# EUROPEAN PATENT APPLICATION

(11) **EP 4 583 171 A1**
(43) Date of publication of application: **09.07.2025**
(21) Application number: 23859469.1
(22) Date of filing: 31.08.2023
(51) Int. Cl.: H01L 33/48, H01L 33/54, H01L 33/50, H01L 33/60, H01L 33/62, H01S 5/022

(54) **PACKAGING STRUCTURE, LED DEVICE, AND PACKAGING METHOD**

(30) Priority: 31.08.2022 CN 202211052295; 13.01.2023 CN 202320148419 U; 26.04.2023 CN 202310461846; 27.04.2023 CN 202310471905; 30.05.2023 CN 202321351736 U; 31.05.2023 CN 202310641247; 31.05.2023 CN 202321364282 U; 31.07.2023 CN 202310957094; 31.07.2023 CN 202310953283
(71) Applicant: Huizhou Jufei Optoelectronics Ltd., Huizhou, Guangdong 516000 (CN)
(72) Inventor: CHENG, Peng, Guangdong 516000 (CN); KE, Youpu, Guangdong 516000 (CN); LIU, Jielin, Guangdong 516000 (CN); SUN, Pingru, Guangdong 516000 (CN); HUANG, Ming, Guangdong 516000 (CN); XING, Meizheng, Guangdong 516000 (CN); LI, Jianren, Guangdong 516000 (CN); ZHANG, Ni, Guangdong 516000 (CN)
(74) Representative: Viering, Jentschura & Partner mbB Patent- und Rechtsanwälte
(86) International application number: PCT/CN2023/116314
(87) International publication number: WO 2024/046441

(57) **Abstract**

The present disclosure is suitable for the technical field of semiconductor packaging, and provides a packaging structure, an LED device and a packaging method, which comprise a substrate, a transparent cover and a dam connected to the substrate, wherein the dam, the transparent cover and the substrate are enclosed to form an assembly area; the dam comprises an outer retaining wall and an inner retaining wall, and a groove is arranged between the outer retaining wall and the inner retaining wall; the LED packaging structure further comprises a sealing member arranged in the groove; the transparent cover covers the inner retaining wall and the assembly area, and the transparent cover is inserted into the groove; the LED packaging structure further comprises a protective member arranged at the edge of the transparent cover, and the protective member is provided with a blocking part for blocking the gap between the transparent cover and the outer retaining wall, and a pressing part connected to the blocking part and capable of abutting against the upper end of the transparent cover. According to the LED packaging structure provided by the present disclosure, with the shielding of the inner retaining wall, the outer retaining wall and the blocking part, the sealing member is capable of avoiding UV irradiation, and has the advantages of both semi-inorganic packaging and fully-inorganic packaging to overcome the limitations of the two, thereby achieving better air tightness and stability.

## Description

### TECHNICAL FIELD

The present disclosure belongs to the technical field of semiconductor packaging, particularly to a packaging structure, an LED device and a packaging method.

### BACKGROUND

Semiconductor packaging technology is very important for the performance of semiconductor devices. However, in the prior art, there are the following problems:

In UV-LED packaging, the air tightness is not good, and the amount of glue used is difficult to calculate, which easily leads to the failure of UV-LED devices, and there are also problems such as high light loss rate and unstable bonding. Secondly, in the use of UV-LED, it is difficult for people to tell whether the UV-LED works or not because ultraviolet rays are invisible to the naked eye.

In the work of LED products, heat dissipation is prone to problems. Usually, heat dissipation devices are added. However, an insulating layer is needed to prevent short circuit if heat dissipation devices are used. The insulating layer easily falls off, resulting in short circuit, and the series-parallel circuits of the substrate are fixed; therefore, the applicability is poor.

A 3D TOF (3 Dimensions Time of flight) device is a new generation of light-emitting device which integrates distance detection with 3D imaging technology. At present, the packaging structure of a light-emitting device mainly includes a substrate, a packaging body, a light-transmitting member and a light-emitting element, wherein the light-transmitting member includes a light-transmitting layer and a homogenizing layer. The homogenizing layer includes a homogenizing structure to refract laser light into a large-angle beam to protect human eyes; therefore, a photoelectric detector is arranged in the accommodating cavity therein. However, the homogenizing layer easily falls off, and the photoelectric detector can detect whether the homogenizing layer has fallen off or not, but it cannot accurately detect whether some areas of the homogenizing layer are damaged, which leads to the result that the photoelectric detector cannot reliably guarantee the safety of human eyes.

### SUMMARY

The present disclosure aims at overcoming at least one of the shortcomings of the prior art by providing a packaging structure, an LED device and a packaging method, which have better air tightness and stability, improve the sealing effect of a semiconductor device while ensuring the reliability of the packaging structure, and can improve the light output rate of the semiconductor device.

The technical solution of the present disclosure is as follows: a packaging structure includes a substrate, a light-emitting element, a transparent cover and a dam connected to the substrate, wherein the light-emitting element is an LED chip or a laser chip; and the substrate has a front surface and a back surface which are opposite to each other, and the light-emitting element is fixed on the front surface of the substrate; and the transparent cover is connected to the dam.

Preferably, the dam, the transparent cover and the substrate define an assembly area; and the dam includes an outer retaining wall and an inner retaining wall, and a groove is formed between the outer retaining wall and the inner retaining wall; and the packaging structure further includes a sealing member arranged in the groove; and the transparent cover covers the inner retaining wall and the assembly area, and the transparent cover is inserted into the groove and connected with the sealing member; the packaging structure further includes a protective member arranged at an edge of the transparent cover, wherein the protective member is provided with a blocking part for blocking a gap between the transparent cover and the outer retaining wall, and a pressing part connected to the blocking part and capable of abutting against an upper end of the transparent cover.

Preferably, the bottom of the transparent cover is provided with a bonding layer, and a front surface of the substrate is provided with a first circuit layer, wherein the first circuit layer includes a first circuit pattern configured to be connected to the bonding layer, and the first circuit layer further includes a pad configured to be bonded with the LED chip, wherein a sealed packaging cavity is formed between the transparent cover and the substrate, the LED chip is arranged in the packaging cavity and bonded to the pad, and the bonding layer is bonded with the first circuit pattern.

Preferably, the dam has an inner side wall, wherein at least a part of the inner side wall of the dam above the LED chip is provided with an assembly groove penetrating through the top of the dam, wherein the assembly groove has a groove bottom surface and a groove side wall; and the packaging structure further includes a positioning block arranged in the assembly groove; and the bottom surface of the transparent cover abuts against the groove bottom surface of the assembly groove, a side of the transparent cover abuts against a plurality of positioning blocks, and the side of the transparent cover, the groove bottom surface and the groove side wall of the assembly groove form a sealant groove; and the packaging structure further includes a sealant that is arranged in the sealant groove and does not cover the transparent cover.

Preferably, the front surface of the substrate is provided with a first circuit layer; and the light-emitting element is arranged on the front surface of the substrate and connected with the first circuit layer; and the dam is arranged on the front surface of the substrate, and includes a first part and a second part which are arranged on the front surface of the substrate at intervals, wherein the first part and the second part are respectively configured as a positive conductor and a negative conductor connected with an electric signal detection module, and the positive conductor and the negative conductor are arranged on the periphery of the light-emitting element and the first circuit layer; and the transparent cover includes a light-transmitting conductive layer, a homogenizing layer and a light-transmitting layer which are stacked, wherein the light-transmitting conductive layer is connected to the positive conductor and the negative conductor.

Preferably, the packaging structure further includes a fluorescent substance, which is arranged on the support structure or/and the transparent cover, and is configured for generating visible light by a fluorescence reaction when irradiated by the light emitted by the LED chip.

Preferably, the substrate is a multilayer substrate, and the multilayer substrate includes:
a first substrate with a front surface and a back surface that are opposite to each other, wherein the front surface of the first substrate is provided with a first circuit layer, and the back surface of the first substrate is provided with a second circuit layer, wherein the first circuit layer is in conductive connection with the second circuit layer, and the first circuit layer includes a first circuit positive electrode and a first circuit negative electrode;
a packaging body that is annular and arranged on the front surface of the first substrate, and surrounds the periphery of the first circuit positive electrode and the first circuit negative electrode; and
a second substrate connected with the second circuit layer on the back surface of the first substrate by a bonding process, wherein a back surface of the second substrate is provided with a heat dissipation layer.

Preferably, the front surface of the substrate is provided with a first circuit layer, which includes a plurality of positive electrode pad and negative electrode pad groups; and the back surface of the substrate is provided with a second circuit layer, which includes a plurality of positive terminal and negative terminal groups corresponding to the positive electrode pad and negative electrode pad groups one by one, wherein the positive terminal and negative terminal of one group are symmetrically arranged on two opposite sides of the back surface of the substrate; and the positive terminals are arranged at linear intervals and equidistantly arranged on a same side of the back surface of the substrate, and the negative terminals are arranged at linear intervals and equidistantly arranged on another side of the back surface of the substrate and are opposite to the positive terminals one by one; and one positive electrode pad is connected with one positive terminal through a positive electrode conductive hole penetrating through the substrate, and one negative electrode pad is electrically connected with one negative terminal through a negative electrode conductive hole penetrating through the substrate; and
a plurality of the LED chips are provided, and each LED chip is electrically connected with one of the positive electrode pad and negative electrode pad groups respectively.

Preferably, the present disclosure further includes a light window assembly, which includes a transparent cover and a metal cap, wherein the metal cap is bonded on the periphery of the transparent cover, and the transparent cover and the metal cap are fixed in the assembly groove; and the bottoms of the transparent cover and the metal cap are both abutted against a groove bottom surface of the assembly groove; and the transparent cover, the metal cap, the front surface of the substrate and the dam define an accommodating cavity for accommodating the LED chips, and the surfaces of the transparent cover and the metal cap and a wall surface of the assembly groove define a sealant groove; and the packaging structure further includes a sealant, and the sealant is arranged in the sealant groove.

Preferably, the dam is provided with an inner side wall plated with a reflecting layer for reflecting the light emitted by the light-emitting element, wherein the inner side wall is inclined from the first end face in a direction away from the light-emitting element and forms an included angle with the first end face of more than zero and less than 90°.

The packaging structure provided by the present disclosure has the advantages of fixed packaging glue amount, good consistency, good air tightness, low light loss rate, firm bonding, capability of distinguishing invisible light and safety in use.

### BRIEF DESCRIPTION OF DRAWINGS

In order to more clearly explain the technical solution in the embodiment of the present disclosure, the drawings necessary for the embodiments will be briefly introduced below. Obviously, the drawings in the following description are only part of the embodiments of the present disclosure, and other drawings can be obtained according to these drawings without creative work for those skilled in the art.

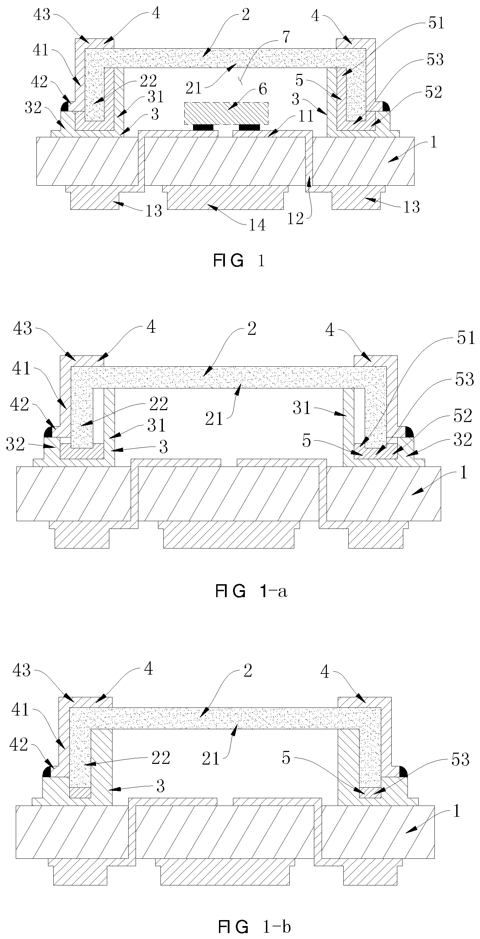

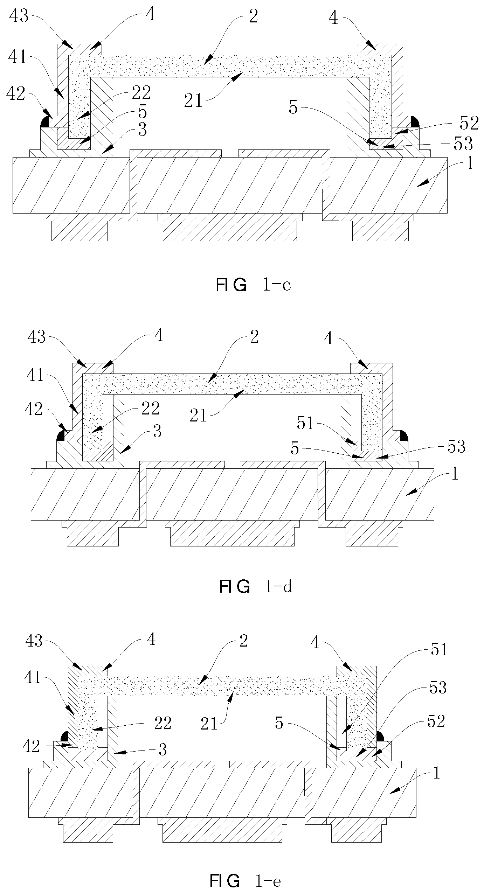

FIG. 1 is a structural schematic diagram of an LED packaging structure provided by an embodiment of the present disclosure;
FIG. 1-a is another structural schematic diagram of an LED packaging structure provided by an embodiment of the present disclosure;
FIG. 1-b is another structural schematic diagram of an LED packaging structure provided by an embodiment of the present disclosure;
FIG. 1-c is another structural schematic diagram of an LED packaging structure provided by an embodiment of the present disclosure;
FIG. 1-d is another structural schematic diagram of an LED packaging structure provided by an embodiment of the present disclosure;
FIG. 1-e is another structural schematic diagram of an LED packaging structure provided by an embodiment of the present disclosure;
FIG. 2 is a schematic diagram of a dam in an LED packaging structure provided by an embodiment of the present disclosure;
FIG. 3 is another structural schematic diagram of an LED packaging structure provided by an embodiment of the present disclosure;
FIG. 4 is a flowchart of a packaging method for an LED packaging structure provided by an embodiment of the present disclosure;
FIG. 5 is a schematic sectional view of an organic packaging structure provided in the prior art;
FIG. 6 is a schematic sectional view of a semi-inorganic packaging structure provided in the prior art;
FIG. 7 is a schematic sectional view of a fully-inorganic packaging structure provided in the prior art;
FIG. 8 is a schematic sectional view of a fully-inorganic packaging structure provided by an embodiment of the present disclosure;
FIG. 9 is a schematic sectional view of a fully-inorganic packaging structure provided by an embodiment of the present disclosure;
FIG. 10 is a sectional view of an LED packaging structure provided by an embodiment of the present disclosure;
FIG. 11 is a top view of an LED packaging structure provided by an embodiment of the present disclosure;
FIG. 12 is a sectional view of an LED packaging structure provided by an embodiment of the present disclosure;
FIG. 13 is a top view of an LED packaging structure provided by an embodiment of the present disclosure;
FIG. 14 is a flowchart of an LED packaging method provided by an embodiment of the present disclosure;
FIG. 15 is a flowchart of the steps of preparing a substrate in the LED packaging method provided by an embodiment of the present disclosure;
FIG. 16 is a flowchart of the steps of arranging the LED chip on the front surface of the substrate in the LED packaging method provided by an embodiment of the present disclosure;
FIG. 17 is a flowchart of the step of placing sealant in the sealant groove in the LED packaging method provided by an embodiment of the present disclosure;
FIG. 18 is a flowchart of an LED packaging method provided by an embodiment of the present disclosure;
FIG. 19 is a sectional view of the packaging structure of the light-emitting element provided by an embodiment of the present disclosure;
FIG. 20 is a top view of the packaging structure of the light-emitting element provided by an embodiment of the present disclosure, which does not include the light-transmitting member and the conductive adhesive;
FIG. 21 is a bottom view of the packaging structure of the light-emitting element provided by an embodiment of the present disclosure;
FIG. 22 is a sectional view of an LED device provided by an embodiment of the present disclosure;
FIG. 23 is a top view of the LED device provided by an embodiment of the present disclosure;
FIG. 24 is a schematic diagram showing that the LED device provided by an embodiment of the present disclosure does not include a light-transmitting member;
FIG. 25 is another schematic diagram showing that the LED device provided by an embodiment of the present disclosure does not include a light-transmitting member;
FIG. 26 is a sectional view of an LED device provided by an embodiment of the present disclosure;
FIG. 27 is a top view of the LED device provided by an embodiment of the present disclosure;
FIG. 28 is a sectional view of an LED device provided by an embodiment of the present disclosure;
FIG. 29 is a top view of the LED device provided by an embodiment of the present disclosure;
FIG. 30 is a flowchart of the first embodiment of the LED packaging method provided by an embodiment of the present disclosure;
FIG. 31 is a flowchart of a step of arranging a fluorescent substance on the support or/and the light-transmitting member in the LED packaging method provided by an embodiment of the present disclosure;
FIG. 32 is a flowchart of the step of arranging fluorescent substances on the support or/and the light-transmitting member in the LED packaging method provided by an embodiment of the present disclosure;
FIG. 33 is an A-A sectional view of the LED device provided in an embodiment of FIG. 34 of the present disclosure;
FIG. 33a is a schematic sectional view of the circuit layer of the LED device provided by an embodiment of the present disclosure;
FIG. 34 is a top view of an LED device provided by an embodiment of the present disclosure;
FIG. 35 is a sectional view of an LED device provided by another embodiment of the present disclosure;
FIG. 36 is a bottom view of the first substrate and the third bonding part in the LED device according to an embodiment of the present disclosure;
FIG. 37 is a sectional view of the second substrate, the first bonding part, the second bonding part and the fourth bonding part in the LED device provided by an embodiment of the present disclosure;
FIG. 38 is a bottom view of a second substrate in an LED device according to an embodiment of the present disclosure;
FIG. 39 is a flowchart of a first embodiment of a method for manufacturing a multilayer substrate provided by an embodiment of the present disclosure;
FIG. 40 is a schematic cross-sectional view of the LED device provided by an embodiment of the present disclosure, and is also the A-A cross-sectional view of FIG. 41;
FIG. 41 is a schematic plan view of an LED device according to an embodiment of the present disclosure;
FIG. 42 is a schematic diagram of the back structure of the LED device provided by an embodiment of the present disclosure;
FIG. 43 is a schematic sectional view taken at B-B in FIG. 42;
FIG. 44 is a schematic sectional view taken at C-C in FIG. 42;
FIG. 45 is a schematic diagram showing the relationship between the projection of the positive electrode pad and the negative electrode pad on the front surface of the substrate of the LED device and the positive terminal and the negative terminal on the back surface of the substrate;
FIG. 45a is a schematic diagram of the shape of a rectangular circuit pattern composed of positive electrode pads and negative electrode pads on the front surface of the substrate of the LED device provided by an embodiment of the present disclosure;
FIG. 46 is a schematic structural diagram of the first circuit layer or the second circuit layer of the LED device provided by an embodiment of the present disclosure;
FIG. 47 is a schematic diagram showing that the circuit connection relationships of four LED chips of the LED device provided by an embodiment of the present disclosure are independent of each other;
FIG. 47a is a schematic diagram of four LED chips of the LED device provided by an embodiment of the present disclosure connected in parallel;
FIG. 47b is a schematic diagram of matching an LED device provided by an embodiment of the present disclosure with a peripheral circuit to realize parallel connection of four LED chips;
FIG. 48 is a schematic diagram of four LED chips of the LED device provided by an embodiment of the present disclosure connected in series;
FIG. 48a is a schematic diagram of matching an LED device provided by an embodiment of the present disclosure with a peripheral circuit to realize the series connection of four LED chips;
FIG. 49 is a schematic diagram of a series-parallel connection of four LED chips of the LED device provided by an embodiment of the present disclosure;
FIG. 49a is a schematic diagram of matching an LED device provided by an embodiment of the present disclosure with a peripheral circuit to realize the series-parallel connection of the four LED chips shown in FIG. 10;
FIG. 50 is a schematic diagram of another series-parallel connection of four LED chips of the LED device provided by an embodiment of the present disclosure;
FIG. 50a is a schematic diagram of matching an LED device provided by an embodiment of the present disclosure with a peripheral circuit to realize the series-parallel connection of the four LED chips shown in FIG. 50;
FIG. 51 is a schematic plan view of the LED device provided by an embodiment of the present disclosure;
FIG. 51a is a schematic view of the shapes of the positive electrode pad and the negative electrode pad of the LED device provided in FIG. 51;
FIG. 52 is a schematic view of the back structure of the LED device provided in FIG. 51;

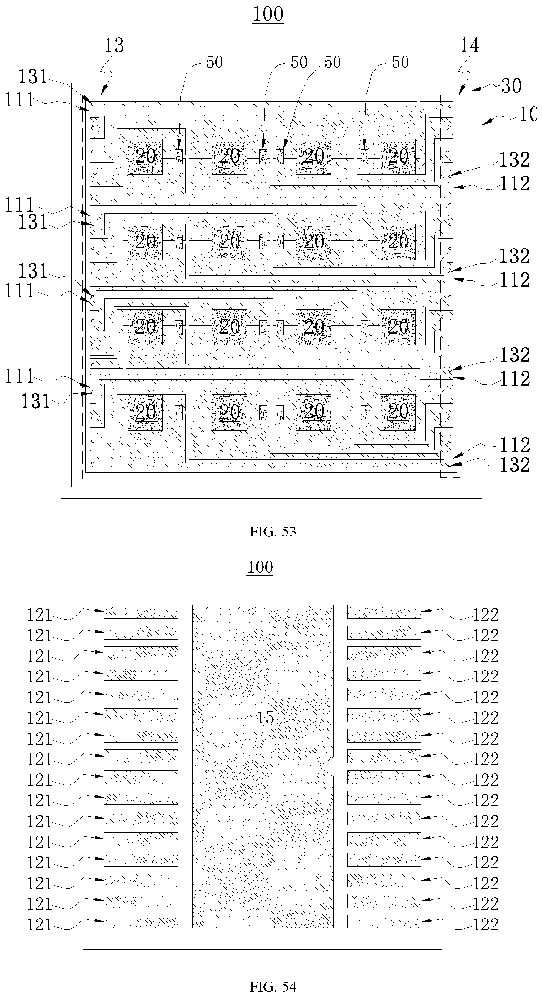

FIG. 53 is a schematic plan view of an LED device provided by another embodiment of the present disclosure;
FIG. 54 is a schematic view of the back structure of the LED device provided in FIG. 53;
FIG. 55 is a sectional view of the LED device provided by an embodiment of the present disclosure;
FIG. 56 is a top view of the LED device provided by an embodiment of the present disclosure, in which the glass solder is connected to the metal cap;
FIG. 57 is a top view of the LED device provided by an embodiment of the present disclosure, in which the glass solder is connected to the metal cap;
FIG. 58 is a top view of the LED device provided by an embodiment of the present disclosure, in which the glass solder is connected to the metal cap;
FIG. 59 is a cross-sectional view of the LED device provided by an embodiment of the present disclosure, in which the light-transmitting member is connected to the metal cap through glass solder;
FIG. 60 is a cross-sectional view of the LED device provided by an embodiment of the present disclosure, in which the light-transmitting member is connected to the metal cap through glass solder;
FIG. 61 is a cross-sectional view of an LED device provided in Embodiment 9 of the present disclosure, and it is also a cross-sectional view of an LED device in the manufacturing method of an LED device in Embodiment 10;
FIG. 62 is a top view of a substrate and a dam part (circular in shape) in an LED device provided in Embodiment 9 of the present disclosure, and also a top view of the substrate and the dam part (circular in shape) in Embodiment 10;
FIG. 63 is a top view of the substrate and the dam part (square in shape) in an LED device provided in Embodiment 9 of the present disclosure, and also a top view of the substrate and the dam part (square in shape) in Embodiment 10;
FIG. 64 is a schematic cross-sectional view of an LED device in which the dam part and the substrate are integrally formed in Embodiment 9 of the present disclosure, and it is also a schematic cross-sectional view of the dam part and the substrate being integrally formed in Embodiment 10;
FIG. 65 is a schematic cross-sectional view of an LED device in which the dam part and the light-transmitting element are integrally formed in Embodiment 9 of the present disclosure, and it is also a schematic cross-sectional view of Embodiment 10 in which the dam part and the light-transmitting element are integrally formed;
FIG. 66 is a schematic diagram showing a manufacturing method of an LED device provided in Embodiment 9 of the present disclosure and the light emitted by light-emitting elements in the LED device reflected by different included angles α, and it is also a schematic diagram showing a manufacturing method of an LED device in Embodiment 10 and the light emitted by light-emitting elements in the LED device reflected by different included angles α;
FIG. 67 is a schematic diagram showing the method for manufacturing an LED device provided in Embodiment 9 of the present disclosure and the light reflected by dam components with different included angles α, and it is also a schematic diagram showing the method for manufacturing an LED device provided in Embodiment 10 and the light reflected by light-emitting elements with different included angles α;
FIG. 68 is a manufacturing method of an LED device provided by an embodiment of the present disclosure and a sectional view of an LED device among the LED devices;
FIG. 68a is a sectional view of a packaging mode ② of the reflecting ring in the embodiment;
FIG. 68b is a sectional view of the packaging mode ② of the reflecting ring in the embodiment;
FIG. 68c is a sectional view of a packaging mode ③ of the reflecting ring in the embodiment;
FIG. 68d is a top view of the reflecting ring (circular in shape) in the embodiment;
FIG. 68e is a top view of the reflecting ring (square in shape) in the embodiment;
FIG. 69 is a manufacturing method of an LED device provided by an embodiment of the present disclosure and a cross-sectional view of an LED device in an embodiment of the LED device;
FIG. 69a is a top view of the LED device with a circular shape of the cap member in the embodiment;
FIG. 69b is a top view of the LED device with a square shape of the cap member in the embodiment;
FIG. 69c is a sectional view of an LED device using a hemispherical lens in the embodiment.
FIG. 70 is a manufacturing method of an LED device provided by an embodiment of the present disclosure and a schematic diagram of light emitted by light-emitting elements in the LED device reflected by different included angles α.

### DESCRIPTION OF EMBODIMENTS

In order to make the object, technical solution and advantages of the present disclosure more clear, the present disclosure will be further described in detail with the attached drawings and examples. It should be appreciated that the specific embodiments described here are only for explaining the present disclosure, and are not intended to limit the present disclosure.

It should be noted that the terms "setting" and "connecting" should be broadly understood, for example, they may refer to direct setting and connection, or indirect setting and connection through the mediate components and the mediate structures.

In addition, in the embodiments of the present disclosure, if there are 'longitudinal', 'transverse', 'length', 'width', 'thickness', "upper", "lower", "front", 'back ', 'left', 'right', 'vertical', 'horizontal', 'top', "bottom", "inside", "outside" and other terms indicative of an orientations or positional relationships, which are based on the orientations or positional relationships or conventional states of placement or use shown in the drawings, they are used solely for the purpose of facilitating the description of the present disclosure and simplifying the description, and are not intended to indicate or imply that the structure, feature, device or element referred to has to have a particular orientation or positional relationship, or must be constructed and operated with a particular orientation, and therefore are not to be construed as a limitation of the present invention. In the description of the present invention, unless otherwise indicated, 'a plurality of' means two or more.

Each specific technical feature and each embodiment described in the specific embodiment can be combined in any suitable way without contradiction. For example, different embodiments can be formed by the combination of different specific technical features/embodiments. In order to avoid unnecessary repetition, various possible combinations of each specific technical feature/embodiment in the present disclosure are not explained separately.

### Embodiment 1

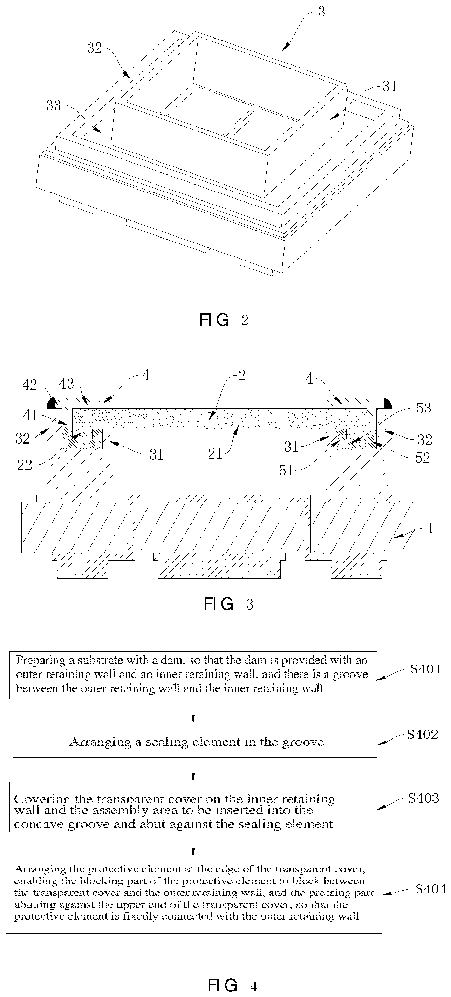

As shown in FIG. 1 and FIG. 3, an LED packaging structure provided by an embodiment of the present disclosure includes a substrate 1, a transparent cover 2 and a dam 3 (as shown in FIG. 2). The dam 3 is connected to the substrate 1. Specifically, the dam 3 is a copper dam, and the substrate 1 is a ceramic substrate. The substrate 1 is connected with an LED chip 6 (UV-LED chip in this embodiment), and the dam 3, the transparent cover 2 and the substrate 1 define an assembly area 7. The transparent cover 2 is a glass lens, which can be made of Quartz glass or sapphire glass. The dam 3 includes an outer retaining wall 32 and an inner retaining wall 31, both of which are walls, which can be square or circular, and a groove 33 is arranged between the outer retaining wall 32 and the inner retaining wall 31. The LED packaging structure further includes a sealing member 5 arranged in the groove 33, the transparent cover 2 covers the inner retaining wall 31 and the assembly area 7, and the transparent cover 2 is inserted into the groove 33 and connected with the sealing member 5. The LED packaging structure further includes a protective member 4, which is arranged at the edge of the transparent cover 2. The protective member 4 has a blocking part 41 and a pressing part 43, wherein the blocking part 41 blocks the gap between the transparent cover 2 and the outer retaining wall 32, the pressing part 43 can abut against the upper end of the transparent cover 2, and the pressing part 43 is connected to the blocking part 41. In the specific application, the protective member 4 is a metal protective member, all made of metal. In this embodiment, the protective member 4 can be bonded with the substrate 1 (laser bonding is used in this embodiment). The bonding connection mode is very firm, which can effectively prevent the glass lens from falling off. Moreover, because the metal protective member arranged on the glass lens is not directly bonded with the substrate 1, but is bonded with the outer retaining wall 32 of the copper dam, the blocking part 41 blocks the gap between the transparent cover 2 and the outer retaining wall 32, so that the sealing member 5 can be prevented from being irradiated by UV, and the glass lens and the ceramic substrate are closely combined to enhance the air tightness. If there are no cracks in bonding, the air tightness is better. If there are cracks, the air tightness can be guaranteed by the sealing member 5 arranged in the groove 33, so that air tightness is double guaranteed, which has the advantages of inorganic packaging technology and overcomes its limitations. Moreover, the glass lens can meet the use requirements even if cracks appear during bonding or subsequent use. The setting of the sealing member 5 has a good effect on filling the contact gap between the ceramic substrate and the glass lens, so that the LED packaging structure has a good air tightness. Moreover, under the shielding of the inner retaining wall 31 and the outer retaining wall 32, and under the blocking of the blocking part 41 and the pressing part 43, the sealing member 5 can avoid UV irradiation, thus effectively preventing the glass lens from falling off, and overcoming the limitations of the semi-inorganic packaging process while taking its advantages. According to the LED packaging structure provided by the embodiment of the present disclosure, the transparent cover 2 (a glass lens in this embodiment) and the substrate 1 (a ceramic substrate in this embodiment) are closely combined, and the air tightness is good, so that the packaging process of combining semi-inorganic packaging with fully-inorganic packaging is realized, the problem that the glue in the semi-inorganic packaging fails for a long time under the irradiation of UV light and the transparent cover 2 falls off is solved, which has the advantages of both semi-inorganic packaging and fully-inorganic packaging while overcoming the limitations of both, thereby ensuring the air tightness of UV-LED products, facilitating the improvement of the service life of UV-LED devices with a better stability and a high practical application value.

In specific application, the substrate 1 is a ceramic substrate, which includes a ceramic layer, internal wiring 11, internal conductive holes 12 and bottom wiring 13. The copper dam is arranged on one side of the ceramic layer, and the internal wiring are located inside the inner retaining wall 31. Among them, the internal wiring and the bottom wiring are connected by arranging the internal conductive holes 12 in the ceramic layer, and the bottom wiring, the internal wiring and the copper dam are combined with the ceramic layer by DPC (Direct Plating copper technology) on the ceramic layer. The UV-LED chip is located inside the inner retaining wall 31 and connected to the internal wiring 11. In other embodiments, the ceramic substrate further includes a heat dissipation part 14 at the bottom.

In some examples of this embodiment, a plurality of protective members 4 are provided, which partially cover the upper surface of the transparent cover 2. The distance between the end faces of the two pressing parts 43 located on the upper surface of the transparent cover 2 is not greater than the distance between the two opposite side walls facing toward the groove 33 of the inner retaining wall 31, that is, the hollowed-out width of the upper surface of the metal inlaid block located on the upper surface of the glass lens is not greater than the distance between the two side walls facing toward the groove 33 of the inner retaining wall 31 (i.e., two inner side walls of the inner retaining wall 33). In other examples of this embodiment, there may be four protective members 4, which are respectively arranged at four right angles of the transparent cover 2 or at the middle positions of the four sides of the transparent cover 2, and partially cover the upper surface of the transparent cover 2. In other embodiments, only two protective members 4 can be provided, which are symmetrically arranged on the sides of the transparent cover 2. In other embodiments, the number of protective members 4 can also be other values, such as three or six. The sealing member 5 is hidden between the substrate 1 and the transparent cover 2 (glass lens) of the protective member 4 (inlaid metal block), and the side part of the light emitted from the UV chip is blocked by the inner retaining wall 31 of the dam 3 (copper dam). Because the hollowed-out width of the upper surface of the metal inlaid block located on the upper surface of the glass lens is not greater than the distance between the two side walls of the inner retaining wall 31 facing toward the groove 33, the external UV light is blocked by the inlaid metal block of the glass lens and the outer retaining wall of the copper dam when it is reflected back, which can ensure that the sealing element is not affected by UV illumination, therefore the reliability is better and the air tightness of the UV-LED products is ensured.

In this embodiment, as shown in FIGS. 1 and 3, the sealing member 5 has an inner sealing part 51, an outer sealing part 52 and a transverse sealing part 53. The transparent cover 2 includes a face cover part 21 and a longitudinal part 22, and the longitudinal part 22 is connected to the outer peripheral side of the face cover part 21. The inner sealing part 51 is attached to the inner retaining wall 31 and the inner side of the transparent cover 2 respectively. The outer sealing part 52 is attached to the outer retaining wall 32 and the outer side of the longitudinal part 22 of the transparent cover 2. The transverse sealing part 53 is attached to a bottom of the groove of the groove 33 and the bottom of the transparent cover 2. One end of the transverse sealing part 53 is connected to the outer sealing part 52, and another end of the transverse sealing part 53 is connected to the inner sealing part 51. The sealing member may be provided with an assembly groove. The inner sealing part 51, the outer sealing part 52 and the transverse sealing part 53 define an assembly groove for installing the transparent cover 2, that is, the two sides of the assembly groove are the inner sealing part 51 and the outer sealing part 52 respectively, and the bottom of the assembly groove is the transverse sealing part 53. The longitudinal part 22 and the inner wall of the assembly groove can be closely connected, so that gaps are eliminated and the air tightness is good. In some examples of this embodiment, as shown in FIG. 1-a, the inner sealing part 51 is not flush with the upper end of the inner retaining wall 31, and the outer sealing part 52 is not flush with the upper end of the outer retaining wall 32, that is, a certain gap is left at the upper ends of the inner sealing part 51 and the outer sealing part 52, and the gap is set and reserved according to the characteristics of the material to give the sealing member 5 sufficient thermal expansion space. In other examples, as shown in FIG. 1-b, the width of the sealing member 5 is the same as that of the longitudinal part 22 of the transparent cover 2, that is, the sealing member 5 only has a part of the transverse sealing part 53, so that the packaging structure is compact and the stability is strong. In other examples, as shown in FIGS. 1-c and 1-d, at least one side of the longitudinal part 22 of the transparent cover 3 is attached to the retaining wall of the dam 3, and when the transparent cover 2 is installed, the point where the longitudinal part 22 is attached to the retaining wall can be used as a positioning point, which can facilitate assembly. Accordingly, as shown in FIG. 1-c, the sealing member only has an outer sealing part 52 and a transverse sealing part 53. Accordingly, as shown in FIG. 1-d, the sealing member has only an inner sealing part 51 and a transverse sealing part 53.

In specific applications, the sealing member 5 can be prefabricated by a mold and installed in the groove 33, and then the transparent cover 2 will abut against the sealing member 5 when it is inserted into the groove 33. In other examples, the sealing member 5 can also be directly coated with a certain amount of liquid glue at the groove bottom of the groove 33, and then the transparent cover 2 is inserted into the groove 33 and baked and solidified. When the sealing member 5 is formed by this method, the inner retaining wall 31 and the outer retaining wall 32 can effectively prevent the glue from overflowing into the cup of the substrate 1 or outside the substrate 1, and prevent the overflowing glue from affecting the parameters and air tightness of the product. Specifically, the sealing member 5 can be made of silica gel, epoxy resin or other packaging glue. In the traditional packaging process, the glue on the surface of the copper dam and the glue overflowing into a cup of the substrate will yellow and fail after being irradiated by UV light for a long time, which will affect the product parameters and air tightness, therefore only non-flowing materials can be used to fill the gap. However, the LED packaging structure provided by the embodiment of the present disclosure can realize gap filling by using liquid or non-liquid substances (i.e., preformed by using a mold), which overcomes the limitation of the selection of filling materials in the traditional packaging process, has better applicability and can reduce the packaging cost.

In some examples of this embodiment, the protective member 4 further includes a fixing part 42 connected to the blocking part 41. The fixing part 42 is fixedly connected to the outer retaining wall 32. In this embodiment, the fixing part 42 is integrally connected to the blocking part 41, the inner side of the blocking part 41 is attached to the longitudinal part 22, and the inner wall of the pressing part 43 is attached to the upper end of the face cover part 21, that is, both inner sides of the protective member 4 can be attached to the transparent cover 2, so that the protective effect is better. In other examples, the fixing part 42 partially overlaps with the outer retaining wall 32, and the fixing part 42 partially overlaps with the upper end face of the outer retaining wall 32, so that the protective member 4 has a support in the vertical direction, which facilitates bonding and makes the bonding firmer. In other examples, as shown in FIG. 1-e, the fixing part 42 partially overlaps with the side of the outer retaining wall 32 facing toward the groove 33. The end face of the fixing part 42 abuts against the sealing member 5, that is, the sealing member 5 supports the protective member 4, so that bonding is convenient. At the same time, the sealing member 5 can be slightly deformed due to compression, and the sealing member 5 can be fully compressed when the protective member 4 is installed, so as to reduce the assembly gap as much as possible and enhance the airtightness of the packaging structure. In other embodiments, there may be a gap between the end face of the fixing part 42 and the sealing member 5, so that the pressing portion 43 ca fully abut against the upper surface of the transparent cover 2 to prevent the transparent cover 2 from loosening.

In the embodiment of the present disclosure, the height of the inner retaining wall 31 is not equal to the height of the outer retaining wall 32, and the groove 33 between the inner retaining wall 31 and the outer retaining wall 32 is described in detail in the following two embodiments 1a and 1b.

### Embodiment 1a

The height of the inner retaining wall 31 is a first height, and the height of the outer retaining wall 32 is a second height. The first height is greater than the second height, that is, the inner retaining wall 31 is higher than the outer retaining wall 32. As shown in FIGS. 1 and 2, the groove 33 between the inner retaining wall 31 and the outer retaining wall 32, the inner retaining wall 31, and the cross section of the combination of the groove bottom of the groove 33 and the outer retaining wall are in a "∟" shape; or the sealing member 5 is installed, and the cross section of the sealing member 5 can be in a " L " shape. The fixing part 42 is connected to one end of the blocking part 41, and the pressing part 43 is connected to another end of the blocking part 41. The cross section of the protective member 4 is Z-shaped, and the fixing parts 42 can be attached to the upper ends of the outer retaining wall 32 and the outer sealing part 52. In this embodiment, the upper ends of the outer retaining wall 32 and the outer sealing part 52 are flush and sealed by the metal protective member at the top of the outer retaining wall 32 and the outer sealing part 52, so that the air tightness is good.

### Embodiment 1b

The height of the inner retaining wall 31 is a first height, and the height of the outer retaining wall 32 is a second height. As an alternative to the above embodiment, the first height is less than the second height in this embodiment, as shown in FIG. 3, that is, the inner retaining wall 31 is lower than the outer retaining wall 32, and the groove 33 is formed between the inner retaining wall 31 and the outer retaining wall 32. The outer side of the blocking part 41 is attached to the outer retaining wall 32, and the blocking part 41 is connected with the outer sealing part 52. The sum of the height of the blocking part 41 and the height of the outer sealing part 52 is equal to the height of the outer retaining wall 32, and the bottom wall of the fixing part 42 can be attached to the upper end of the outer retaining wall 32. The fixing part 42 is connected with the blocking part 41 and the pressing part 43 respectively, and the cross section of the protective member 4 is in a "T" shape, which has a good air tightness.

Embodiment 1 of the present disclosure also provides a packaging method for an LED packaging structure, which is used for packaging the LED packaging structure, as shown in FIG. 4, and includes the following steps:
S401: a substrate 1 with a dam 3 is prepared, such that the dam 3 is provided with an outer retaining wall 32 and an inner retaining wall 31, and a groove 33 is provided between the outer retaining wall 32 and the inner retaining wall 31.

Specifically, the substrate 1 is a ceramic substrate, and the dam 3 is a copper dam. The internal circuit 11, external circuit, internal through hole 12 and dam 3 are formed on the ceramic substrate by DPC (Direct Plating copper) process. The specific process route includes process of laser drilling, vacuum plating, die pressing, circuit exposure, circuit development, hole filling plating, grinding, sandblasting, die pressing, preparation and exposure of copper dam, copper dam development, copper dam plating, grinding, film removal, copper removal and titanium removal, electrical measurement and surface treatment. In other embodiments, a heat dissipating part 14 for dissipating heat may be formed at the bottom of the substrate.

It can be appreciated that the dam 3 manufactured by the above steps is formed with an outer retaining wall 32 and an inner retaining wall 31, so that a groove 33 is formed between the outer retaining wall 32 and the inner retaining wall 31. Based on the above introduction, it can be known that the height of the inner retaining wall 31 is defined as a first height, and the height of the outer retaining wall 32 is defined as a second height. In some examples of this embodiment, the first height is greater than the second height. In other examples, the height of the outer retaining wall 32 is defined as a second height.

Specifically, the packaging method further includes a chip die-bonding step, that is, soldering flux on the internal circuit of the substrate 1 (ceramic substrate) and soldering the LED chip 6 in the area with the flux; wherein the pad of the LED chip 6 is gold-tin alloy; the role of flux is to act as a eutectic medium, so that the LED chip 6 is closely combined with the substrate 1 during eutectic. The ceramic substrate circuit needs to be plated with nickel and gold, and the thickness requirements are nickel > 3µm and gold > 0.05µm; the packaging method further includes a chip eutectic step, that is, the substrate 1 (ceramic substrate) on which the LED chip 6 is fixed passes through a eutectic furnace, so that the LED chip 6 is firmly combined with the ceramic substrate, wherein at least one temperature zone of the eutectic furnace is between 300°C and 340°C, and the eutectic process needs nitrogen protection.

S402: the sealing member 5 is arranged in the groove 33;
Specifically, the sealing member 5 can be preformed by a mold, and then the sealing member 5 can be installed in the groove 33. In some examples, a certain amount of flowable thermosetting glue can also be directly applied to the bottom of the groove 33 to be baked and cured to form the sealing member 5. The glue with fluidity, that is, liquid glue, is used to make the sealing member 5, which needs to be baked and cured later. Under the action of the inner retaining wall 31 and the outer retaining wall 32, the glue can be effectively prevented from overflowing into the cup of the substrate 1 or outside the substrate 1, and the overflowing glue can be prevented from affecting the parameters and air tightness of the product. The gap between the transparent cover 2 and the dam 3 can be filled with liquid or non-liquid substances (that is, preformed by using a mold), which overcomes the limitation of the selection of filling materials in the traditional packaging process, has better applicability and can reduce the packaging cost.

S403: the transparent cover 2 is used to cover the inner retaining wall 31 and the assembly area 7, and is inserted into the groove 33 and is abutted against the sealing member 5.

Based on the foregoing introduction, it can be seen that in one embodiment, the transparent cover 2 includes a face cover part 21 and a longitudinal part 22 connected to the outer peripheral side of the face cover part 21. With the above steps, the sealing member 5 fills the gap between the transparent cover 2 and the dam 3, and the airtightness of the packaging structure is improved.

S404: the protective member 4 is arranged at the edge of the transparent cover 2, the blocking part 41 of the protective member 4 blocks the gap between the transparent cover 2 and the outer retaining wall 32, and the pressing part 43 is abutted against the upper end of the transparent cover 2 to fixedly connect the protective member 4 to the outer retaining wall 32.

Specifically, in one embodiment, the pressing part 43 of the protective member 4 can cover the upper surface of the transparent cover 2, so that the distance between the end faces of two pressing parts 43 located on the upper surface of the transparent cover 2 is not greater than the distance between the two opposite side walls of the inner retaining wall 31 facing toward the groove 33. With the above steps, the sealing member 5 is prevented from being irradiated by UV under the shielding of the inner retaining wall 31 and the outer retaining wall 32, and under the blocking of the blocking part 41 and the pressing part 43, so that the reliability of the packaging structure is better and the air tightness of UV-LED products is ensured.

Based on the foregoing introduction, it can be seen that in some examples, the protective member 4 can also be provided with a fixing part 42, which is fixedly connected to the outer retaining wall 32, and the transparent cover 2 (glass lens) is closely combined with the ceramic substrate. In this embodiment, the protective member 4 is a metal protector, and the fixing part 42 is integrally connected to the blocking part 41, all made of metal. In this embodiment, the fixing part 42 can be laser bonded with the substrate 1. The bonding connection is very firm, which can effectively prevent the glass lens from falling off. In some examples, the fixing part 42 of the protective member 4 can be arranged on the upper end face of the outer retaining wall 32, so that the fixing part 42 partially overlaps with the upper end face of the outer retaining wall 32, so that the protective member 4 has a support in the vertical direction, which can facilitate bonding and make the bonding firm.

In other examples, the fixing part 42 of the protective member 4 can be arranged in the groove 33, so that the fixing part 42 partially overlaps with the side of the outer retaining wall 32 facing toward the groove 33. When the protective member 4 is installed, the sealing piece 5 can be compressed, and the sealing piece 5 can be slightly deformed due to compression, so that the assembly gap can be reduced as much as possible, and the airtightness of the packaging structure can be enhanced. In other embodiments, there may be a gap between the protective member 4 and the sealing member 5, so that when the protective member 4 is installed, the pressing portion 43 ca fully abut against the upper surface of the transparent cover 2 to prevent the transparent cover 2 from loosening.

According to the LED packaging structure provided by the first embodiment of the present disclosure, a dam 3 with an outer retaining wall 32 and an inner retaining wall 31 is arranged on the substrate 1, a groove 33 is arranged between the outer retaining wall 32 and the inner retaining wall 31, and a sealing member 5 is arranged in the groove 33. The transparent cover 2 covers the inner retaining wall 31 and the assembly area 7, and the transparent cover 2 is inserted into the groove 33 and connected with the sealing member 5. The protective member 4 is arranged at the edge of the transparent cover 2, and the blocking part 41 of the protective member 4 is provided between the transparent cover 2 and the outer retaining wall 32, and the pressing part 43 abuts against the upper end of the transparent cover 2. Under the shielding of the inner retaining wall 31 and the outer retaining wall 32 and the blocking part 41 and the pressing part 43, the sealing member can avoid UV irradiation, so that the transparent cover 2 and the substrate 1 are closely combined and have good air tightness. The packaging process of combining semi-inorganic packaging and fully-inorganic packaging is realized, which solves the problem that the transparent cover 2 falls off due to glue failure under long-term irradiation of UV light in semi-inorganic packaging, and has the advantages of semi-inorganic packaging and fully-inorganic packaging, which ensures the air tightness of UV-LED products, is beneficial to improving the service life of UV-LED devices and has better stability.

### Embodiment 2

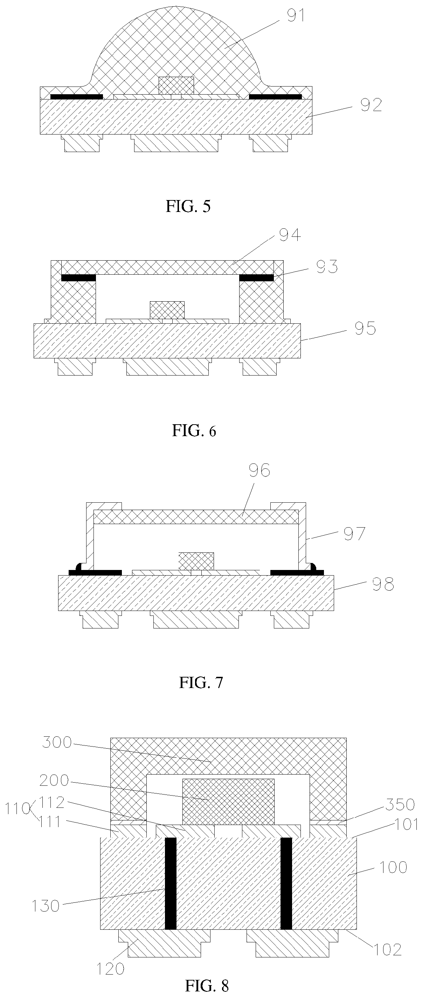

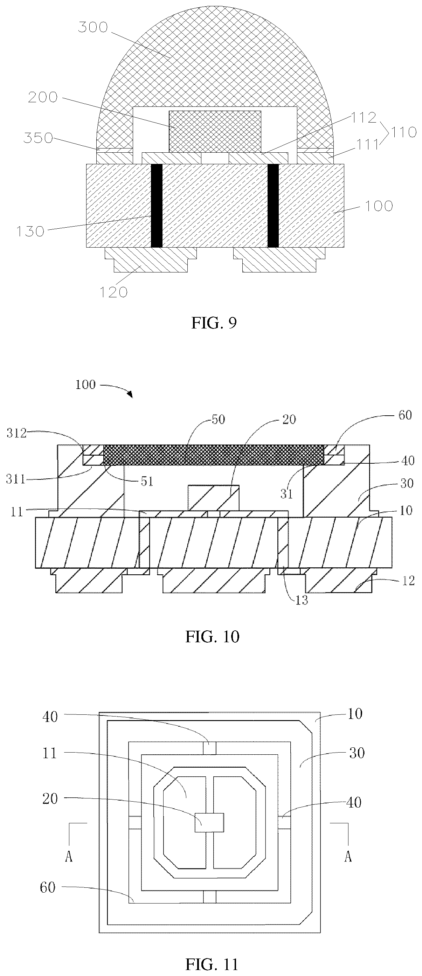

As shown in FIG. 8 and FIG. 9, a fully-inorganic LED packaging structure provided by an embodiment of the present disclosure includes a packaging substrate 100 (substrate), an LED chip 200 and a light-transmitting hood 300 (transparent cover). The packaging substrate 100 (substrate) has a front surface 101 and a back surface 102 opposite to each other, and the front surface 101 of the packaging substrate 100 (substrate) is provided with a first circuit layer 110. The first circuit layer 110 includes a first circuit pattern 111 and a pad 112, and the pad 112 is used for being bonded with the LED chip 200. The bottom of the light-transmitting hood 300 (transparent cover) is provided with a bonding layer 350, which is bonded with the first circuit pattern 111. A sealed packaging cavity is formed between the light-transmitting hood 300 (transparent cover) and the packaging substrate 100 (substrate). The LED chip 200 is arranged in the packaging cavity and bonded to the pad 112. The top surface and peripheral side of the light-transmitting hood 300 can both transmit light. Through the bonding layer 350 arranged at the bottom of the light-transmitting hood 300 (transparent cover), it can be closely combined with the first circuit pattern 111 of the packaging substrate 100 (substrate), and the combination is reliable. In this embodiment, the packaging structure may not use organic materials such as silica gel, silicone resin or epoxy resin, and a fully-inorganic packaging process may be used, without the risk that the colloidal yellow lens falls off in organic packaging and semi-inorganic packaging. At the same time, the side and the front surface of the light-transmitting hood 300 (transparent cover) can transmit light. When there are four sides of the light-transmitting hood 300 (transparent cover), the above packaging structure can emit light from five sides (when the light-transmitting hood 300 is rectangular), which not only greatly improves the light emitting efficiency of the UV-LED packaging body, but also has high reliability. Because organic materials can not be used, the shortcomings that organic materials will yellow and lose their viscosity under the irradiation of UV light with wavelength below 350nm are avoided. The fully-inorganic LED packaging structure provided by this embodiment has obvious advantages in UV-LED products with peak wavelength below 350nm. The light-transmitting hood 300 (transparent cover) can be made of an inorganic glass material, and the bottom of the light-transmitting hood 300 is provided with a bonding layer 350, so that the light-transmitting hood 300 (transparent cover) and the packaging substrate 100 are bonded together, closely combined, without the risk of yellowing and falling off, with high product reliability and good user experience.

Specifically, the light-transmitting hood 300 (transparent cover) can be a glass lens, and the bonding layer 350 can be a metal layer (i.e., metal solder) formed at the bottom of the light-transmitting hood 300 (transparent cover) by electroplating. The first circuit pattern 111 is a metal layer formed on the front surface 101 of the packaging substrate 100 by electroplating, which has a low production cost. In other embodiments, the bonding layer 350 can also be glass solder formed at the bottom of the light-transmitting hood 300 (transparent cover), and the first circuit pattern 111 can be a metal layer formed on the front surface 101 of the packaging substrate 100 (substrate) by electroplating. The light-transmitting hood 300 is bonded on the first circuit pattern by the glass solder and metal sealing technology, which has good light transmittance and reduces the light blocking effect of the bonding layer 350 on the LED chip. The bonding layer 350 can cover the bottom surface of the light-transmitting hood 300 (transparent cover). Of course, the bonding layer 350 can also extend to the inner and outer sides of the light-transmitting hood 300 (transparent cover) by a set distance. In this embodiment, the first circuit pattern is used to be bonded with the light-transmitting hood 300 (transparent cover) and is not used for conducting electricity.

Specifically, the light-transmitting hood 300 (transparent cover) covers the top surface and the side of the LED chip, and both the top surface and the side can emit light, so that the light-emitting effect is good. In this embodiment, the light-transmitting hood 300 (transparent cover) includes a top light-emitting surface and four side light-emitting surfaces, and the shape of the light-transmitting hood 300 (transparent cover) can be rectangular (square) to achieve the effect of light-emitting on five sides.

Specifically, the packaging substrate 100 (substrate) can be a ceramic substrate with a good reliability and a low application cost.

Specifically, the metal layer (bonding layer 350) may be a eutectic metal layer. Alternatively, the metal layer is a non-eutectic metal layer. When the metal layer is a eutectic metal layer, the metal layer can be connected with the first circuit pattern 111 by eutectic bonding and other processes, and the bonding reliability is high. When the metal layer is a non-eutectic metal layer, the light-transmitting hood 300 (glass lens) can be closely combined with the packaging substrate 100 (ceramic substrate) by reflow soldering or high-temperature baking, and a fully-inorganic packaging process can be realized. Even if the above-mentioned fully-inorganic LED packaging structure is applied to UV-LED products, the glass lens has no risk of falling off.

Specifically, the metal layer can be a gold-tin alloy layer or a silver layer, which has high reliability and good bonding effect with the first circuit pattern 111.

Specifically, the light-transmitting hood 300 (transparent cover) can be a Quartz glass hood or a sapphire glass hood, which has good light transmittance. The light-transmitting hood 300 may be rectangular or circular in shape, and its front surface may be flat or convex spherical.

Specifically, the first circuit pattern 111 is a metal layer formed on the front surface of the packaging substrate 100 (substrate) by electroplating, which is easy to manufacture.

Specifically, the shape of the first circuit pattern 111 is a closed shape, and the bonding layer 350 is connected with the first circuit pattern 111 to form a bonding area with a closed shape. The first circuit pattern 111 may be rectangular, the shape of the light-transmitting hood 300 (transparent cover) may be rectangular, the bottom surface of the light-transmitting hood 300 (transparent cover) may be rectangular, and the bonding layer 350 at the bottom edge of the light-transmitting hood 300 (transparent cover) may just be seated on the first circuit pattern 111. The bottom edge of the light-transmitting hood 300 (transparent cover) can completely be seated above the first circuit pattern 111, that is, the projection area of the bottom edge of the light-transmitting hood 300 (transparent cover) on the front surface 101 of the packaging substrate 100 (substrate) can completely fall within the range of the first circuit pattern 111.

Alternatively, as one of the alternatives, the shape of the first circuit pattern 111 may also be semi-closed, and the bonding layer 350 is connected with the first circuit pattern 111 to form a semi-closed bonding area.

Specifically, the bonding layer 350 can also be glass solder formed at the bottom of the light-transmitting hood 300, and can be connected by glass solder and metal sealing technology, with good product reliability.

Specifically, the longitudinal section of the light-transmitting hood 300 (transparent cover) is n -shaped, and the light-transmitting hood 300 (transparent cover) can form a light-emitting structure on five sides. Of course, the shape of the light-transmitting hood 300 can also be polygonal, rounded (as shown in FIG. 9), etc.

Specifically, the height of the bottom of the light-transmitting hood 300 (transparent cover) can be equal to or lower than the bottom of the LED chip 200, so as to prevent the bonding layer 350 at the bottom of the light-transmitting hood 300 (transparent cover) from blocking the light of the LED chip 200, which is beneficial to further improving the light efficiency.

Specifically, the back surface 102 or/and the inside of the packaging substrate 100 (substrate) is provided with a second circuit layer 120. The pad 112 is connected to the second circuit layer 120 through a conductive hole (filled with conductive material 130) provided in the packaging substrate 100 (substrate) to meet the wiring requirements of the circuit. In this embodiment, the second circuit layer 120 is arranged on the back surface 102 of the packaging substrate 100 (substrate). The packaging substrate 100 is a ceramic substrate made of DPC (Direct Plating Copper) technology, and there are circuits on both the surface and the back surface. The pad 112 of the surface circuit (the first circuit layer 110) and the back circuit (the second circuit layer 120) can be connected through internal conductive holes.

In this embodiment, the LED chip 200 may be a flip chip, and the electrodes of the flip chip may be gold-tin alloy.

The present disclosure also provides a fully-inorganic LED packaging method for packaging the fully-inorganic LED packaging structure, which includes the following steps:
an LED chip 200, a packaging substrate 100 (substrate) with a first circuit pattern 111 and a pad 112 on the front surface, and a light-transmitting hood 300 with a bonding layer 350 on the bottom are prepared;
step of bonding the LED chip: the LED chip 200 is arranged on the front surface 101 of the packaging substrate 100 and bonded to the pad 112;
step of fixing the transparent cover: the light-transmitting hood 300 covers the LED chip 200, and the bonding layer 350 at the bottom of the light-transmitting hood 300 is seated on the first circuit pattern 111, so that the bonding layer 350 is connected with the first circuit pattern 111 through a bonding or baking process.

Specifically, the pad 112 is made of gold-tin alloy, and the first circuit pattern 111 can be plated with a nickel-gold layer, wherein the thickness of the nickel layer is > 3µm, and the thickness of the gold layer is > 0.05µm.

In this embodiment, the bonding step of the LED chip 200 includes a chip die-bonding step and a eutectic step.

Specifically, the chip die-bonding step includes: setting a flux which can be used as a eutectic medium on the front surface 101 of the packaging substrate 100 (substrate), and then fixing the LED chip 200 on the front surface 101 of the packaging substrate 100 (substrate) where the flux exists.

Specifically, the eutectic step includes: placing the LED chip 200 along with the packaging substrate 100 (substrate) in a eutectic furnace for eutectic bonding, wherein the temperature of at least one zone of the eutectic furnace is between 300°C and 340°C, and the eutectic furnace is protected by nitrogen during the eutectic process.

Specifically, the fixing step of the transparent cover includes: setting solder on the first circuit layer 110, and covering the light-transmitting hood 300 on the first circuit pattern 111 of the first circuit layer 110.

In specific applications, the bonding layer 350 can be a gold-tin alloy, and flux is used as solder and fixed to the first circuit pattern 111 by a eutectic bonding process.

Alternatively, the bonding layer 350 may be gold-tin alloy, and silver paste or solder paste is used as solder and fixed to the first circuit pattern 111 through a high-temperature baking process or a reflow soldering process.

Alternatively, the bonding layer 350 may be a non-eutectic metal, and is fixed to the first circuit pattern 111 by a high-temperature baking process or a reflow soldering process using silver paste or solder paste as solder.

Specifically, the peak wavelength of the LED chip 200 is less than 350nm.

In specific applications, the fully-inorganic LED packaging method can be referred to as follows:
LED chip bonding step (also called chip die bonding step): the circuit (including at least the first circuit layer 110) of the packaging substrate 100 (substrate, which is a ceramic substrate in this embodiment) can be plated with a nickel-gold coating, and the thickness of the nickel coating can be greater than 3µm and the thickness of the gold coating can be greater than 0.05µm. The flux is applied on the first circuit layer 110 of the front surface 101 of the packaging substrate 100 (substrate), the LED chip 200 is positioned at the position where the flux exists, and the electrode corresponds to the pad 112 (the pad 112 may be gold-tin alloy), so as to fix the LED chip 200 on the packaging substrate 100; when eutectic bonding is adopted, the flux may act as a eutectic medium, and the LED chip 200 and the pad 112 can be closely combined.

Eutectic bonding step: eutectic bonding is performed on the packaging substrate 100 (substrate) fixed with the LED chip 200 with a eutectic furnace, so that the LED chip 200 and the packaging substrate 100 (substrate) are firmly combined; at least one temperature zone of the eutectic furnace is between 300°C and 340°C, and protective gas (such as inert gas such as nitrogen) is introduced during eutectic bonding, so the bonding quality is more reliable;
Step of covering the glass lens: solder is placed on the first circuit layer 110 on the surface of the packaging substrate 100 at the contact position with the glass lens (light-transmitting hood 300), and the glass lens is allowed to cover the surface of the packaging substrate 100 (substrate);
bonding step: the ceramic substrate covered with the glass lens is tightly combined with the ceramic substrate through the eutectic furnace, reflow soldering or high temperature baking; (if the electroplating metal at the bottom of the glass lens is gold-tin alloy, eutectic process can be used for bonding, and the solder is flux; high temperature baking or reflow soldering can also be used for bonding, wherein the solder is silver paste or solder paste; if the electroplating metal at the bottom of the glass lens is silver or other non-eutectic metal, it can only be bonded by high temperature baking or reflow soldering, wherein the solder is silver paste or solder paste).

According to the fully-inorganic LED packaging structure provided by the embodiment of the present disclosure, organic materials such as silica gel, silicone resin or epoxy resin can not be used, and a fully-inorganic packaging process can be used, so that there is no risk that the colloid yellows and the lens falls off in organic packaging and semi-inorganic packaging. Meanwhile, both the side and the front surface of the light-transmitting hood 300 can transmit light. When there are four sides of the light-transmitting hood 300, the packaging structure can realize light emission from five faces (when the light-transmitting hood 300 is rectangular), whereby not only the light emitting efficiency of UV-LED package is greatly improved, but also the reliability is high. Because organic materials can not be used, the shortcomings of yellowing and loss of viscosity of organic materials under UV light with wavelength below 350nm are avoided. The fully-inorganic LED packaging structure provided by this embodiment has obvious advantages in UV-LED products with a peak wavelength below 350nm. The light-transmitting hood 300 (transparent cover) can use inorganic glass materials as the glass lens, which has no risk of yellowing and falling off, and the product reliability is high and user experience is good.

Embodiment 3 includes Embodiment 3a and Embodiment 3b.

### Embodiment 3a

As shown in FIG. 10 and FIG. 11, an LED packaging structure 100 provided by an embodiment of the present disclosure includes a substrate 10, an LED chip 20, a support 30 (a dam), a positioning block 40, a light-transmitting member 50 (a transparent cover) and a sealant 60. Specifically, the substrate 10 has opposite front and back surfaces, and the LED chip 20 is fixed on the front surface of the substrate 10. The support 30 (dam) is annular and has an inner side wall, a top and a bottom. The bottom of the support 30 (dam) is seated on the front surface of the substrate 10, and the support 30 (dam) surrounds the LED chip 20. The inner side of the support 30 (dam) is the side of the support 30 (dam) close to the LED chip 20, and at least a part of the inner side wall of the support 30 (dam) above the LED chip is provided with an assembly groove 31 that runs through the top of the support 30 (dam), and the positioning block 40 is arranged in the assembly groove 31. The light-transmitting member 50 (transparent cover) is arranged in the assembly groove 31, and the bottom surface of the light-transmitting member 50 (transparent cover) abuts against the groove bottom surface 311 of the assembly groove 31 and faces toward the LED chip 20. The side surface 51 of the light-transmitting member 50 abuts against multiple positioning blocks 40, thus realizing the positioning of the light-transmitting member 50 (transparent cover), so that the side surface 51 of the light-transmitting member 50, the groove bottom surface 311 and the groove side wall 312 of the assembly groove 31 form a sealant groove (not shown), and the sealant 60 can be arranged in the sealant groove from the upper opening of the sealant groove without covering the light-transmitting member 50, that is, the sealant 60 is arranged between the side surface 51 of the light-transmitting member 50 and the groove bottom surface 311 and the groove side wall 312 of the assembly groove 31. Therefore, when measuring the thickness of sealant 60, the height of sealant groove may be first measured, then the distance between sealant 60 and the groove top of the sealant groove is measured, and finally the amount of the sealant contained in the sealant groove is obtained through simple calculation. The thickness of the sealant 60 can be directly measured by measuring the height of the sealant 60 soaked in light-transmitting member 50 (transparent cover) or inserting sealant 60 to be cured and directly measuring the depth of the sealant 60, by which the measurement is very convenient and the amount of sealant contained in sealant groove can be accurately calculated, therefore the consistency of products is improved while ensuring the sealing effect of the sealant. The problem in the prior art that the sealant is provided first, and then the light-transmitting part is provided on the support, which leads to the sealant being arranged in the closed space in the LED structure, thus making it difficult to measure the thickness of the sealant is avoided. With this arrangement, the light-transmitting member 50 (transparent cover) and the groove bottom surface 311 of the assembly groove 31 do not need to be provided with bottom sealant, and the light-transmitting member 50 (transparent cover) will not be subjected to the upward buoyancy of the bottom sealant to the light-transmitting member 50 (transparent cover). The upward pressure on the light-transmitting member 50 caused by the resilience of the bottom sealant itself is also avoided, and the problem in the prior art that a sealed space is formed immediately when the bottom sealant contacts the light-transmitting member 50 (transparent cover) is avoided, further avoiding the problem in the prior art that the light-transmitting member 50 (transparent cover) floats due to the pressure increase in the sealed space caused by air compression in the sealed space. Therefore, the problem in the prior art that when the sealant 60 is arranged on the bottom surface of the light-transmitting member 50 (transparent cover) and the groove bottom surface 311 of the assembly groove 31, the light-transmitting member 50 (transparent cover) floats and the sealant 60 may generate bubbles and air holes can be avoided, and the sealing effect of the LED packaging structure 100 is further enhanced.

For the LED chip 20, in some embodiments, the front surface of the substrate 10 is provided with a first circuit 11, and the LED chip 20 is connected with the first circuit 11.

In some embodiments, the LED chip 20 can be any one of flip chip, wire-bonding chip or vertical chip, and the connection between the LED chip 20 and the substrate 10 can be realized by arranging a flux material on the first circuit 11 on the front surface of the substrate 10, and then arranging the LED chip on the flux material.

For the substrate 10, in some embodiments, the back surface of the substrate 10 is provided with a second circuit 12, and the substrate 10 is provided with a conductive hole 13 penetrating through the front surface and the back surface. The first circuit 11 and the second circuit 12 are connected through the conductive hole 13, thereby realizing the connection between the LED chip 20, the first circuit 11 and the second circuit 12.

In practical application, the first circuit 11 and the second circuit 12 can be arranged on the substrate 10 by a DPC (Direct Plating copper) process.

Preferably, the substrate 10 and the support 30 (dam) are integrally formed, which is very convenient to manufacture.

Preferably, the bottom of the light-transmitting member 50 (transparent cover) is seated on the groove bottom surface 311 of the assembly groove 31, and the top of the light-transmitting member 50 is higher than the height of the positioning block 40, so that the positioning block 40 can be prevented from blocking the sealant 60 at a certain position between the light-transmitting member 50 and the groove side wall 312 of the assembly groove 31, thereby ensuring that the light-transmitting member 50 can be connected with the support 30 (dam) by the sealant 60, thereby ensuring the bonding and sealing effect of the sealant 60.

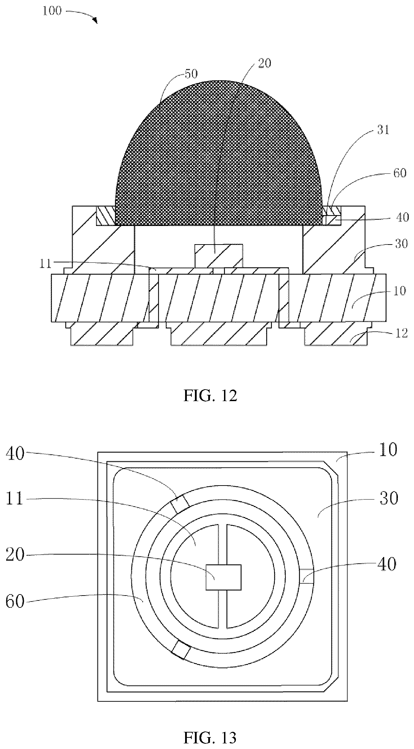

In some embodiments, the light-transmitting member 50 (transparent cover) is made of quartz or sapphire, but the specific material of the light-transmitting member 50 is not limited in the present disclosure, as long as it can achieve light transmission. For example, the light-transmitting member 50 can be made of plastic such as PMMA. In this embodiment, the light-transmitting member 50 may be square (please refer to FIGS. 10 and 11) or hemispherical (please refer to FIGS. 12 and 13), but the shape of the light-transmitting member 50 is not limited to this, as long as it does not affect light transmission, such as cuboid, light bulb, etc.

Preferably, a plurality of the positioning blocks 40 are arranged at equal intervals along the circumferential direction of the sealant groove, so that the positioning of the light-transmitting member 50 (transparent cover) is more accurate, and the sealant groove is better formed, so as to increase the sealing effect of the LED packaging structure 100.

In some embodiments, please refer to FIG. 10 and FIG. 11. The support 30 (dam) is a hollow rectangle, and the light-transmitting member 50 can be laid flat on the assembly groove 31 in a square shape. The number of the positioning blocks can be four, and the first sides of the four positioning blocks 40 are all abutted against the support 30 (dam), and the four positioning blocks 40 are arranged at equal distances along the groove side wall 312 of the assembly groove 31. That is, the four positioning blocks 40 can be respectively arranged at the midpoints of four sides of the assembly groove 31. In some other embodiments (please refer to FIG. 12 and FIG. 13), the support 30 (dam) is hollow and circular, and the light-transmitting member 50 can be installed in the assembly groove 31 in a hemispherical shape. The number of the positioning blocks can be three, the first sides of the three positioning blocks 40 all abut against the support 30 (dam), and the three positioning blocks 40 can be equidistantly arranged around the central axis of the bracket 30, and the angle formed by the connecting line between every two positioning blocks 40 and the central axis of the bracket 30 (dam) is 120 degrees.

Preferably, the bottom of the positioning block 40 is seated on the groove bottom surface 311 of the assembly groove 31, and the positioning block 40 has a first side (not shown) and a second side (not shown) which are opposite to each other. The first side of the positioning block 40 abuts against the groove side wall 312 of the assembly groove 31, and the peripheral side of the light-transmitting member 50 abuts against the second side of the positioning block 40. The height of the positioning block 40 is lower than that of the positioning block 40, so that the sealant 60 can cover the top of the positioning block 40, thereby preventing the positioning block 40 from blocking the sealant 60 at a certain position between the light-transmitting member 50 and the groove side wall 312 of the assembly groove 31, and ensuring that the light-transmitting member 50 and the support 30 can be connected by the sealant 60, thereby ensuring the bonding and sealing effect of the sealant 60.

In some embodiments, the support 30 (dam) is provided with a plurality of positioning grooves (not shown) facing toward the assembly groove 31, and the positioning grooves are used for accommodating the positioning blocks 40, which is convenient for positioning and setting the positioning blocks 40. It can be appreciated that the connection mode of the positioning block 40 and the support 30 in the present disclosure is not limited to this, as long as the positioning blocks 40 can be arranged on the support 30 (dam), for example, the positioning blocks 40 and the support 30 are integrally molded.

Specifically, the height of the sealant 60 is greater than that of the positioning block 40, and the sealant 60 covers the positioning block 40, so that the positioning block 40 can be prevented from blocking the sealant 60 at a certain position between the light-transmitting member 50 and the groove side wall 312 of the assembly groove 31, thereby ensuring that the light-transmitting member 50 and the support 30 can be connected by the sealant 60, thus guaranteeing the bonding and sealing effect of the sealant 60.

It should be noted that on the premise that the positioning blocks 40 can limit the position of the light-transmitting member 50, the fewer the positioning blocks 40, the better. This is because if the number of the positioning blocks 40 is less, the volume occupied by a plurality of the positioning blocks 40 in the assembly groove 31 is smaller, so that the larger the volume of the sealant groove, the more sealant 60 can be applied, and the bonding area between the light-transmitting member 50 and the support 30 (dam) is larger, thereby improving the sealing effect of the LED packaging structure 100. In the specific application (please refer to FIGS. 10 and 11), when the light-transmitting member 50 is laid flat in the assembly groove 31 in a square shape, the number of the positioning blocks 40 may be four, and the four positioning blocks 40 can be respectively arranged at the midpoints of the four sides of the light-transmitting member 50. Please refer to FIG. 12 and FIG. 13, when the light-transmitting member 50 is arranged in the assembly groove 31 in a hemispherical shape, the number of the positioning blocks 40 may be three, and the three positioning blocks 40 can be arranged at equal intervals along the circumference of the light-transmitting member 50.

It should be noted that the smaller the positioning block 40, the better, on the premise that the positioning block 40 can limit the position of the light-transmitting member 50. This is because the smaller the volume of the positioning blocks 40, the smaller the volume occupied by a plurality of the positioning blocks 40 in the assembly groove 31, so that the larger the volume of the sealant groove is, the more sealant 60 can be applied, and the bonding area between the light-transmitting member 50 and the support 30 (dam) is larger, thereby improving the sealing effect of the LED packaging structure 100.

It can be appreciated that although the number and size of the positioning blocks 40 are limited in this embodiment, the number and size of the positioning blocks 40 are not limited in this disclosure, as long as the light-transmitting member 50 (transparent cover) and the support 30 (dam dam) can still be bonded by the sealant 60. For example, when the number of the positioning blocks 40 is large enough to form a step around the assembly groove 31, the side surface 51 of the light-transmitting member 50, the top surface of the positioning blocks 40, the groove bottom surface 311 of the assembly groove 31 and the groove side wall 312 of the assembly groove 31 form a new sealant groove. At this time, the plurality of positioning blocks 40 can still limit the thickness of the sealant 60 between the light-transmitting member 50 (transparent cover) and each part of the sealant groove, and the lateral sealing method can still avoid the upward pressure of the sealant 60 on the light-transmitting member 50 (transparent cover), thus avoiding the problem that the sealant 60 may generate bubbles and air holes when the light-transmitting member 50 floats.

### Embodiment 3b

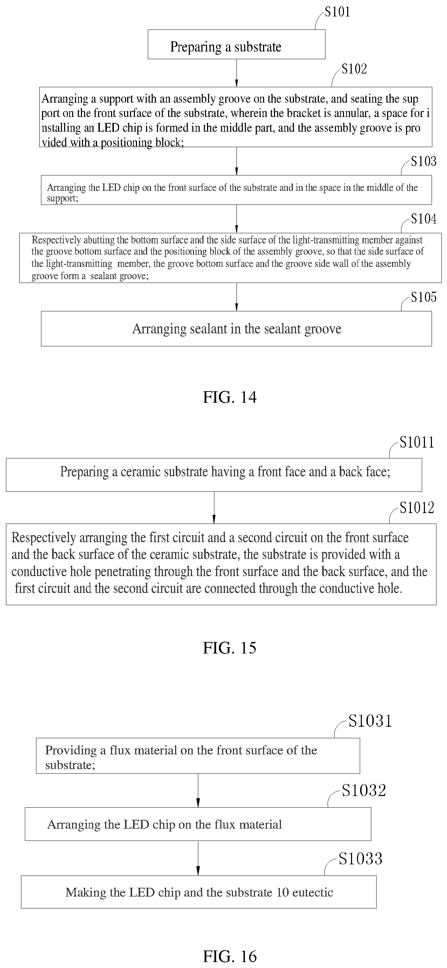

As shown in FIG. 14, an LED packaging method provided by an embodiment of the present disclosure is used for packaging the LED packaging structure 100. Please refer to FIGS. 10 and 11, the LED packaging method includes the following steps:
S101: a substrate 10 is prepared;
S102: a support 30 (a dam) with an assembly groove 31 is arranged on the substrate 10, and the support 30 is seated on the front of the substrate 10; the support 30 is annular, and a space for installing the LED chip 20 is formed in the middle; the assembly groove 31 is provided with a positioning block 40;
S103: the LED chip 20 is arranged on the front surface of the substrate 10 and located in the space in the middle of the support 30 (dam);
S104: the bottom surface and side of the light-transmitting member 50 (transparent cover) are respectively abutted against the groove bottom surface 311 of the assembly groove 31 and the positioning block 40, so that the side surface 51 of the light-transmitting member 50, the groove bottom surface 311 and the groove side wall 312 of the assembly groove 31 form a sealant groove;
S105: the sealant 60 is arranged in the sealant groove.

Specifically, in an embodiment, when the support 30 (dam) is installed, the support 30 (dam) can be prepared into a ring shape, and then at least a part of the inner side wall of the support 30 (dam) is provided with an assembly groove 31 penetrating the top of the support 30 (dam), and then the top of the substrate 10 is connected with the bottom of the support 30 (dam). In another embodiment, the top of the substrate 10 and the bottom of the support 30 (dam) can be integrally molded (by DirectPlatingcopper plating technology), which makes the manufacturing very convenient. A space for installing the LED chip 20 is formed in the middle of the support 30 (dam); the assembly groove 31 is used for mounting the light-transmitting member 50 (transparent cover). In order to avoid interference between the light-transmitting member 50 (transparent cover) and the LED chip 20, the assembly groove 31 needs to be arranged above the LED chip 20.

Specifically, the way of arranging the positioning block 40 in the assembly groove 31 of the support 30 (dam) may be first arranging a positioning groove in the assembly groove 31 and then arranging the positioning block 40 in the positioning groove, or directly arranging the positioning block 40 and the support 30 (dam) in an integrated manner when manufacturing the support 30 (dam), as long the positioning effect of the positioning block 40 on the light-transmitting member 50 (transparent cover) can be achieved. It can be appreciated that the way of setting the positioning groove and the positioning block 40 can be implemented by manual or mechanical structure, for example, setting an intelligent manipulator, and accurately setting the positioning groove or the positioning block 40 by the intelligent manipulator at a fixed point, which can accurately position the light-transmitting member 50, thus further improving the sealing effect.

Preferably, a plurality of positioning blocks 40 can be arranged in the assembly groove 31 of the support 30 (dam), so that the positioning of the light-transmitting member 50 (transparent cover) in the assembly groove 31 can be realized, and the thickness of the sealant 60 between the side surface 51 of the light-transmitting member 50 (transparent cover) and the groove side wall 312 of the assembly groove 31 can be controlled when the sealant 60 is arranged. When a plurality of the positioning blocks 40 are arranged at equal intervals along the circumferential direction of the sealant groove, the positioning of the light-transmitting member 50 is more accurate, and the sealant groove is better formed, so as to increase the sealing effect of the LED packaging structure 100.

Preferably, when preparing the support 30 (dam) and the positioning block 40 and setting the sealant 60, the height of the positioning block 40 can be lower than the top of the assembly groove 31 and the light-transmitting member 50 (transparent cover), and the sealant 60 covers the positioning block 40 and is higher than the height of the positioning block 40. Therefore, the positioning block 40 can be prevented from blocking the sealant 60 at a certain position between the light-transmitting member 50 (transparent cover) and the groove side wall 312 of the assembly groove 31, thereby ensuring that the light-transmitting member 50 (transparent cover) and the support 30 (dam) can be connected by the sealant 60, thus guaranteeing the bonding and sealing effect of the sealant 60.

Specifically, when the sealant 60 is placed between the side surface 51 of the light-transmitting member 50 (transparent cover) and the sealant groove formed by the groove bottom surface 311 and the groove side wall 312 of the assembly groove 31, the light-transmitting member 50 (transparent cover) will no longer be subjected to the upward buoyancy of the sealant 60 on the light-transmitting member 50 (transparent cover) and the upward pressure on the light-transmitting member 50 (transparent cover) due to the resilience of the sealant 60 itself. Therefore, the problem in the prior art that the light-transmitting member 50 floats and the sealant 60 may generate bubbles and air holes when the sealant 60 is arranged on the bottom surface of the light-transmitting member 50 and the groove bottom surface 311 of the assembly groove 31 can be avoided, and the sealing effect of the LED packaging structure 100 is further enhanced.

It can be appreciated that the sealant 60 refers to glue with adhesive function, and the specific material of the sealant 60 is not limited. Specifically, in order to ensure the sealing effect, the sealant 60 can be evenly coated in the sealant groove, so as to prevent the internal gas from overflowing from the weak part of the sealant 60 due to the pressure increase when the light-transmitting member 50 sinks toward the bottom of the assembly groove 31. It can be appreciated that setting the sealant 60 in the sealant groove can be achieved by manual or mechanical means, for example, setting an intelligent manipulator and uniformly setting a certain amount of sealant 60 by the intelligent manipulator can further improve the sealing effect.

As one of the alternative implementations of this embodiment, as shown in FIG. 15, the steps of preparing the substrate include:
S1011: a ceramic substrate is prepared, wherein the ceramic substrate has a front surface and a back surface;
S1012: a first circuit and a second circuit are respectively arranged on the front surface and the back surface of the ceramic substrate, the substrate is provided with a conductive hole penetrating through the front surface and the back surface, and the first circuit and the second circuit are connected through the conductive hole.

As an alternative embodiment of this embodiment, the step of arranging the LED chip 20 on the front surface of the substrate 10, as shown in FIG. 16, further includes:
S1031: g a flux material is arranged on the front surface of the substrate 10;
S1032: the LED chip 20 is arranged on the flux material;
S1033: the LED chip 20 and the substrate 10 are make to be eutectic.

Specifically, the electrical connection between the LED chip 20 and the first circuit 11 can be realized by arranging the first circuit 11 on the front surface of the substrate 10, which includes the first pad, then arranging the flux material on the first pad, and then arranging the LED chip 20 on the flux material. Usually, when the first circuit 11 is manufactured, the first pad will be formed simultaneously. The fixing between the substrates 10 of the LED chip 20 can be made firmer by setting the flux material and making the LED chip 20 and the substrate 10 eutectic.

With regard to the step of arranging the first circuit 11 with flux material on the front side of the substrate 10, the way of arranging the first circuit 11 on the substrate 10 can be realied by a DPC (Direct Plating copper) process, the second circuit 12 can be arranged on the back side of the substrate 10 by the same process, and the substrate 10 is provided with a conductive hole 13 penetrating through the substrate 10. The first circuit 11 and the second circuit 12 are connected through the conductive hole 13, so that the LED chip 20, the first circuit 11 and the second circuit 12 can be connected. The flux material can be provided on the first circuit 11 by spot coating. It can be appreciated that the spot coating of the flux material on the first circuit 11 can be realized by manual or mechanical means, for example, an intelligent manipulator is arranged, and a certain amount of flux material is uniformly arranged by the intelligent manipulator, so that the bonding effect can be further improved.

In specific applications, the first circuit 11 and the second circuit 12 can be plated with nickel and gold to prevent the migration and oxidation of metals on the lines and improve the conductivity and oxidation resistance. The thickness of nickel plating is required to be > 3µm, and the thickness of gold plating is required to be > 0.05µm, so as to ensure the conductivity and oxidation resistance.

In some embodiments, the LED chip 20 can be any one of a flip chip, a wire bonding chip or a vertical chip. The connection between the LED chip 20 and the substrate 10 can be realized by arranging a flux material on the first circuit on the front side of the substrate 10, and then arranging the LED chip on the flux material.

The way to make the LED chip 20 and the substrate 10 eutectic can be to pass the connected LED chip 20 and the substrate 10 through a eutectic furnace, so that the combination of the LED chip 20 and the substrate 10 can be more firm. In practical application, when the pad is made of Au-Sn alloy, at least one temperature zone of the eutectic furnace is between 300°C and 340°C, and the eutectic process needs nitrogen protection.

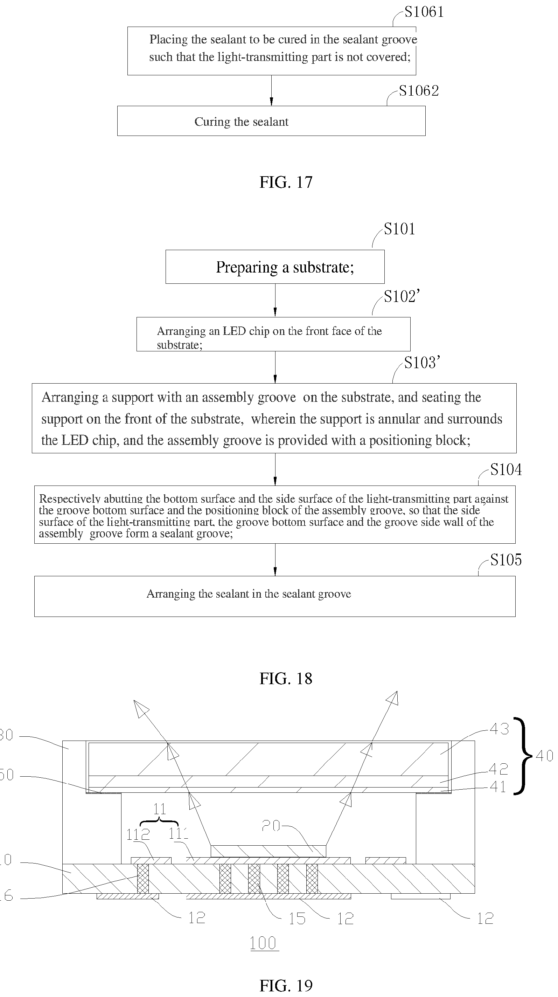

As an alternative embodiment of this embodiment, the step of setting the sealant 60 in the sealant tank, as shown in FIG. 17, further includes:
S1051: the sealant 60 to be cured is arranged in the sealant groove, and the positioning block 40 is covered with the sealant 60 to be cured;
S1052: the sealant 60 is cured.

The purpose of covering the positioning block 40 with the sealant 60 to be cured is to prevent the positioning block 40 from blocking the sealant 60 at a certain position between the light-transmitting member 50 (transparent cover) and the support 30 (dam), so as to ensure the connection between the light-transmitting member 50 (transparent cover) and the support 30 (dam) through the sealant 60, thus ensuring the bonding and sealing effect.

Specifically, the way to cure the sealant 60 may include waiting for the sealant 60 to cure naturally, curing by baking or curing by UV light. It can be appreciated that the curing mode of the sealant 60 is not limited to this, as long as the sealant 60 can be cured. For example, if the sealant 60 needs to be cured by baking, it will be cured by baking; if it can be cured by direct irradiation with UV light, it will be cured by UV light; if it is other types of sealant, it will be cured by corresponding curing methods.

This alternative embodiment ensures the bonding and sealing effect of the sealant by covering the positioning block 40 with the sealant 60 to be cured and curing the sealant 60.

### Embodiment 3c

In other embodiments, as shown in FIG. 18, after the substrate 10 is prepared, the LED chip 20 may be arranged on the front surface of the substrate 10 first, and then the support 30 (dam) and the positioning block 40 may be arranged around the LED chip 20. That is, the embodiment of the present disclosure also provides another LED packaging method, which includes the following steps:
S101: a substrate 10 is prepared;
S102': the LED chip 20 is arranged on the front surface of the substrate 10;
S103': a support 30 (a dam) with an assembly groove 31 is arranged on the substrate 10, and the support 30 is seated on the front surface of the substrate 10; the support 30 is annular and surrounds the LED chip 20, and the assembly groove 31 is provided with a positioning block 40;
S104: the bottom surface and side surface of the light-transmitting member 50 (transparent cover) are respectively abutted against the groove bottom surface 311 and the positioning block 40 of the assembly groove 31, so that the side surface 51 of the light-transmitting member 50 (transparent cover), the groove bottom surface 311 and the groove side wall 312 of the assembly groove 31 form a sealant groove; and
S105: the sealant 60 is arranged in the sealant groove.

Specifically, unlike Embodiment 3b, in this embodiment, the LED chip 20 is arranged first, and then the support 30 is arranged, therefore it is not convenient to prepare the support 30 (dam dam) by a DPC process. Therefore, in this embodiment, when the support 30 (dam dam) is arranged, the support 30 can be prepared into a ring shape first, and then at least a part of the inner side wall of the support 30 is provided with an assembly groove 31 that runs through the top of the support 30, then the top of the substrate 10 is connected with the bottom of the support 30 (dam); other steps of this embodiment are the same as those of the second embodiment, reference may be made to the description of the second embodiment, which will not be repeated here.

The present disclosure provides an LED packaging structure and an LED packaging method. The LED packaging structure 100 includes a substrate 10, an LED chip 20, a support 30 (a dam), a positioning block 40, a light-transmitting member 50 (a transparent cover) and a sealant 60. Wherein, the substrate 10 has opposite front and back surfaces. The LED chip 20 is fixed on the front surface of the substrate 10. The support 30 (dam) is annular and has a top and a bottom. The bottom of the support 30 (dam) is seated on the front surface of the substrate 10, and the support 30 (dam) surrounds the LED chip 20. Moreover, the support 30 (dam) is provided with an assembly groove 31 which runs through the top of the support 30 (dam) and the inner side wall of the support 3 (dam). The assembly groove 31 has a groove bottom surface 311 and a groove side wall 312. The positioning block 40 is disposed in the assembly groove 31. The bottom surface of the light-transmitting member 50 (transparent cover) abuts against the groove bottom surface 311 of the assembly groove 31 and faces toward the LED chip 20, and the side surface 51 of the light-transmitting member 50 (transparent cover) abuts against a plurality of positioning blocks 40, thereby positioning the light-transmitting member 50 (transparent cover). The side surface 51 of the light-transmitting member 50, the groove bottom surface 311 and the groove side wall 312 of the assembly groove 31 form a sealant groove, and the sealant 60 is arranged in the sealant groove. According to the present disclosure, firstly, the light-transmitting member 50 (transparent cover) is limited by the positioning of the plurality of positioning blocks 40, so that the side surface 51 of the light-transmitting member 50 (transparent cover) forms a sealant groove with the groove bottom surface 311 and the groove side wall 312 of the assembly groove 31, which limits the maximum amount of sealant that can be accommodated in the sealant groove, and the sealant 60 can be arranged in the sealant groove from the upper opening of the sealant groove. That is, by arranging the sealant 60 between the light-transmitting member 50 (transparent cover) and the side surface 51 of the sealant groove, the sealant 60 can be exposed to the outside, thus avoiding the problem in the prior art that the sealant first is arranged, followed by arranging the light-transmitting member on the support, and the sealant is arranged in the closed space of the LED structure, resulting in the difficulty in measuring the thickness of the sealant. For example, when measuring the thickness of the sealant 60, the height of the sealant groove can be measured first. Then, the distance between the sealant 60 and the groove top of the sealant groove is measured, and the amount of sealant can be obtained by simple calculation, which is very convenient to measure. In addition, it is not necessary to set bottom sealant on the light-transmitting member 50 (transparent cover) and the groove bottom surface 311 of the assembly groove 31, and the light-transmitting member 50 will not be affected by the upward buoyancy of the bottom sealant on the light-transmitting member 50 (transparent cover). It also avoids the upward pressure on the light-transmitting member 50 (transparent cover) caused by the resilience of the bottom sealant itself, avoids the problem that a sealed space is formed when the bottom sealant just contacts the light-transmitting member 50 in the prior art, and further avoids the problem that the transparent member 50 floats due to the increase of the pressure in the sealed space caused by air compression in the sealed space in the prior art, thus avoiding the problem that the sealant 60 may generate bubbles and air holes when the light-transmitting member 50 (transparent cover) floats, and further enhancing the LED packaging structure.

### Embodiment 4

3D TOF (3 Dimensions Time of flight) device is a new generation of light-emitting device which combines distance detection with 3D imaging technology. At present, the packaging structure of light-emitting device mainly includes a substrate, a packaging body, a light-transmitting member and a light-emitting element. The packaging body is annular and is arranged on the front surface of the substrate. The light-transmitting member is connected to the top of the packaging body and forms an accommodating cavity with the packaging body and the substrate, and the light-emitting element is accommodated in the accommodating cavity. The light-transmitting member includes a light-transmitting layer and a homogenizing layer, and the homogenizing layer includes a homogenizing structure so as to refract the laser into a light beam with a large angle to protect human eyes. In order to ensure the safety of human eyes, it is often necessary to set a photoelectric detector in the accommodating cavity. The photoelectric detector converts the light signal into an electrical signal by receiving the light reflected to the photoelectric detector after the laser passes through the homogenizing layer, so as to facilitate the operator to judge whether the homogenizing layer on the light-transmitting member falls off.

However, there are also some problems in the actual use of photoelectric detectors. First, the space in the accommodating cavity is limited, and the setting of photoelectric detectors reduces the packaging space in the packaging structure, which leads to certain limitations in the size selection of light-emitting elements; second, the manufacture and algorithm of photodetector are complicated, which requires high time and cost; thirdly, the pulse current is mainly used to drive the VCSEL (Vertical Cavity Surface Emitting Laser) light-emitting element, while the photodetector often needs to be driven by bias voltage, and the two driving modes are different, therefore the packaging structure needs to be equipped with two driving integrated circuits to use, which will further increase the manufacturing time and cost; fourth, due to the limited size of the photodetector, the photodetector can only receive the light reflected by some areas of the homogenizing layer, but not the whole area of the homogenizing layer, and if the homogenizing layer is damaged, the light may be directly emitted or reflected to other positions and cannot be received by the photodetector, therefore, the photodetector can only detect whether the homogenizing layer falls off, but cannot accurately detect whether some areas of the homogenizing layer are damaged, which leads to that the photodetector cannot reliably guarantee the safety of human eyes.

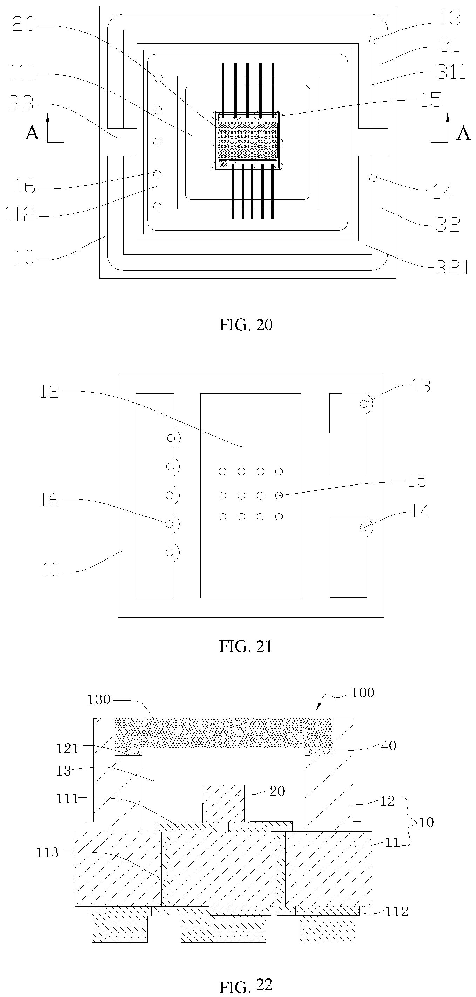

Embodiment 4 of the present disclosure provides a packaging structure of a light-emitting element. As shown in FIGS. 19 and 20, the packaging structure 100 includes a substrate 10, a light-emitting element 20, a dam 30 and a light-transmitting member 40 (transparent cover). The front surface of the substrate 10 is provided with a first circuit layer 11. The light-emitting element 20 is disposed on the front surface of the substrate 10, and the light-emitting element 20 is connected with the first circuit layer 11. The dam 30 is arranged on the front surface of the substrate 10, and includes a first part and a second part which are arranged on the front surface of the substrate 10 at intervals, wherein the first part and the second part are respectively configured as a positive conductor 31 and a negative conductor 32 connected with an electric signal detection module, and the positive conductor 31 and the negative conductor 32 are arranged on the front surface of the substrate 10 at intervals, and the positive conductor 31 and the negative conductor 32 are arranged on the periphery of the light-emitting element 20 and the first circuit layer 11. The light-transmitting member 40 (transparent cover) includes a light-transmitting conductive layer 41, a homogenizing layer 42 and a light-transmitting layer 43 which are stacked, and the light-transmitting conductive layer 41 is connected to the positive conductor 31 and the negative conductor 32. The light-emitting element 20 can be a laser element. When the first circuit layer 11 is connected with a power supply, the laser emitted by the light-emitting element 20 is refracted out of the outside through the light-transmitting member 40 (transparent cover). The homogenizing layer is provided with a homogenizing structure. When the first circuit layer 11 is connected with a power supply, the laser emitted by the light-emitting element 20 passes through the homogenizing layer 42 and refracts out of the environment with a beam with a larger angle, so as to prevent the laser from directly hitting the human eye, thereby protecting the human eye. In order to protect the safety of human eyes to a greater extent, an operator can judge whether the homogenizing layer 42 falls off or is damaged by detecting the light-transmitting conductive layer 41. The operator first connects the positive conductor 31 and the negative conductor 32 with current, and then detects the resistance of the light-transmitting conductive layer 41 through an electric signal detection module connected with the positive conductor 31 and the negative conductor 32, so as to judge whether the homogenizing layer 42 falls off or is damaged. When the resistance of the light-transmitting conductive layer 41 cannot be detected, it can be judged that the homogenizing layer 42 falls off. When the resistance of the light-transmitting conductive layer 41 can be detected, but the resistance value is not within the normal range, it can be judged that the homogenizing layer 42 and some areas of the light-transmitting conductive layer 41 are damaged (the light-transmitting conductive layer 41 is likely to be damaged during the use of the product); when the resistance of the light-transmitting conductive layer 41 can be detected, and the resistance value is within the normal range, it can be judged that the homogenizing layer 42 has not fallen off and some areas have not been damaged. According to the present disclosure, the light-transmitting conductive layer 41 capable of conducting electricity is arranged on the homogenizing layer 42, and whether the light-transmitting conductive layer 41 falls off or is damaged can be detected and judged by detecting whether the resistance value of the light-transmitting conductive layer 41 is normal. Compared with the prior art, the present disclosure not only does not need to manufacture a photoelectric detector with complicated algorithm and high cost, but also does not need to additionally configure a driving integrated circuit adapted to the driving mode of the photoelectric detector in the packaging structure, so that the packaging and detection modes are simpler, the manufacturing and detection time and cost are also reduced, the working flow is shortened, the working efficiency of products is improved, and the photoelectric detector is not needed to be arranged in the packaging space, therefore the packaging space occupied by light-emitting elements is increased, so that a light-emitting element with a larger size can be arranged in the packaging structure, and the possibility of chip size selection is increased; moreover, in the prior art, only whether the homogenizing layer falls off as a whole can be judged, while in the present disclosure, whether a part of the homogenizing layer is damaged can be judged by the magnitude of the resistance value, so that the safety of human eyes can be ensured to a greater extent.

It can be appreciated that the electrical signal detection module can detect the resistance of the light-transmitting conductive layer 41 by first detecting the current value and the voltage value passing through the light-transmitting conductive layer 41, and then calculating the resistance value of the light-transmitting conductive layer 41, so as to detect whether the homogenizing layer 42 falls off or is damaged. Of course, in the present disclosure, the current value and voltage value passing through the light-transmitting conductive layer 41 can be detected by the electric signal detection module respectively, so as to directly judge whether the homogenizing layer 42 falls off or is damaged. When the current of the light-transmitting conductive layer 41 cannot be detected, it can be judged that the homogenizing layer 42 falls off. When the current of the light-transmitting conductive layer 41 can be detected, but the current value or voltage value is not within the normal range, it can be judged that some areas of the homogenizing layer 42 and the light-transmitting conductive layer 41 are damaged. When the current of the light-transmitting conductive layer 41 can be detected, and the current value and the voltage value are within the normal range, it can be judged that the homogenizing layer 42 has not fallen off and some areas have not been damaged.

It can be appreciated that judging whether the resistance value of the light-transmitting conductive layer 41 is within the normal range can be achieved by big data comparison, etc. For example, in the same batch of tests, the resistance value of the light-transmitting conductive layer will hover around a value. If the resistance value of the light-transmitting conductive layer deviates greatly from this value, it can be judged that some areas of the homogenizing layer and the light-transmitting conductive layer in this packaging structure are damaged.

For the substrate 10, please refer to FIGS. 19, 20 and 21. In some embodiments, the back surface of the substrate 10 is provided with a second circuit layer 12 which is electrically connected to the first circuit layer 11, so as to facilitate the connection of circuits.

Preferably, please refer to FIG. 21. The substrate 10 is provided with a third conductive hole 15 and a fourth conductive hole 16 penetrating through the substrate 10. The first circuit layer 11 includes a positive circuit 111 and a negative circuit 112 respectively connecting the positive electrode and the negative electrode of the light-emitting element 20. The positive circuit 111 is connected with the second circuit layer 12 through the third conductive hole 15, and the negative circuit 112 is connected with the second circuit layer 12 through the fourth conductive hole 16.

Preferably, the first circuit layer 11 includes a driving integrated circuit (not shown), the light-emitting element 20 is a VCSEL laser chip, the driving integrated circuit is connected with the VCSEL laser chip and the light-transmitting conductive layer 41. The driving integrated circuit provides pulsed driving current to the VCSEL laser chip and the light-transmitting conductive layer 41. The electric signal detection module can be integrated into the driving integrated circuit, so that the resistance value of the light-transmitting conductive layer 41 can be detected without setting another driving integrated circuit in the packaging structure, and the manufacturing time and cost are saved. Of course, the light-emitting elements in the packaging structure provided by the present disclosure are not limited to VCSEL laser chips, and the packaging structure provided by the present disclosure is not limited to 3D TOF devices. For example, the present disclosure can also be applied to other devices that need to detect whether the homogenizing layer is damaged to ensure safety.

For the dam 30, please refer to FIGS. 20 and 21. Preferably, the substrate 10 is provided with a first conductive hole 13 and a second conductive hole 14 penetrating through the substrate 10. The positive conductor 31 is connected with the second circuit layer 12 through the first conductive hole 13, and the negative conductor 32 is connected with the second circuit layer 12 through the second conductive hole 14. The first conductive hole 13 is used to conduct the positive conductor 31 and the second circuit layer 12, and the second conductive hole 14 is used to conduct the negative conductor 32 and the second circuit layer 12.

Preferably, the top of the positive conductor 31 is provided with a first assembly groove 311, which is arranged on at least a part of the side wall of the positive conductor 31 above the light-emitting element 20 and penetrates through the top of the positive conductor 31. The top of the negative conductor 32 is provided with a second assembly groove 321, and the second assembly groove 321 is arranged on at least a part of the side wall of the negative conductor 32 above the light-emitting element 20 and penetrates through the top of the negative conductor 32. The light-transmitting member 40 (transparent cover) is fixed to the first assembly groove 311 and the second assembly groove 321 to make the mounting of the light-transmitting member 40 (transparent cover) more stable.

Preferably, the dam 30 is separated by a partition groove 33, and the positive conductor 31 and the negative conductor 32 are symmetrically arranged with respect to the partition groove 33. The dam 30 is separated by the partition groove 33, which can increase the distance between the positive conductor 31 and the negative conductor 32 and reduce the possibility of short circuit between the positive conductor 31 and the negative conductor 32. The symmetrical arrangement of the positive conductor 31 and the negative conductor 32 relative to the partition groove 33 can improve the assembly stability of the light-transmitting member 40 (transparent cover).

Preferably, the positive conductor 31 is Π-shaped, the negative conductor 32 is inverted Π-shaped, the opening of the positive conductor 31 is opposite to the opening of the negative conductor 32, and the light-emitting element 20 at least partially extends into the opening of the positive conductor 31 and/or the opening of the negative conductor 32, thereby reducing the exposed area of the light-emitting element 20 to protect the light-emitting element 20 and further increasing the service life of the packaging structure 100 of the light-emitting element.

Preferably, insulating material is provided at the partition groove 33 to reduce the possibility of short circuit between the positive conductor 31 and the negative conductor 32. The insulating material can be plastic, rubber, insulating glue, etc. The present disclosure does not limit the specific material of the insulating material, as long as it can realize the insulation between the positive conductor 31 and the negative conductor 32.

Preferably, both the positive conductor 31 and the negative conductor 32 are made of copper. In practical application, the positive conductor 31 and the negative conductor 32 can be arranged on the substrate 10 by DPC (direct plating copper). The DPC process only needs a temperature of about 250-350°C to complete the fabrication of the substrate 10, which avoids the adverse effects of high temperature on materials or circuit structures and reduces the manufacturing process cost.

As for the light-transmitting member 40 (transparent cover), it is preferable that the light-transmitting member 40 (transparent cover) has a bottom surface facing toward the light-emitting element 20, the homogenizing layer 42 completely covers the bottom surface of the light-transmitting layer 43, and the light-transmitting conductive layer 41 completely covers the bottom surface of the homogenizing layer 42, and the bottom surface of the light-transmitting conductive layer 41 is bonded to the groove bottom surfaces of the first assembly groove 311 and the second assembly groove 321 by a conductive adhesive 50 so as to fix the light-transmitting member 40 (transparent cover).

The conductive adhesive 50 refers to an adhesive with certain conductive properties, which usually consists of matrix resin and conductive filler, that is, conductive particles. The conductive adhesive 50 can be made of epoxy resin, silicone resin, polyimide resin and other materials. The present disclosure does not limit the specific material of the conductive adhesive 50, as long as the resistance of the light-transmitting conductive layer 41 can be detected without affecting the use of the packaging structure 100.

In some embodiments, the light-transmitting conductive layer 41, the homogenizing layer 42 and the light-transmitting layer 43 may all be plate-shaped, and the light-transmitting member 40 (transparent cover) may also be flat plate-shaped (as shown in FIG. 19). Of course, the specific shape of the light-transmitting member 40 (transparent cover) is not limited in the present disclosure. For example, the light-transmitting member 40 (transparent cover) can be in the shape of a hollow bulb or a hemispherical shape, so long as the homogenizing layer 42 can cover the bottom surface of the homogenizing layer 43, the light-transmitting conductive layer 41 can cover the bottom surface of the homogenizing layer 42 to ensure the safety of human eyes and realize the detection of the homogenizing layer 42.

Preferably, the light-transmitting conductive layer 41 can be made of indium tin oxide (ITO). Because ITO has good conductivity and light transmittance, a transparent conductive film can be formed on the bottom surface of the homogenizing layer 42, and the light transmittance of the transparent conductive film is over 90%. Of course, the present disclosure is not limited to the specific material of the light-transmitting conductive layer 41, for example, materials such as indium zinc oxide, indium gallium zinc oxide or indium tin zinc oxide can also be used, as long as the resistance of the light-transmitting conductive layer 41 can be detected and the light-emitting element 20 can be ensured to penetrate through the light-transmitting conductive layer 41. In practical application, the light-transmitting conductive layer 41 can cover the bottom surface of the homogenizing layer 42 by evaporation.

In the actual packaging process, the homogenizing layer 42 and the light-transmitting layer 43 which are stacked can be prepared first, then the light-transmitting conductive film 41 is evaporated on the bottom surface of the homogenizing layer 42, and then the substrate 10 is prepared, and the positive conductor 31 and the negative conductor 32 which are arranged at intervals are arranged on the substrate 10 by DPC (Direct Plating Copper) technology. Then, the light-emitting element 20 is fixed to the first circuit layer 11 by eutectic process, and the light-emitting element 20 is connected with the first circuit layer 11 by wire bonding operation. Then, conductive adhesive is arranged in the first assembly groove 311 and the second assembly groove 321 to connect the light-transmitting member 40 (transparent cover) with the dam 30 to complete the whole package. During the test, the operator first connects the positive conductor 31 and the negative conductor 32 with current, and then detects the light-transmitting conductive layer 41 through the electric signal detection module in the above manner, so as to judge whether the homogenizing layer 42 falls off or is damaged.

The present disclosure provides a packaging structure of a light-emitting element. The packaging structure 100 includes a substrate 10, a light-emitting element 20, a dam 30 and a light-transmitting member 40 (transparent cover). The front surface of the substrate 10 is provided with a first circuit layer 11. The light-emitting element 20 is disposed on the front surface of the substrate 10, and the light-emitting element 20 is connected with the first circuit layer 11. The dam 30 is arranged on the front surface of the substrate 10, and includes a positive conductor 31 and a negative conductor 32, which are arranged on the front surface of the substrate 10 at intervals, and are arranged on the periphery of the light-emitting element 20 and the first circuit layer 11. The light-transmitting member 40 (transparent cover) includes a light-transmitting conductive layer 41, a homogenizing layer 42 and a light-transmitting layer 43 which are stacked, and the light-transmitting conductive layer 41 is connected to the positive conductor 31 and the negative conductor 32. When the first circuit layer 11 is connected to a power supply, the laser light emitted by the light-emitting element 20 is refracted to the outside through the homogenizing layer 42 at a larger angle, thereby protecting human eyes. First, the operator connects the positive conductor 31 and the negative conductor 32 with current, and then the resistance of the light-transmitting conductive layer 41 can be detected, so that it can be judged whether the homogenizing layer 42 falls off or is damaged. When the resistance of the light-transmitting conductive layer 41 cannot be detected, it can be judged that the homogenizing layer 42 falls off. When the resistance of the light-transmitting conductive layer 41 can be detected, but the resistance value is not within the normal range, it can be judged that some areas of the homogenizing layer 42 and the light-transmitting conductive layer 41 are damaged. When the resistance of the light-transmitting conductive layer 41 can be detected, and the resistance value is within the normal range, it can be judged that the homogenizing layer 42 has not fallen off and some areas have not been damaged. According to the present disclosure, the light-transmitting conductive layer 41 capable of conducting electricity is arranged on the homogenizing layer 42, and whether the light-transmitting conductive layer 41 falls off or is damaged can be detected and judged by detecting whether the resistance value of the light-transmitting conductive layer 41 is normal. Compared with the prior art, the present disclosure not only does not need to manufacture a photoelectric detector with complicated algorithm and high cost, but also does not need to additionally configure a driving integrated circuit adapted to the driving mode of the photoelectric detector in the packaging structure, so that the packaging and detection modes are simpler, the manufacturing and detection time and cost are also reduced, the working flow is shortened, the working efficiency of products is improved, the photoelectric detector is not needed to be arranged in the packaging space, and the occupied space of light-emitting elements is increased, so that a light-emitting element with a larger size can be arranged in the packaging structure, and the possibility of chip size selection is increased; moreover, in the prior art, only whether the homogenizing layer falls off as a whole can be judged, while in the present disclosure, whether part of the homogenizing layer is damaged can be judged by the magnitude of the resistance value, so that the safety of human eyes can be ensured to a greater extent.

### Embodiment 5

### Embodiment 5a

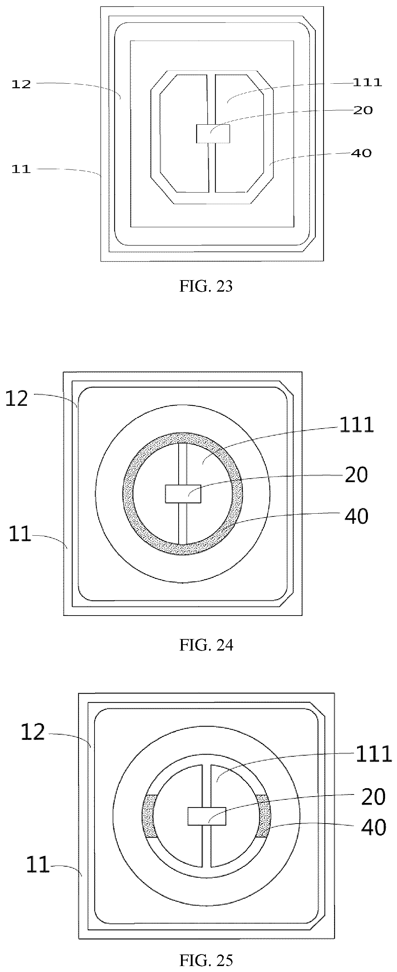

As shown in FIG. 22 and FIG. 23, the first embodiment of the present disclosure provides an LED device 100, which includes a support 10 (support structure), an LED chip 20, a light-transmitting member 30 (transparent cover) and a fluorescent substance, wherein the support 10 (support structure) has the dam and the substrate 11, and specifically, the support 10 (support structure) includes the substrate having a front surface and a back surface that are opposite to each other. The LED chip 20 is fixed on the front surface of the substrate 11. The light-transmitting member 30 and the support 10 (support structure) define an accommodating cavity 13 for accommodating the LED chip 20, and the light-transmitting member 30 is arranged on the front surface of the substrate 11 and covers the LED chip 20. The fluorescent substance is arranged on the support 10 (support structure) or/and the light-transmitting member 30, and is used for generating visible light by fluorescent reaction when the light emitted by the LED chip 20 is irradiated. When the LED chip 20 works, the light emitted by the LED chip 20 irradiates the fluorescent substance, so that the fluorescent substance can generate a visible light, therefore the LED device 100 provided by the present disclosure can conveniently detect the working state of the LED device 100 by providing the fluorescent substance, and the manufacturing and application are very simple and convenient, so that users can conveniently observe the working state of the LED device, and the probability of causing safety accidents is reduced. Moreover, in the prior art, there are mainly two methods for detecting the working state of LED devices. One is to install another chip that can emit visible light in the LED device. However, in the actual manufacturing process, if the visible light chip is connected in parallel with the LED chip, one chip may fail and another chip may work normally during use, resulting in misjudgment. If the visible light chip is connected in series with the LED chip, the visible light chip may fail, while the ultraviolet chip will not fail during use, which will also lead to the failure of the LED device, therefore the series design will increase the risk of the overall failure of the device. Another way is to add a monitoring circuit to judge whether the device is in working state by detecting and judging the current and voltage changes in the device circuit, but it is more difficult and costly to add the monitoring circuit, while the present disclosure avoids using another visible light chip or monitoring circuit in the LED device, thus avoiding the problems of increasing misjudgment rate and failure rate caused by using another visible light chip, and the difficulties in manufacturing and high cost caused by adding a monitoring circuit. In the practical application of users, the LED device mentioned in this embodiment has more advantages.

It can be appreciated that the LED device 100 can be used for lamps capable of emitting invisible light, such as UV-LED lamps and infrared LED lamps, and when a fluorescent substance capable of fluorescent reaction with the invisible light is provided, the working state of the lamps such as UV-LED lamps and infrared LED lamps can be detected.

Specifically, for the support 10, in some embodiments, the support 10 further includes a packaging body 12 (a dam), and the packaging body 12 (a dam) is used for installing the light-transmitting member 30 (i.e., a transparent cover, the assembly position of which should be higher than the top surface of the LED chip 20 in order to avoid interference between the light-transmitting member 30 and the LED chip 20), thereby improving the sealing effect of the LED device 100 and enhancing the LED device 100. Preferably, the packaging body 12 (dam) is annular and has an inner side wall, a top and a bottom, the bottom of the packaging body 12 (dam) is seated on the front surface of the substrate 11, the packaging body 12 (dam) surrounds the periphery of the LED chip 20, and the light-transmitting member 30, the packaging body 12 (dam) and the substrate 11 define the accommodating cavity. Preferably, the substrate 11 and the packaging body 12 (dam) can be integrally formed, which is very convenient to manufacture.

Preferably, the light-transmitting member 30 is bonded to the packaging body 12 (dam) by an adhesive glue 40 mixed with the fluorescent substance, and/or the fluorescent substance is arranged in the accommodating cavity. When the LED chip 20 emits invisible light, the fluorescent substance is subjected to a fluorescence reaction to emit visible light, and the visible light is emitted to the outside through the light-transmitting member 30, so that human eyes can recognize the working state of the LED device 100.

Preferably, as shown in FIG. 22, at least a part of the inner side wall of the packaging body 12 (dam) located above the LED chip 20 is provided with an assembly groove 121 penetrating through the top of the packaging body 12 (dam), and the bottom or/and side of the light-transmitting member 30 is fixed to the assembly groove 121 by the adhesive glue 40 mixed with the fluorescent substance. By fixing the adhesive glue 40 mixed with the fluorescent substance to the assembly groove 121, not only the fluorescent substance can be fixed, but also the light-transmitting member 30 can be fixed to the assembly groove 121.

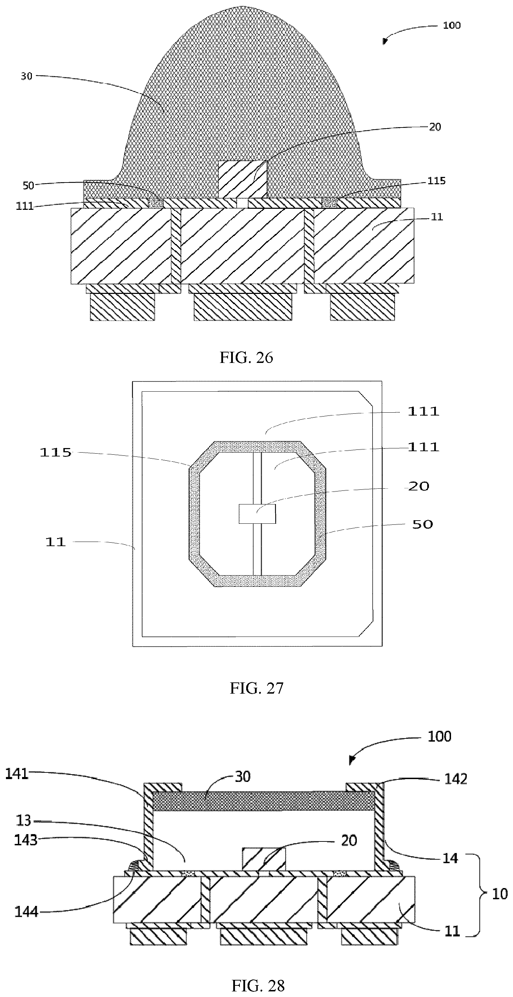

Preferably, referring to FIG. 26 and FIG. 27, the fluorescent substance is set as a fluorescent layer 50, and the fluorescent layer 50 can be ring-shaped, strip-shaped, circular or polygonal. Specifically, the fluorescent layer 50 can be made by mixing a fluorescent substance with glue, or by mixing a fluorescent substance with other curable liquids, or the fluorescent substance directly forms the fluorescent layer 50. The present disclosure is not limited to this, as long as the fluorescent substance can be arranged on the support or/and the light-transmitting member and the user can observe the visible light generated by the fluorescent substance. The present disclosure does not limit the thickness, width and shape of the coating of the fluorescent substance, as long as the user can observe the visible light generated after the fluorescent reaction of the fluorescent substance.

For the substrate 11, in some embodiments, the front surface of the substrate 11 is provided with a first circuit 111 configured to be connected to the LED chip 20. The back surface of the substrate 11 is provided with a second circuit 112, and the substrate 11 is provided with a conductive hole 113 penetrating through the front surface and the back surface. The first circuit 111 and the second circuit 112 are connected through the conductive hole 113, thereby realizing the connection between the LED chip 20, the first circuit 111 and the second circuit 112.

In a specific application, the arrangement of the first circuit 111 and the second circuit 112 on the substrate 11 can be realized by a DPC (Direct Plating copper) process.

In some embodiments, the LED chip 20 is a flip chip, a wire bonding chip or a vertical chip, and the connection between the LED chip 20 and the substrate 11 can be realized by arranging a flux material on the first circuit 111 on the front surface of the substrate 11, and then arranging the LED chip 20 on the flux material.

In some embodiments, please refer to FIG. 26 and FIG. 27. The first circuit 111 has an annular groove 115, and the fluorescent substance is arranged in the annular groove 115, so that the arrangement of the fluorescent substance is better. When the fluorescent layer 50 is not cured, the liquid to be cured can be prevented from flowing to affect the use of other components in the LED device 100. It can be appreciated that the fluorescent layer 50 can be coated on the annular groove 115, or it can be coated on the annular groove 115 in a block shape, as long as the user can conveniently observe the visible light generated by the fluorescent substance after the fluorescent reaction.

As for the light-transmitting member 30 (transparent cover), in some embodiments, the light-transmitting member 30 (transparent cover) is made of quartz or sapphire, but the specific material of the light-transmitting member 30 (transparent cover) is not limited in the present disclosure, as long as it can achieve light transmission. For example, the light-transmitting member 30 can be made of PMMA (polymethylmethacrylate). Preferably, the light-transmitting member 30 (transparent cover) can be laid flat in the assembly groove 121 in a square shape, and at least one of the bottom surface or side of the light-transmitting member 30 (transparent cover) is connected with the groove surface of the assembly groove 121 by an adhesive glue 40. When one of the bottom surface or side of the light-transmitting member 30 (transparent cover) is connected with the groove surface of the assembly groove 121 by an adhesive glue 40, the other surface can abut against the groove surface of the assembly groove 121.

As for the fluorescent substance, in some embodiments, the LED chip 20 is a UV-LED chip, and the fluorescent substance can be ultraviolet fluorescent powder or other fluorescent substances that can fluoresce with ultraviolet rays. In some other embodiments, the LED chip 20 is a high-energy infrared laser LED chip, and the fluorescent substance can be infrared phosphor powder or other fluorescent substances that can fluoresce with high-energy infrared laser. It can be appreciated that, in addition to the fluorescent substance, the present disclosure does not limit the specific material of the fluorescent substance, as long as it is arranged corresponding to the LED chip and can has a fluorescence reaction with the invisible light emitted by the LED chip to detect the working state of the LED chip.

In practical application, due to the light absorption of some fluorescent substances, in order to avoid affecting the use of the LED device 100 because the fluorescent substances absorb the light emitted by the LED chip 20, and to ensure that the fluorescent substances are sufficient to generate visible light, the concentration of the fluorescent substances mixed in the adhesive glue 40 can be 5% to 10%.

It can be appreciated that the adhesive glue 40 mixed with the fluorescent substance can be distributed on the front surface of the substrate 11 in a ring shape (see FIG. 24) or in a block shape (see FIG. 25) and located in the packaging body 12 (dam) or on the inner side wall of the packaging body 12 (dam). In the present disclosure, the thickness, width and shape of the adhesive glue 40 mixed with the fluorescent substance are not limited, as long as the user can conveniently observe the visible light generated after the fluorescent reaction of the fluorescent substance and the adhesive glue can play a bonding role when bonding the light-transmitting member 30 and the packaging body 12.

It should be noted that in addition to the above-mentioned preferred arrangement of the fluorescent substance in the assembly groove 121, in some other embodiments, the fluorescent substance can also be arranged in the accommodating cavity or even outside the accommodating cavity. For example, the fluorescent substance can be arranged on the surface (outside or inside) of the light-transmitting member 30 or on the front surface of the substrate 11, and the fluorescent substance can also be arranged on the interlayer of the light-transmitting member 30. In the present disclosure, the location of the fluorescent substance is not specifically limited, as long as the fluorescent substance is located in the LED device 100 and does not affect the reaction between the fluorescent substance and the light emitted by the LED chip 20 to generate visible light that can be observed by users.

It can be appreciated that the adhesive glue 40 refers to a coating with a bonding function. When the LED chip 20 is a UV-LED chip, the adhesive glue 40 is UV-resistant glue, usually a glue made of materials such as silica gel, epoxy resin and fluororesin. Of course, the present disclosure does not limit the specific material of the adhesive glue 40, as long as the service life of the glue can meet the service life of the device.

It can be appreciated that the arrangement of the fluorescent substance in the LED device 100 is not limited to the above-mentioned way of mixing the fluorescent substance with the adhesive glue 40. The fluorescent substance may also be arranged in a way that a fluorescent block or a fluorescent layer with a fluorescent substance made by mixing the fluorescent substance with a curable liquid is arranged on the support 10 (support structure) or/and the light-transmitting member 30 (transparent cover). The arrangement mode of the fluorescent substance is not limited in the present disclosure, as long as the fluorescent substance can be fixed in the LED device 100 and the user can observe the visible light generated by the fluorescent substance.

### Embodiment 5b:

As shown in FIG. 26 and FIG. 27, embodiment 5b of the present disclosure provides an LED device 100. Different from embodiment 5a, the light-transmitting member 30 in this embodiment 5b is hemispherical and directly wraps the LED chip 20. The support 10 (support structure) does not include the packaging body 12 (dam dam) in Embodiment 5a, which is simple in structure, small in size, better in protection for the LED chip 20 and moisture-proof.

Specifically, the LED device 100 includes a support 10 (support structure), an LED chip 20, a light-transmitting member 30 (transparent cover) and a fluorescent substance. The support 10 (support structure) includes a substrate 11 having opposite front and back surfaces. The LED chip 20 is fixed on the front surface of the substrate 11. The light-transmitting member 30 (transparent cover) is arranged on the front surface of the substrate 11 and covers the LED chip 20. The fluorescent substance is arranged on the support 10 (substrate 11) or/and the light-transmitting member 30, and is used for generating visible light by fluorescent reaction when the light emitted by the LED chip 20 is irradiated. When the LED chip 20 works, the light emitted by the LED chip 20 irradiates the fluorescent substance, so that the fluorescent substance can generate a visible light, therefore the LED device 100 provided by the present disclosure can conveniently detect the working state of the LED device 100 by setting the fluorescent substance, and the manufacturing and application are very simple and convenient, and users can conveniently observe the working state of the LED device, thus reducing the probability of causing safety accidents. Moreover, in the prior art, there are mainly two methods to detect the working state of LED devices. One is to install another chip that can emit visible light in the device. However, in the actual manufacturing process, if the visible light chip is connected in parallel with the LED chip, one chip may fail while another chip works normally, resulting in misjudgment. If the visible light chip is connected in series with the LED chip, the visible light chip may fail, while the ultraviolet chip will not fail, which will also lead to the failure of the device, therefore the series design will increase the risk of the overall failure of the device; another way is to add a monitoring circuit to judge whether the device is in working state by detecting and judging the current and voltage changes in the device circuit, but it is difficult and costly to add the monitoring circuit. In contrast, the present disclosure avoids using another visible light chip or monitoring circuit in the LED device, thus avoiding the problems of increase of misjudgment rate and device failure rate caused by using another visible light chip, and difficulty in manufacturing and high cost caused by adding monitoring circuits. The present device has greater advantages in the practical application of users.

It can be appreciated that the light-transmitting member 30 can be made of light-resistant materials such as silica gel, epoxy resin and fluororesin. Setting the light-transmitting member 30 on the front surface of the substrate 11 may be implemented by directly molding (compression molding) the light-transmitting member 30 on the front surface of the substrate 11.

### Embodiment 5c:

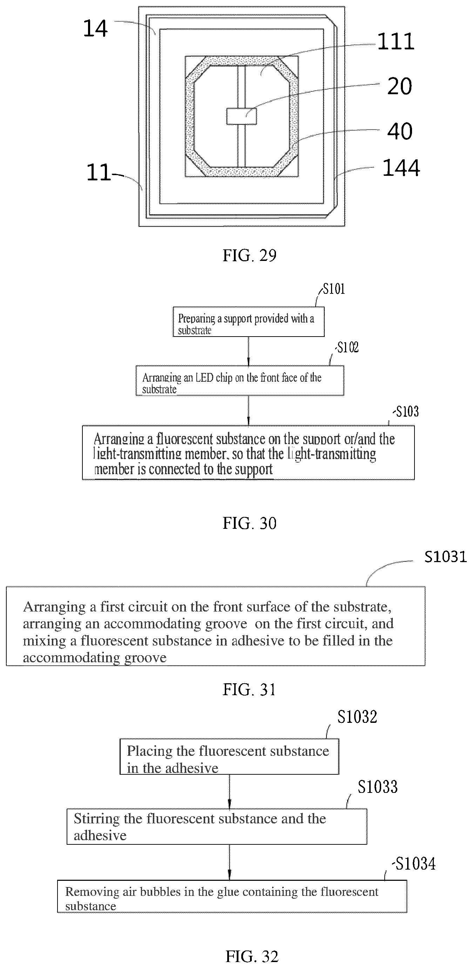

As shown in FIG. 28 and FIG. 29, the Embodiment 3 of the present disclosure provides an LED device 100. Different from Embodiment 5a, the packaging body 12 in this embodiment 5c is a metal cap 14. The LED device 100 includes a support 10 (support structure), an LED chip 20, a light-transmitting member 30 (transparent cover) and a fluorescent substance. The support 10 (support structure) includes a substrate 11 having opposite front and back surfaces. The LED chip 20 is fixed on the front surface of the substrate 11. The light-transmitting member 30 and the support 10 define an accommodating cavity 13 for accommodating the light-transmitting member 30. The fluorescent substance is arranged on the support 10 (support structure) or/and the light-transmitting member 30 (transparent cover), and is used for generating visible light by fluorescent reaction when the light emitted by the LED chip 20 is irradiated. When the LED chip 20 works, the light emitted by the LED chip 20 irradiates the fluorescent substance, so that the fluorescent substance can generate a visible light, therefore the LED device 100 provided by the present disclosure can conveniently detect the working state of the LED device 100 by setting the fluorescent substance, and the manufacturing and application are very simple and convenient, so that users can conveniently observe the working state of the LED device, thus reducing the probability of causing safety accidents. Moreover, in the prior art, there are mainly two methods to detect the working state of LED devices. One is to install another chip that can emit visible light in the device. However, in the actual manufacturing process, if the visible light chip is connected in parallel with the LED chip, one chip may fail while another chip works normally, resulting in misjudgment. If the visible light chip is connected in series with the LED chip, the visible light chip may fail, while the ultraviolet chip will not fail, which will also lead to the failure of the device, therefore the series design will increase the risk of the overall failure of the device; another way is to add a monitoring circuit to judge whether the device is in working state by detecting and judging the current and voltage changes in the device circuit, but it is difficult and costly to add the monitoring circuit. In contrast, the present disclosure avoids using another visible light chip or monitoring circuit in the LED device, thus avoiding the problems of increase of misjudgment rate and device failure rate caused by using another visible light chip, and difficulty in manufacturing and high cost caused by adding monitoring circuits. The present device has greater advantages in the practical application of users.

Specifically, the upper and lower ends of the metal cap 14 have openings, the bottom of the metal cap 14 is seated on the front surface of the substrate 11, the light-transmitting member 30 (transparent cover) is connected to the upper end of the metal cap 14 and closes the opening of the upper end. The metal cap 14 surrounds the periphery of the LED chip 20, the light-transmitting member 30 (transparent cover), the metal cap 14 and the substrate 11 define the accommodating cavity 13, and the front surface of the substrate 11 and the inside of the metal cap 14 are provided with the fluorescent substance.

In some embodiments, the metal cap 14 includes a housing part 141, and a first connecting part 142 and a second connecting part 143 extending from both ends of the housing part 141 in a direction perpendicular to the length of the housing part 141. The first connecting part 142 is located at the upper end of the metal cap 14 and the second connecting part 143 is located at the lower end of the metal cap 14. The first connecting part 142 is configured to be connected to the light-transmitting member 30, and the second connecting part 143 is configured to be connected to the substrate 11.

Further, the housing part 141 is annular, and the first connecting part 142 is formed by the housing part 141 extending into the housing part 141 along the direction perpendicular to the length of the housing part 141, the length of the first connecting part 142 is less than that of the light-transmitting member 30. The second connecting part 143 is formed by the housing part 141 extending out of the housing part 141 along the direction perpendicular to the length of the housing part 141. The first connecting part 142 surrounds the periphery of a part of the top surface of the light-transmitting member 30, and the housing part 141 surrounds the periphery of the side surface of the light-transmitting member 30.

It can be appreciated that the light-transmitting member 30 (transparent cover) and the upper end of the metal cap 14 can be connected by high-temperature sintering with glass solder as the medium, and the substrate 11 and the lower end of the metal cap 14 can be bonded to form a bonding layer 144.

### Embodiment 5d:

As shown in FIG. 30, Embodiment 5d of the present disclosure provides an LED packaging method, which is used to package the LED device 100. Referring to FIGS. 22 to 30, the LED packaging method includes the following steps:
S101: a support 10 (support structure) provided with a substrate 11 is prepared;
S102: a LED chip 20 is provided on the front surface of the substrate 11;
S103: a fluorescent substance is provided on the support 10 (support structure) or/and the light-transmitting member 30 (transparent cover) to connect the light-transmitting member 30 (transparent cover) to the support 10 (support structure).

For the step of preparing the support 10 (support structure) provided with the substrate 11, when preparing the substrate 11, a first circuit 111 and a second circuit 112 configured to be connected to the LED chip 20 can be respectively arranged on the front and back surface of the substrate 11. The arrangement of the first circuit 111 and the second circuit 112 can be implemented by a DPC (Direct Plating copper) process. In addition, the back surface of the substrate 11 can be provided with a second circuit 112, and the substrate 11 is provided with a conductive hole 113 penetrating through the substrate 11, and the first circuit 111 and the second circuit 112 are connected through the conductive hole 113, so that the LED chip 20, the first circuit 111 and the second circuit 112 can be connected, and the electrical connection of the LED chip 20 in the support 10 (support structure) can be facilitated.

In specific applications, the first circuit 111 and the second circuit 112 can be plated with nickel and gold to prevent the migration and oxidation of metals on the lines, and improve the conductivity and oxidation resistance. Among them, the thickness of nickel plating is required to be > 3µm, and the thickness of gold plating is required to be > 0.05µm, so as to ensure the conductivity and oxidation resistance.

The step of arranging the LED chip 20 on the front surface of the substrate 11 is to fix the LED chip 20 to the substrate 11. In some embodiments, the LED chip 20 is a flip chip, and the first circuit 111 includes a pad. The pad is provided with a flux material, and then the LED chip 20 is arranged on the flux material, so that the connection between the LED chip 20 and the substrate 11 can be realized. Usually, when the first circuit 11 is manufactured, the first pad will be formed simultaneously. Preferably, the flux material can be provided on the first circuit 111 by spot coating. It can be appreciated that the spot coating of the flux material on the first circuit 111 can be realized by manual or mechanical means, for example, an intelligent manipulator is arranged, and a fixed amount of flux material is uniformly arranged by the intelligent manipulator, so that the bonding effect can be further improved.

It can be appreciated that in order to make the combination of the LED chip 20 and the substrate 11 more firm, the ceramic substrate 11 with the chip fixed can be eutectic by a eutectic furnace. In practical application, when the pad can be gold-tin alloy, at least one temperature zone of the eutectic furnace is between 300°C and 340°C, and the eutectic process needs nitrogen protection.

For the step of arranging the fluorescent substance on the support 10 (support structure) or/and the light-transmitting member 30, the fluorescent substance can be arranged by mixing the fluorescent substance with glue and then coating it on the support 10 (support structure) or/and the light-transmitting member 30. It can also be arranged in the LED device 100 by arranging a fluorescent block with the fluorescent substance obtained by mixing the fluorescent substance with a curable liquid on the support 10 (support structure) or/and the light-transmitting member 30 (transparent cover), or a fluorescent layer 50 is directly formed by the fluorescent substance, as long as the fluorescent substance can be fixed in the LED device 100 and the user can observe the visible light generated by the fluorescent substance.

It can be appreciated that the glue refers to a coating with a bonding function, and the glue can be made of materials such as silica gel, epoxy resin and fluororesin, and the specific material of the glue is not limited in the present disclosure. Further, the way of curing the glue may include waiting for the glue to naturally cure, baking curing or UV light curing. It can be appreciated that the curing mode of the glue is not limited to this, as long as the glue can be cured. For example, if the glue needs to be cured by baking, it will be cured by baking, if it can be cured by direct irradiation with UV light, it will be cured by UV light, and if it is other types of glue, it will be cured by corresponding curing methods.

Preferably, the fluorescent substance is a fluorescent layer, and the fluorescent layer can be distributed in the support 10 or/and the light-transmitting member 30 (transparent cover) in the form of a ring, a strip, a circle, a polygon or a block without a specific shape. The present disclosure does not limit the thickness, width and shape of the coating of the fluorescent substance, as long as the user can conveniently observe the visible light generated after the fluorescent reaction of the fluorescent substance.

For the step of connecting the light-transmitting member 30 to the support 10 (support structure), the connection modes between the light-transmitting member 30 and the support 10 for different structural shapes and between the light-transmitting member 30 and the support 10 are slightly different, but as long as the light-transmitting member 30 (transparent cover) and the support 10 define an accommodating cavity 13 for accommodating the light-transmitting member 30 (transparent cover), or the light-transmitting member 30 is disposed on the front of the substrate 11 and covers the LED chip 20.

As one of the alternative embodiments of this embodiment, refer to Embodiment 5a of the present disclosure. Referring to FIGS. 22 to 25, the light-transmitting member 30 (transparent cover) and the support 10 (support structure) can be packaged and connected in a semi-inorganic packaging way. Specifically, after the step of preparing the substrate 11, it is necessary to prepare a packaging body 12 connected with the substrate 11. At least a part of the inner side wall of the packaging body 12 above the LED chip 20 is provided with an assembly groove 121 that runs through the top of the packaging body 12, and then the bottom of the packaging body 12 is seated on the front surface of the substrate 11, and the packaging body 12 surrounds the periphery of the LED chip 20. Then, the bottom of the light-transmitting member 30 (transparent cover) is placed in the assembly groove 121, and then the bottom or/and side of the light-transmitting member 30 (transparent cover) is fixed to the assembly groove 121 by an adhesive, and finally, the glue is cured. It can be appreciated that the setting position of the fluorescent substance can also be optimized and adjusted according to the different structural shapes of the light-transmitting member 30 and the support 10 (support structure). In the first embodiment of the present disclosure, the fluorescent substance can be mixed with the glue to fix both the light-transmitting member 30 (transparent cover) and the fluorescent substance in the assembly groove 121, so that the light-transmitting member 30 (transparent cover) and the packaging body 12 can be bonded while the fluorescent substance is arranged. Preferably, the substrate 11 and the packaging body 12 can be integrally formed, which is very convenient to manufacture.

As another alternative to this embodiment, refer to the second embodiment of the present disclosure. Referring to FIG. 26 and FIG. 27, the light-transmitting member 30 and the support 10 can be packaged and connected by organic packaging. Specifically, the light-transmitting member 30 (transparent cover) can be made of moldable materials such as silica gel, epoxy resin and fluororesin. After the step of arranging fluorescent substances on the support 10 (support structure) or/and the light-transmitting member 30 (transparent cover), the light-transmitting member 30 can be directly molded on the front surface of the substrate 11 by a mold to complete the connection between the light-transmitting member 30 and the support 10 (support structure). It can be appreciated that the arrangement position of the fluorescent substance can also be adjusted according to the specific structural shapes of the light-transmitting member 30 (transparent cover) and the support 10. In the second embodiment of the present disclosure, a fluorescent layer 50 with the fluorescent substance can be arranged on the front surface of the substrate 11 to facilitate the user's observation. The fluorescent layer 50 can be made by mixing a fluorescent substance with the adhesive glue 40 or by mixing a fluorescent substance with other curable liquids, and the present disclosure is not limited to this, as long as the fluorescent substance can be arranged on the substrate 11.

As another alternative embodiment of this embodiment, please refer to Embodiment 5c of the present disclosure. Referring to FIGS. 28 and 29, the light-transmitting member 30 (transparent cover) and the support 10 (support structure) can be packaged and connected in a fully-inorganic way. Specifically, after preparing the substrate 11, it is necessary to prepare a packaging body 12 connected with the substrate 11. The packaging body 12 is a metal cap 14, and the upper and lower ends of the metal cap 14 are provided with openings. After the support 10 (support structure) or/and the light-transmitting member 30 are provided with fluorescent substances, the light-transmitting member 30 and the upper end of the packaging body 12 are connected by glass solder. The connection between the light-transmitting member 30 (transparent cover) and the support 10 is realized by high-temperature sintering, and the opening of the upper end of the metal cap 14 is closed by the light-transmitting member 30 to seal the LED device 100. Finally, the lower end of the metal cap 14 is bonded to the front surface of the substrate 11, thereby forming a bonding layer 144.

As shown in FIG. 31, as another alternative embodiment of this embodiment, the step of arranging a fluorescent substance on the support 10 (support structure) or/and the light-transmitting member 30 further includes the following steps:
S1031: a first circuit 111 is provided on the front surface of the substrate 11, an accommodating groove is provided on the first circuit 111, and a fluorescent substance is mixed with glue to fill the accommodating groove.

In this embodiment, by arranging the accommodating groove, the glue containing fluorescent substances can be conveniently arranged, and the use of other components in the LED device 100 can be prevented from being influenced by the flow of the glue to be cured.

As shown in FIG. 32, as an alternative embodiment of this embodiment, the preparation steps of the fluorescent substance include:
S1032: the fluorescent substance is placed in the glue;
S1032: the fluorescent substance and the glue are stirred;
S1034: bubbles are removed from the glue containing fluorescent substances.

Preferably, due to the light absorption of some fluorescent substances, in order to avoid affecting the use of the LED device 100 because the fluorescent substances absorb the light emitted by the LED chip 20, and to ensure that the fluorescent substances are sufficient to generate visible light, when the fluorescent substances are placed in the glue, the concentration of the fluorescent substances mixed with the adhesive glue 40 can be controlled to be 5% to 10%. In order to ensure the concentration, an intelligent manipulator may be provided in the present disclosure, and a quantitative fluorescent substance and glue are uniformly set by the intelligent manipulator, thus ensuring the lighting effects and detection effect of the LED device 100.

It can be appreciated that the mixing of the fluorescent substance and the glue can be realized by manual and mechanical structures, for example, an intelligent manipulator is arranged for uniform mixing, so that the luminous effect of the fluorescent substance can be further improved. Removing bubbles in the glue containing fluorescent substances can be achieved by manual and mechanical structures, for example, removing bubbles by a defoamer, so that the luminous effect of the fluorescent substances can be further improved.

In this embodiment, by stirring the fluorescent substance and the glue and removing bubbles in the glue including the fluorescent substance, the fluorescent substance and the glue are mixed more evenly, thereby improving the luminous effect of the fluorescent substance and further facilitating the user to detect the working state of the LED device 100.

The present disclosure provides an LED device and an LED packaging method. The LED device 100 includes a support 10 (support structure), an LED chip 20, a light-transmitting member 30 (transparent cover) and a fluorescent substance. The support 10 includes a substrate 11 having opposite front and back surfaces. The LED chip 20 is fixed on the front surface of the substrate 11. The light-transmitting member 30 and the support 10 define an accommodating cavity 13 for accommodating the light-transmitting member 30 (transparent cover), or the light-transmitting member 30 (transparent cover) is arranged on the front surface of the substrate 11 and covers the LED chip 20. The fluorescent substance is arranged on the support 10 (support structure) or/and the light-transmitting member 30, and is used for generating visible light by fluorescent reaction when the light emitted by the LED chip 20 is irradiated. When the LED chip works, the light emitted by the LED chip irradiates the fluorescent substance, so that the fluorescent substance can generate visible light. Therefore, the LED device and the LED packaging method provided by the present disclosure detect the working state of the LED device by providing a fluorescent substance which can have a fluorescent reaction with the light emitted by the LED chip and emit visible light, which is very simple and convenient for manufacturing and application. Users can conveniently observe the working state of the LED device, which reduces the probability of causing safety accidents. In addition, the present disclosure avoids using another visible light chip or monitoring circuit in the LED device, thus avoiding the problems of increase of misjudgment rate and device failure rate caused by using another visible light chip, and difficulty in manufacturing and high cost caused by adding monitoring circuits. The present device has greater advantages in the practical application of users.

### Embodiment 6

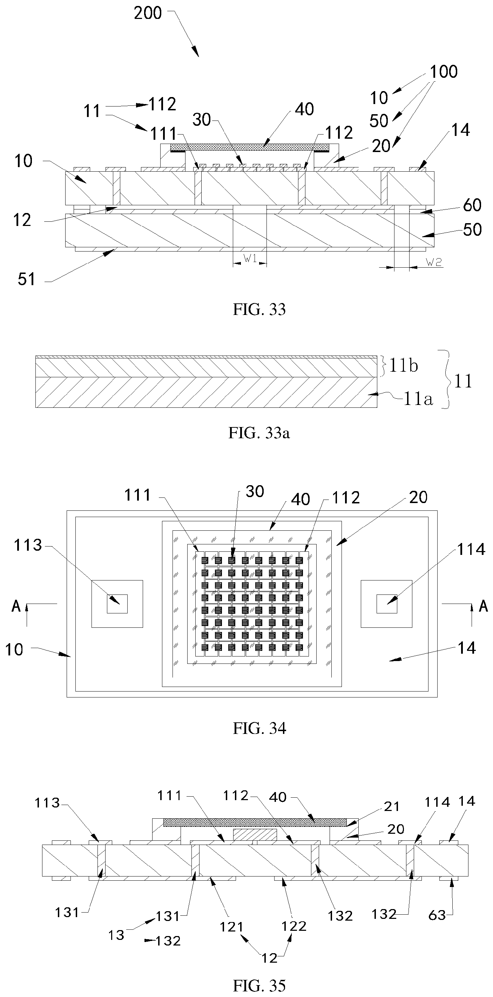

Referring to FIGS. 33 and 34, the present disclosure provides a multilayer substrate, which includes a first substrate 10, a package 20 and a second substrate 50. The first substrate 10 has a front surface and a back surface which are opposite to each other. The front surface of the first substrate 10 is provided with a first circuit layer 11, the back surface of the first substrate 10 is provided with a second circuit layer 12, and the first circuit layer 11 is electrically connected with the second circuit layer 12. The first circuit layer 11 includes a first circuit positive electrode 111 and a first circuit negative electrode 112. The packaging body 20 is annular, and is arranged on the front surface of the first substrate 10, and surrounds the periphery of the first circuit positive electrode 111 and the first circuit negative electrode 112. The second substrate 50 is connected to the second circuit layer 12 on the back surface of the first substrate 10 by a bonding process, and the back surface of the second substrate 50 is provided with a heat dissipation layer 51. On the one hand, in the multilayer substrate provided by the present disclosure, by adding the second substrate 50 and providing the heat dissipation layer 51 on the second substrate 50 instead of the back surface of the first substrate 10, the circuit on the back surface of the first substrate 10 cannot contact with the radiator or the heat dissipation layer 51, therefore the insulating layer in the prior art is not needed for avoiding the contact between the circuit and the radiator or the heat dissipation layer, thereby avoiding the problem of short circuit or leakage of the positive and negative electrodes caused by the insulating layer falling off in the prior art. On the other hand, by arranging the interconnected circuits on the front and back surfaces of the first substrate 10, the circuits do not need to pass through the packaging body 20, so that there is no need to set a through notch on the packaging body 20 as in the prior art, and the subsequent problem that it is difficult to effectively hermetically package the LED device 200 caused by setting the notch is avoided. Therefore, the present disclosure not only realizes the heat dissipation of high-power products, meets the requirements of airtight packaging of high-power LED products, but also reduces the failure risk of LED products and improves the safety and reliability of products.

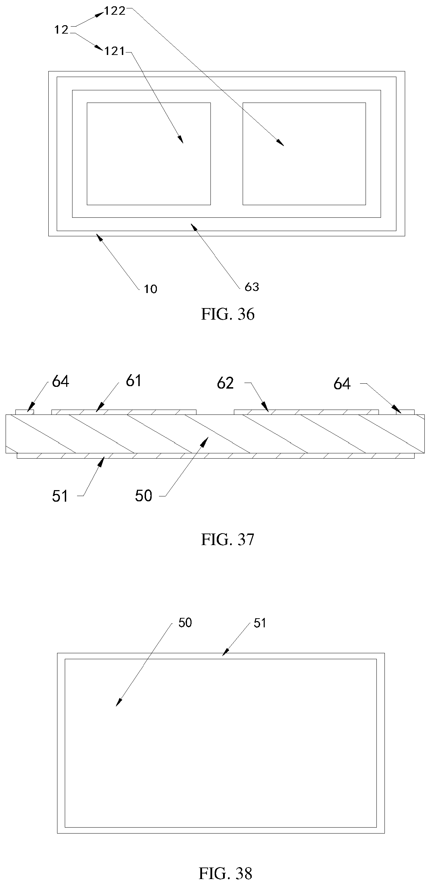

For the first substrate 10, please refer to FIGS. 34 to 36. The first substrate 10 is provided with conductive holes 13, which include at least two first conductive holes 131 and at least two second conductive holes 132. Preferably, the openings of the at least two first conductive holes 131 on the front surface of the first substrate 10 are located at the inside and outside of the packaging body 20. The openings of the at least two second conductive holes 132 on the front surface of the first substrate 10 are located at the inner side and the outer side of the packaging body 20, respectively, and conductive materials are arranged in each of the first conductive holes 131 and the second conductive holes 132, thereby realizing the conduction between the first circuit layer 11 and the second circuit layer 12. The conductive hole 13 penetrates through the first substrate 10, so that the circuits do not need to pass through the packaging body 20, so that there is no need to set a through notch on the packaging body 20 as in the prior art, thereby avoiding the subsequent problem that it is difficult to effectively hermetically package the LED device 200 caused by setting the notch, further meeting the requirements for airtight packaging of high-power LED products, reducing the failure risk of the LED products and improving the safety and reliability of the products.

In some embodiments, referring to FIG. 33a, the surface of the first substrate 10 is provided with a surface metal layer 11b for covering the surface of the copper material 11a forming the first circuit layer 11, so as to improve the oxidation resistance of products and facilitate the subsequent arrangement of the LED chip 30 on the surface of the first substrate 10. Specifically, the material of the surface metal layer 11b (the first circuit layer 11) may be gold (Au), silver (Ag), nickel (Ni), palladium (Pd) and the like. It should be noted that the LED chip 30 can be a flip chip, and then the LED chip 30 can be fixed by a eutectic process. The materials of the surface metal layer 11b can be preferably nickel and gold, and the gold layer covers the nickel layer, wherein the thickness of the nickel layer can be greater than 3 microns, and the thickness of the gold layer can be greater than 0.05 microns. The LED chip 30 may also be a horizontal or vertical chip, and then the LED chip 30 can be fixed by a bonding process. The surface metal layer 11b may be made of nickel, palladium and gold, and the nickel layer, the palladium layer and the gold layer are sequentially stacked from the front surface of the first substrate 10, wherein the thickness of the nickel layer can be greater than 3 microns, the thickness of the palladium layer can be greater than 0.05 microns, and the thickness of the gold layer can be greater than 0.05 microns.

In specific applications, the first substrate 10 may be made of ceramic materials, such as aluminum nitride ceramics (AlN), gallium nitride ceramics (GaN), alumina ceramics (Al2O3), silicon carbide ceramics (SiC) and the like, so as to meet the heat dissipation and insulation of LED devices, especially high-power LED devices. In specific applications, the thickness of the first substrate 10 may be 0.3 mm to 2.0 mm.

For the first circuit layer 11 and the second circuit layer 12, please refer to FIGS. 34 to 36. The first circuit layer 11 further includes a positive electrode 113 and a negative electrode 114, which are arranged on the front surface of the first substrate 10 and are arranged on the periphery of the packaging body 20. There is no need to set a notch in the packaging body 20. The second circuit layer 12 includes a second circuit positive electrode 121 and a second circuit negative electrode 122 which are separated and insulated from each other. The second circuit positive electrode 121 and the second circuit negative electrode 122 are arranged on the back surface of the first substrate 10, the second circuit positive electrode 121 is located below the positive electrode 113 and the first circuit positive electrode 111, and the second circuit negative electrode 122 is located below the negative electrode 114 and the first circuit negative electrode 112. The second circuit positive electrode 121 is connected with the positive electrode 113 and the first circuit positive electrode 111 through at least two first conductive holes 131, and the second circuit negative electrode 122 is connected with the negative electrode 114 and the first circuit negative electrode 112 through at least two second conductive holes 132.

Specifically, there are at least two first conductive holes 131, the electrode positive electrode 113 is arranged on the front surface of the first substrate 10 and covers one first conductive hole 131 (upper end), the first circuit positive electrode 111 is arranged on the front surface of the first substrate 10 and covers another first conductive hole 131 (upper end), and the second circuit positive electrode 121 is correspondingly arranged on the back surface of the first substrate 10. The second circuit positive electrode 121 covers one of the first conductive holes 131 (lower end), and the second circuit positive electrode 121 covers another of the first conductive holes 131 (lower end), so that the second circuit positive electrode 121 is connected with the positive electrode 113 and the first circuit positive electrode 111 through the first conductive holes 131, thereby realizing the connection between the positive electrode 113 and the first circuit positive electrode 111. Similarly, there are at least two second conductive holes 132, the negative electrode 114 is arranged on the front surface of the first substrate 10 and covers one second conductive hole 132 (upper end), the first circuit negative electrode 112 is arranged on the front surface of the first substrate 10 and covers another second conductive hole 132 (upper end), and the second circuit negative electrode 122 is correspondingly arranged on the back surface of the first substrate 10. The second circuit negative electrode 122 covers one of the second conductive holes 132 (lower end) and the second circuit negative electrode 122 covers another of the second conductive holes 132 (lower end), so that the second circuit negative electrode 122 is connected with the negative electrode 114 and the first circuit negative electrode 112 through the second conductive holes 132, thereby realizing the connection between the negative electrode 114 and the first circuit negative electrode 112.

Specifically, the front surface of the first substrate further includes a protective layer 14. The protective layer 14 is a circle of metal layers left after the first circuit layer 11 is made by etching process, which is actually the same as the structure of the first circuit layer 11, except that this protective layer 14 does not conduct electricity, and remains on the surface of the ceramic substrate to balance stress, prevent the first substrate 10 from warping, and also protect the substrate. A protective layer similar to the protective layer 14 can also be provided on the back surface of the first substrate 10, and the protective layer on the back surface of the first substrate 10 can participate in the bonding of the first substrate 10 and the second substrate 50.

Preferably, a conductive metal connecting the first circuit layer 11 and the second circuit layer 12 can be provided in the conductive hole 13 to make the conductive hole 13 conductive, wherein the conductive metal can be metals such as tungsten (W), titanium (Ti), nickel (Ni), chromium (Cr), copper (Cu) or the alloys thereof.

In specific applications, the aperture of the conductive hole 13 can be 0.09 mm to 0.15 mm, so as to ensure the conductive function of the conductive hole 13, and at the same time, avoid the influence of the oversized aperture on the use of the first substrate 10. If the current that needs to pass through the first circuit layer 11 and the second circuit layer 12 is large, the number of the conductive holes 13 can be increased accordingly, and the distance between each conductive hole 13 can be greater than 0.2 mm, so as to avoid the ceramic substrate from being broken because the distance between the conductive holes 13 is too small.

Preferably, the interval between the second circuit positive electrode 121 and the second circuit negative electrode 122 is filled with an insulating material, thereby ensuring insulation.

In specific applications, the first circuit layer 11, the second circuit layer 12 and the following third bonding part 63 can all be provided on the first substrate 10 by a DPC (Direct Plating copper) process.

For the packaging body 20, please refer to FIGS. 33 to 35, wherein, FIGS. 33, 33a and 34 are examples of an LED device including a plurality of chips; FIG. 35 is another LED device only suitable for a single chip. The packaging body 20 is annular and has a top and a bottom, and the bottom of the packaging body 20 is arranged on the front surface of the first substrate 10. The packaging body 20 is provided with an assembly groove 21 for setting a light-transmitting member 40 capable of closing the notch of the assembly groove 21, and the assembly groove 21 penetrates the inner side wall and the top of at least a part of the packaging body 20 above the LED chip 30 described below. When the light-transmitting member 40 is disposed in the assembly groove 21, the light-transmitting member 40, the packaging body 20 and the front surface of the first substrate 10 form a packaging cavity for accommodating the LED chip 30.

It can be appreciated that the packaging body 20 can be in a hollow step shape, and the step of the packaging body 20 is the assembly groove 21. In order to facilitate the assembly of the light-transmitting member 40 and the sealant for fixing the light-transmitting member 40, the packaging body 20 can be in a single-layer step or a multilayer step shape. For example, when the packaging body 20 is in a single-layer step shape, the bottom surface of the light-transmitting member 40 is arranged on the groove bottom surface of the assembly groove 21 through the sealant. For example, when the packaging body 20 has a double step, the light-transmitting member 40 can be directly arranged on the lower step, and the sealant is arranged between the side of the light-transmitting member 40 and the side wall surface of the higher step to fix the light-transmitting member 40 in the assembly groove 21. Of course, although the packaging body 20 in the embodiment of the present disclosure can be stepped, the present disclosure is not limited to the step shape of the packaging body 20, for example, the top of the packaging body 20 can also be a flat table, and the bottom surface of the light-transmitting member 40 can be provided on the top surface of the packaging body 20 by bonding. In addition, the present disclosure does not limit the shape of the packaging body 20, for example, the packaging body 20 can be round, square or diamond, as long as the light-transmitting member 40 can be arranged in the assembly groove 21 without affecting the use of the LED device.

In specific applications, the packaging body 20 can be made of copper material, and the surface of the packaging body 20 can be provided with stacked nickel metal layers and gold metal layers, thereby improving the corrosion resistance and wear resistance of the packaging body 20 and prolonging the service life of the packaging body 20. Moreover, the height of the packaging body 20 can be 200 microns to 1200 microns, the thickness of the nickel metal layer arranged on the packaging body 20 can be greater than 3 microns, and the thickness of the gold metal layer can be greater than 0.05 microns.

As for the second substrate 50, please refer to FIG. 33, FIG. 37 and FIG. 38. In specific applications, both the first substrate 10 and the second substrate 50 can be ceramic substrates, and the second substrate 50 can be made of ceramic materials, such as aluminum nitride ceramics (AlN), gallium nitride ceramics (GaN), alumina ceramics (Al₂O₃), silicon carbide ceramics (SiC), etc. In specific applications, the thickness of the second substrate 50 may be 0.3 mm to 2.0 mm.

For the heat dissipation layer 51, it is preferable that the heat dissipation layer 51 includes a copper heat dissipation layer, a nickel heat dissipation layer and a gold heat dissipation layer which are stacked. The thickness of the copper heat dissipation layer is 50 to 300 microns, the thickness of the nickel heat dissipation layer is greater than 3 microns, and the thickness of the gold heat dissipation layer is greater than 0.05 microns, so that the heat dissipation layer 51 has a better heat dissipation effect.

In some embodiments, there is a bonding layer 60 between the first substrate 10 and the second substrate 50 to connect the first substrate 10 and the second substrate 50. For the bonding layer 60, please refer to FIGS. 33 to 38. In some embodiments, the bonding layer 60 includes a first bonding part 61 and a second bonding part 62 separated from each other, and the first bonding part 61 is located on the front surface of the second substrate 51 corresponding to the second circuit positive electrode 121. The second bonding part 62 is arranged on the front surface of the second substrate 50 corresponding to the second circuit negative electrode 122. The first bonding part 61 and the second bonding part 62 are bonded with the second circuit positive electrode 121 and the second circuit negative electrode 122, respectively, and the first bonding part 61 is insulated from the second bonding part 62, thus realizing the bonding of the first substrate 10 and the second substrate 50.

Preferably, the first bonding part 61 and the second circuit positive electrode 121 have the same shape and size, and the second bonding part 62 and the second circuit negative electrode 122 have the same shape and size. This arrangement not only enables the first substrate 10 and the second substrate 50 to be better connected, but also avoids the phenomenon of short circuit between the positive and negative electrodes caused by slight dislocation when the first substrate 10 and the second substrate 50 are bonded to some extent. Specifically, along the direction perpendicular to the thickness of the first bonding part 61 and the second circuit positive electrode 121, the shape and size of the first bonding part 61 and the second circuit positive electrode 121 are the same, and the shape and size of the second bonding part 62 and the second circuit negative electrode 122 are the same. The present invention does not limit the specific shapes, sizes and thicknesses of the first bonding part 61, the second circuit positive electrode 121, the second bonding part 62 and the second circuit negative electrode 122, as long as the first bonding part 61 and the second bonding part 62 can play the role of bonding and the second circuit positive electrode 121 and the second circuit negative electrode 122 can play the role of circuit conduction and bonding.

Preferably, the bonding layer 60 further includes a third bonding part 63, which may be in a closed ring shape and surround the periphery of the second circuit layer 12. Further, the third bonding portion 63 may be spaced and insulated from the second circuit layer 12. Similarly, the bonding layer 60 may also include a fourth bonding part 64, which may be in a closed ring shape and surround the periphery of the first bonding part 61 and the second bonding part 62. Further, the fourth bonding part 64 may be spaced and insulated from the first bonding part 61 and the second bonding part 62. Further, the third bonding part 63 and the fourth bonding part 64 together with the back surface of the first substrate 10 and the front surface of the second substrate 50 can define a closed space for accommodating the second circuit positive electrode 121 and the second circuit negative electrode 122 to protect the second circuit positive electrode 121 and the second circuit negative electrode 122. The arrangement of the third bonding part 63 and the fourth bonding part 64 can not only improve the connection firmness between the first substrate 10 and the second substrate 50, but also surround the periphery of the second circuit positive electrode 121, the second circuit negative electrode 122, the first bonding part 61 and the second bonding part 62 to reduce the possibility of water vapor invading the second circuit positive electrode 121 and the second circuit negative electrode 122, and improve the protective performance of products.

Preferably, the shape and size of the third bonding part 63 and the fourth bonding part 64 are the same. This arrangement not only enables the first substrate 10 and the second substrate 50 to be better connected, but also avoids the short circuit between the positive and negative electrodes caused by slight dislocation when the first substrate 10 and the second substrate 50 are bonded to some extent. Specifically, along the direction perpendicular to the thickness of the third bonding part 63 and the fourth bonding part 64, the shape and size of the third bonding part 63 and the fourth bonding part 64 are the same. The present disclosure does not limit the specific shape, size and thickness of the third bonding part 63 and the fourth bonding part 64 as long as the third bonding part 63 and the fourth bonding part 64 can play a bonding role.

Preferably, in order to avoid the phenomenon that the first substrate 10 and the second substrate 50 are slightly misaligned during bonding, the distance between the third bonding part 63 and the second circuit layer 12, the second circuit positive electrode 121 and the second circuit negative electrode 122, the fourth bonding part 64 and the first bonding part 61 and the second bonding part 62, and the distance between the first bonding part 61 and the second bonding part 62 can be limited in the present disclosure to reduce the possibility of short circuit. With reference to FIG. 33, FIG. 36 and FIG. 37, in specific applications, the minimum distance W1 between the third bonding part 63 and the second circuit layer 12 may be greater than 0.2 mm, and the minimum distance W2 between the second circuit positive electrode 121 and the second circuit negative electrode 122 may be greater than 0.2 mm; the minimum distance between the fourth bonding part 64 and the first bonding part 61 may be greater than 0.2 mm; the minimum distance between the fourth bonding part 64 and the second bonding part 62 may be greater than 0.2 mm; the minimum distance between the first bonding part 61 and the second bonding part 62 may be greater than 0.2 mm.

Preferably, an insulating material may be provided at the interval between the third bonding part 62 and the second circuit layer 12 to ensure insulation.

Preferably, the first circuit layer 11, the second circuit layer 12 and the bonding layer 60 all include a copper metal layer, a nickel metal layer and a gold metal layer which are stacked. The thickness of the copper metal layer can be 50 microns to 80 microns, the thickness of the nickel metal layer can be greater than 3 microns, and the thickness of the gold metal layer can be greater than 0.05 microns, so that the first circuit layer 11 and the second circuit layer 12 have better circuit conduction effect, and

Referring to FIGS. 33 and 34, the present disclosure provides an LED device 200, which includes the multilayer substrate 100, and may further include a light-transmitting member 40 and an LED chip 30. The light-transmitting member 40 is connected to the packaging body 20, and the LED chip 30 is arranged on the front surface of the first substrate 10 and electrically connected with the first circuit positive electrode 111 and the first circuit negative electrode 112. The light-transmitting member 40, the packaging body 20 and the front surface of the first substrate 10 form a packaging cavity for sealing the LED chip 30.

As for the LED chip 30, please refer to FIG. 33 and FIG. 34. Preferably, the LED chip 30 is integrated by Chip on Board packaging. In the prior art, LED modules are usually integrated by SMT (Surface Mounted Technology) patch. This integration method needs to be carried out on the basis of PCB first, and LED devices need to be arranged on PCB, which mainly has three problems. First, each LED device often needs solder paste to be soldered to a printed circuit board (PCB), leading to the result that the heat emitted by the chip in the LED device can only be transmitted to the radiator connected to the PCB through the solder paste and the PCB, which makes the heat dissipation path longer, thus affecting the heat dissipation and service life of the product; and in addition, insulating layers are needed to avoid short circuit on the PCB when manufacturing the PCB, which further reduces the thermal conductivity of the product. Second, when setting LED devices by SMT, there should be a certain distance between the devices to avoid the mutual interference between LED devices caused by the error in the process of mounting; and under the influence of the size of LED devices, the size of LED module is further increased, which makes the application of products limited. Thirdly, the large distance between LED devices also reduces the optical power density in unit area. However, the chip can be directly integrated on the substrate by adopting the COB packaging method. Compared with the SMT packaging method in the prior art, the COB packaging method does not need to use solder paste, thus shortening the heat dissipation path of the product and improving the heat dissipation of the product, and also does not need to increase the distance between chips to avoid the chip mounting error, thereby reducing the size of the product, improving the optical power density of the product and improving the use effect.

Preferably, the LED chip 30 can be a UV-LED chip, and the wavelength range of the UV-LED chip can be 100 nm to 350 nm. The present disclosure can realize the heat dissipation of the high-power UV-LED device, meet the requirements for the airtight packaging of the high-power UV-LED device, reduce the failure risk of the high-power UV-LED device, and improve the safety and reliability of the product.

Preferably, the LED chip 30 can be a flip chip, so as to facilitate the integration by using COB. In addition, the electrode of the LED chip 30 can be made of gold-tin alloy, so that the LED chip 30 can be conveniently arranged on the first substrate 10.

In specific applications, the number and connection mode of the LED chips 30 can be adapted according to actual needs or the power supply of the LED device 200. For example, the number of the LED chips 30 may be 64, and the 64 LED chips 30 are respectively arranged on the front surface of the first substrate 10 in 8 rows and 8 columns, and the LED chips 30 in each row are connected in series. It can be appreciated that in some other embodiments, the series and parallel connection of the LED chips 30 can be set in 2*2 (2 series and 2 parallel), 3*3, 4*4, 5*5, 6*6, 7*7, 8*8, etc. The present disclosure does not limit the number and connection mode of the LED chips 30, as long as it does not affect the actual use.

Referring to FIG. 33, the light-transmitting member 40 can be made of quartz or sapphire. The bottom of the light-transmitting member 40 configured to be connected to the packaging body 20 can be provided with a gold-tin alloy for convenient connection, wherein the content of gold is 80wt%, the content of tin is 20wt%, and the melting point of the gold-tin alloy is 280°C.

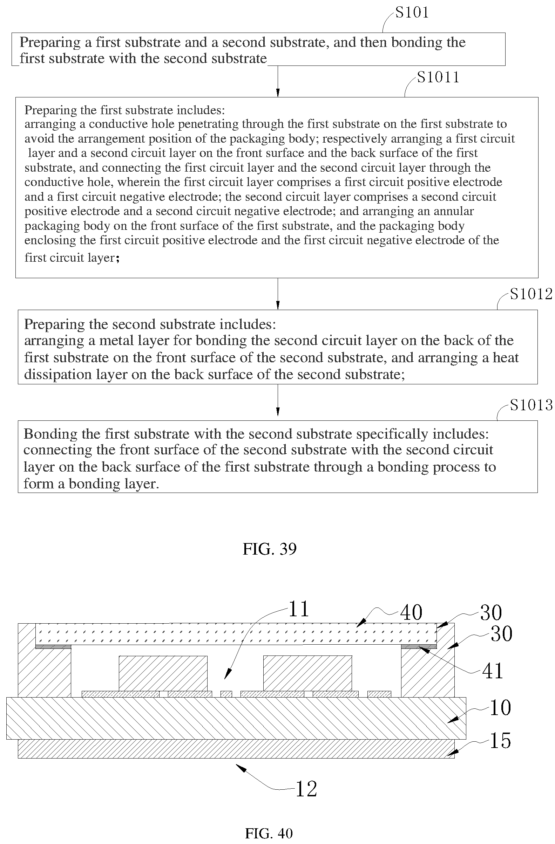

As shown in FIG. 39, a method for manufacturing a multilayer substrate provided by an embodiment of the present disclosure can be used for manufacturing the multilayer substrate 100. Please refer to FIGS. 33- 38, the method includes the following steps:
S101: a first substrate and a second substrate are prepared, and then the first substrate and the second substrate are bonded;
S1011: preparing the first substrate includes:
   providing a conductive hole penetrating through the first substrate on the first substrate to avoid the assembly position of the packaging body;
   respectively providing a first circuit layer and a second circuit layer on the front surface and the back surface of the first substrate, and connecting the first circuit layer and the second circuit layer through the conductive hole, the first circuit layer including a first circuit positive electrode and a first circuit negative electrode; the second circuit layer including a second circuit positive electrode and a second circuit negative electrode;
   providing an annular packaging body on the front surface of the first substrate, and the packaging body enclosing the first circuit positive electrode and the first circuit negative electrode of the first circuit layer;
S1012: manufacturing the second substrate includes:
   providing a metal layer for bonding the second circuit layer on the back surface of the first substrate on the front of the second substrate, and providing a heat dissipation layer on the back surface of the second substrate;
S1013: bonding the first substrate and the second substrate specifically includes:
   connecting the front surface of the second substrate with the second circuit layer on the back surface of the first substrate by a bonding process to form a bonding layer.

Preferably, the first substrate 10 and the second substrate 50 can be made of ceramic materials, such as aluminum nitride ceramics (AlN), gallium nitride ceramics (GaN), alumina ceramics (Al₂O₃), silicon carbide ceramics (SiC), so as to meet the heat dissipation and insulation of LED devices, especially high-power LED devices. In practical application, the first substrate 10 and the second substrate 50 can be made by tape casting, and then polished and/or cut to the required size. In practical application, the thickness of the first substrate 10 and the second substrate 50 may be 0.3 mm to 2.0 mm.

Preferably, after the step of setting the conductive hole 13 through the first substrate 10, the surface film of the first substrate 10 can be metallized to improve the performance of the surface of the first substrate 10.

Specifically, the way of arranging the conductive hole 13 may include drilling a hole on the first substrate 10 by laser drilling or mechanical drilling, and then the conductive hole 13 is formed by plating a conductive metal by vacuum plating in the hole. The conductive hole 13 has a conductive function. The conductive metal can be metals such as tungsten (W), titanium (Ti), nickel (Ni), chromium (Cr), copper (Cu) or the alloys thereof. In addition, the aperture of the conductive hole 13 can be 0.09 mm to 0.15 mm, so as to ensure the conductive function of the conductive hole 13, and at the same time, avoid the influence of the oversized aperture on the use of the first substrate 10. If the current that needs to pass through the first circuit layer 11 and the second circuit layer 12 is large, the number of the conductive holes 13 can be increased accordingly, and the distance between each conductive hole 13 can be greater than 0.2 mm, so as to avoid the ceramic substrate from being broken because the distance between the conductive holes 13 is too small.

Specifically, the surface of the first substrate 10 can be metallized by depositing a thin film metal on the surface of the first substrate 10 by vacuum plating or magnetron sputtering, and the thin film metal can be metals such as tungsten (W), titanium (Ti), nickel (Ni), chromium (Cr) or the alloys thereof. In specific applications, the thin film metal may be a tungsten-titanium alloy (WTi), and the thickness of the tungsten-titanium alloy (WTi) can be 0.1 micron. In specific applications, the thin film metal may be a nickel-chromium alloy (CrNi), and the thickness of the nickel-chromium alloy (CrNi) can be 0.25 micron.

Specifically, the first circuit layer 11 and the second circuit layer 12 on the front and back of the first substrate 10 and the heat dissipation layer 51 on the back surface of the second substrate 50 can be provided on the first substrate 10 or the second substrate 50 by a DPC (Direct Plating copper) process.

Preferably, the steps of arranging the first circuit layer 11 and the second circuit layer 12 can be as follows: plating copper on the surface of the first substrate 10; pressing a dry film on the copper-plated surface of the first substrate 10, and respectively arranging the patterns of the first circuit layer 11 and the second circuit layer 12 on the dry film; exposing and developing the first circuit layer 11 and the second circuit layer 12; etching the circuit to remove unnecessary copper; removing the dry film on the surface of the first substrate 10; grinding the first substrate 10, the first circuit layer 11 and the second circuit layer 12, wherein the thickness of copper plating can be 50 microns to 80 microns; the purpose of dry film pressing is to make the dry film cover the copper surface of the first substrate 10 so that the patterns of the first circuit layer 11 and the second circuit layer 12 can be carved on the dry film respectively; the first circuit layer 11 and the second circuit layer 12 can be ground by an abrasive belt, thereby improving the flatness of the surfaces of the first substrate 10, the first circuit layer 11 and the second circuit layer 12. It can be appreciated that the bonding layer 60 and the heat dissipation layer 51 can also be provided on the first substrate 10 or the second substrate 50 through the same steps.

Preferably, the step of arranging the annular package 20 on the front surface of the first substrate 10 may include: sandblasting the packaging body 20; laminating the packaging body 20; exposing and developing the packaging body 20; electroplating and thickening the packaging body 20; grinding the surface of the packaging body 20; removing the dry film on the surface of the packaging body 20; subjecting the packaging body 20 to copper and titanium removal treatment. Among them, sandblasting the packaging body 20 can remove impurities, mottle and oxide layer on the surface of the packaging body 20, and at the same time roughen the surface, eliminate the residual stress of the workpiece and improve the surface hardness of the substrate. Grinding is used to improve the flatness of the surface of the packaging body 20.

In specific applications, in order to improve the corrosion resistance and wear resistance of the packaging body 20 and prolong the service life of the packaging body 20, the packaging body 20 can be made of copper, and a nickel metal layer and a gold metal layer can be stacked on the surface of the packaging body 20. In practical application, the height of the packaging body 20 can be 200 microns to 1200 microns, the thickness of the nickel metal layer arranged on the packaging body 20 can be greater than 3 microns, and the thickness of the gold metal layer can be greater than 0.05 microns.

Preferably, before the step of arranging the annular package 20 on the front surface of the first substrate 10 or the step of arranging the LED chip 30 on the front surface of the first substrate 10, a surface metal layer 11b can be arranged on the copper surfaces 11a of the first substrate 10 (on which the heat dissipation layer 51 has been arranged) and the second substrate 50, thereby improving the oxidation resistance of products and facilitating the subsequent arrangement of the first circuit layer 11 and the LED chip 30 on the surface of the first substrate 10. Specifically, the material of the surface metal layer 11b can be gold (Au), silver (Ag), nickel (Ni), palladium (Pd) and the like. It should be noted that the LED chip 30 can be a flip chip, and then the LED chip 30 can be fixed by a eutectic process. The materials of the surface metal layer 11b can be preferably nickel and gold, and the gold layer covers the nickel layer, wherein the thickness of the nickel layer can be greater than 3 microns, and the thickness of the gold layer can be greater than 0.05 microns. The LED chip 30 can also be a horizontal or vertical chip, and then the LED chip 30 can be fixed by a bonding process. The materials of the surface metal layer 11b can be preferably nickel, palladium and gold. From the front surface of the first substrate 10, the nickel layer, palladium layer and gold layer are sequentially stacked, wherein the thickness of the nickel layer can be greater than 3 microns, palladium layer can be greater than 0.05 microns and gold layer can be greater than 0.05 microns.

Preferably, the way of connecting the front surface of the second substrate 50 to the back surface of the first substrate 10 through the bonding layer 60 may be bonding the front surface of the second substrate 50 to the back surface of the first substrate 10 by means of solder reflow or vacuum furnace bonding, and the bonding temperature can be adjusted according to the melting point of the solder. In the specific application, the specific material of the solder can be selected according to the specific processing mode of the chip and the light-transmitting member 40. For example, when the flux materials selected for chip eutectic and packaging the light-transmitting member 40 are all gold-tin alloys with 80wt% of gold and 20wt% of tin, the solder can also adopt this gold-tin alloy; for another example, for products whose temperature is below 280°C in the subsequent packaging process, the solder can be Au-Sn alloy (Au₈₀Sn ₂₀), in which the content of gold is 80wt%, the content of tin is 20wt%, and the melting point of the solder can be 280°C. For another example, for products whose temperature is below 360°C in the subsequent packaging process, the solder can be Au-Ge alloy (Au₈₈Ge₁₂), in which the content of Au is 88wt%, the content of Ge is 12wt%, and the melting point of the solder can be 361°C, which is suitable for products whose temperature is below 360°C in the subsequent packaging process. It can be appreciated that the spot coating of the solder on the first substrate 10 and the second substrate 50 can be realized by manual or mechanical means, for example, an intelligent manipulator is arranged, and a certain amount of solder is uniformly arranged by the intelligent manipulator, so that the bonding effect can be further improved.

It can be appreciated that the solder is coated on the front surface of the second substrate 50 and bonded on the back surface of the first substrate 10 to form the bonding layer 60 after bonding. Specifically, the part of the bonding layer 60 on the back surface of the first substrate 10 is a third bonding part 63, and the part of the bonding layer 60 on the front of the second substrate 50 is a first bonding part 61, a second bonding part 62 and a fourth bonding part 64. The first bonding part 61 corresponds to the second circuit positive electrode 121, and the first bonding part 61 is bonded with the second circuit positive electrode 121 in the second circuit layer 12. The second bonding part 62 corresponds to the second circuit negative electrode 122, and the second bonding part 62 is bonded to the second circuit negative electrode 122 in the second circuit layer 12. The third bonding part 63 is arranged on the back surface of the first substrate 10 and surrounds the periphery of the second circuit positive electrode 121 and the second circuit negative electrode 122 in an annular shape. The fourth bonding part 64 corresponds to the third bonding part 63, and the fourth bonding part 64 surrounds the periphery of the first bonding part 61 and the second bonding part 62 in an annular shape. Preferably, the solder can be more evenly coated on the periphery of the second circuit positive electrode 121 and the second circuit negative electrode 122 at the third bonding part 63 and the fourth bonding part 64. The thickness of the solder at the third bonding part 63 and the fourth bonding part 64 (that is, the stacked thickness of the third bonding part 63 and the fourth bonding part 64) is equal to the stacked thickness of the second circuit positive electrode 121 and the first bonding part 61 and the stacked thickness of the second circuit negative electrode 122 and the second bonding part 62, which can reduce the possibility of water vapor invading the second circuit positive electrode 121 and the second circuit negative electrode 122 and improve the protective performance of the product. Of course, the present disclosure does not limit the specific shape, size and thickness of each part in the bonding layer 60, that is, the specific shape, size and thickness of the solder coating, as long as it can play a soldering role.

Preferably, in order to avoid the phenomenon that the first substrate 10 and the second substrate 50 are slightly misaligned during bonding, the distances between the third bonding part 63 and the second circuit layer 12, between the second circuit positive electrode 121 and the second circuit negative electrode 122, between the fourth bonding part 64 and the first bonding layer 60 and the second bonding layer 60 and between the first bonding layer 60 and the second bonding layer 60 can be limited in the present disclosure to reduce the possibility of short circuit. In specific applications, the minimum distance W1 between the third bonding part 63 and the second circuit layer 12 may be greater than 0.2 mm, and the minimum distance W2 between the second circuit positive electrode 121 and the second circuit negative electrode 122 may be greater than 0.2 mm; the minimum distance between the fourth bonding part 64 and the first bonding part 61 may be greater than 0.2 mm; the minimum distance between the fourth bonding part 64 and the second bonding part 62 may be greater than 0.2 mm; the minimum distance between the first bonding part 61 and the second bonding part 62 may be greater than 0.2 mm. On the one hand, in the manufacturing method of the multilayer substrate provided by the present disclosure, the second substrate 50 is added and the heat dissipation layer 51 is arranged on the second substrate 50, instead of arranging the heat dissipation layer 51 on the back surface of the first substrate 10, so that the circuit on the back surface of the first substrate 10 cannot contact with the radiator or the heat dissipation layer 51, thereby avoiding the contact between the circuit and the radiator or the heat dissipation layer, without the need of using an insulating layer in the prior art for preventing the contact between the circuit and the radiator or the heat dissipation layer, thereby avoiding the problem of short circuit or leakage of the positive and negative electrodes caused by the falling of the insulating layer in the prior art. On the other hand, by arranging the interconnected circuits on the front and back surfaces of the first substrate 10, the circuits do not need to pass through the packaging body 20, so that there is no need to set a through notch on the packaging body 20 as in the prior art, thereby avoiding the subsequent problem of difficulty in effectively hermetically packaging the LED device due to the arrangement of the notch. Therefore, the manufacturing method can not only realize the heat dissipation of high-power products, but also meet the requirements for airtight packaging of high-power LED products, reduce the failure risk of LED devices, and improve the safety and reliability of products.

An embodiment of the present disclosure also provides a packaging method of a packaging structure, which includes a manufacturing method of the multilayer substrate, and the manufacturing method of the multilayer substrate is described below.

In some embodiments, after the step of preparing a first substrate and a second substrate, and then bonding the first substrate and the second substrate, the manufacturing method of the multilayer substrate may further include the following steps:

S102: an LED chip is arranged on the front surface of the first substrate, so that the LED chip is connected to the first circuit positive electrode and the first circuit negative electrode; a light-transmitting member is arranged on the packaging body, so that the light-transmitting member, the packaging body and the front surface of the first substrate form a packaging cavity for sealing the LED chip.

Preferably, the way of arranging a LED chip 30 on the front surface of the first substrate 10 may be integrating the LED chip 30 by chip on board (Chip on Board) packaging. In the prior art, LED chips are usually integrated by SMT (Surface Mounted Technology). This integration method needs to be carried out on the basis of PCB first, and LED devices need to be arranged on PCB, which mainly has three problems. First, each LED device often needs solder paste to be soldered to a printed circuit board (PCB), leading to the result that the heat emitted by the chip in the LED device can only be transmitted to the radiator connected to the PCB through the solder paste and the PCB, which makes the heat dissipation path longer, thus affecting the heat dissipation and service life of the product; and in addition, insulating layers are needed to avoid short circuit on the PCB when manufacturing the PCB, which further reduces the thermal conductivity of the product. Second, when setting LED devices by SMT, there should be a certain distance between the devices to avoid the mutual interference between LED devices caused by the error in the process of mounting; and under the influence of the size of LED devices, the size of LED module is further increased, which makes the application of products limited. Thirdly, the large distance between LED devices also reduces the optical power density in unit area. However, the chip can be directly integrated on the substrate by adopting the COB packaging method. Compared with the SMT packaging method in the prior art, the COB packaging method does not need to use solder paste, thus shortening the heat dissipation path of the product and improving the heat dissipation of the product, and also does not need to increase the distance between chips to avoid the chip mounting error, thereby reducing the size of the product, improving the optical power density of the product and improving the use effect.

Preferably, the LED chip 30 can be a flip chip, so as to facilitate the integration by using COB.

In order to make the connection between the LED chip 30 and the first substrate 10 firmer, the LED chip 30 and the substrate can be eutectic again, and the way to realize eutectic can be: passing the connected LED chip 30 and the first substrate 10 through a eutectic furnace. In practical application, at least one temperature zone of the eutectic furnace is between 280°C and 320°C, and nitrogen can be introduced to protect the eutectic process.

In specific applications, the number and connection mode of the LED chips 30 can be adapted according to the actual situation or the power supply of the LED device 200. For example, the number of the LED chips 30 may be 64, and the 64 LED chips 30 are respectively arranged on the front surface of the first substrate 10 in 8 rows and 8 columns, and the LED chips 30 in each row are connected in series. It can be appreciated that in some other embodiments, the series and parallel connection of the LED chips 30 can also be set to 2*2 (2 series and 2 parallel), 3*3, 4*4, 5*5, 6*6, 7*7, 8*8, etc. The present disclosure does not limit the number and connection mode of the LED chips 30 as long as it does not affect the actual use.

In practical application, in the step of installing the light-transmitting member 40 on the packaging body 20, the material of the light-transmitting member 40 can be quartz, sapphire and other materials. In specific applications, the bottom of the light-transmitting member 40 configured to be connected to the packaging body 20 can be provided with a flux material, such as a gold-tin alloy, to facilitate the connection, wherein the content of gold is 80wt%, the content of tin is 20wt%, and the melting point of the gold-tin alloy is 280°C.

According to the embodiment of the present disclosure, the LED chip 30 and the light-transmitting member 40 are arranged on the multilayer substrate 100, and the LED device 200 with the multilayer substrate 100 can be obtained, so that not only the heat dissipation of the high-power LED device is realized, but also the requirements for airtight packaging of the high-power LED product are met, the failure risk of the LED device is reduced, and the safety and reliability of the product are improved. The present disclosure provides a multilayer substrate, a manufacturing method thereof and an LED device. The multilayer substrate 100 includes a first substrate 10, a package 20, an LED chip 30, a light-transmitting member 40 and a second substrate 50. The first substrate 10 has a front surface and a back surface which are opposite to each other. The front surface of the first substrate 10 is provided with a first circuit layer 11, the back surface of the first substrate 10 is provided with a second circuit layer 12, and the first circuit layer 11 is electrically connected with the second circuit layer 12. The first circuit layer 11 includes a first circuit positive electrode 111 and a first circuit negative electrode 112. The packaging body 20 is annular and arranged on the front surface of the first substrate 10, and surrounds the periphery of the first circuit positive electrode 111 and the first circuit negative electrode 112. The light-transmitting member is connected to the packaging body, and the light-transmitting member, the packaging body and the front surface of the first substrate form a packaging cavity. The LED chip is arranged in the packaging cavity and connected to the first circuit positive electrode and the first circuit negative electrode. The front surface of the second substrate 50 is connected to the back surface of the first substrate 10 through a bonding layer 60, and the back surface of the second substrate 50 is provided with a heat dissipation layer 51. On the one hand, in the manufacturing method of the multilayer substrate provided by the present disclosure, the second substrate 50 is added and the heat dissipation layer 51 is arranged on the second substrate 50, instead of arranging the heat dissipation layer 51 on the back surface of the first substrate 10, so that the circuit on the back surface of the first substrate 10 cannot contact with the radiator or the heat dissipation layer 51, thereby avoiding the contact between the circuit and the radiator or the heat dissipation layer, without the need of using an insulating layer in the prior art for preventing the contact between the circuit and the radiator or the heat dissipation layer, thereby avoiding the problem of short circuit or leakage of the positive and negative electrodes caused by the falling of the insulating layer in the prior art. On the other hand, by arranging the interconnected circuits on the front and back surfaces of the first substrate 10, the circuits do not need to pass through the packaging body 20, so that there is no need to set a through notch on the packaging body 20 as in the prior art, thereby avoiding the subsequent problem of difficulty in effectively hermetically packaging the LED device due to the arrangement of the notch. Therefore, the manufacturing method can not only realize the heat dissipation of high-power products, but also meet the requirements for airtight packaging of high-power LED products, reduce the failure risk of LED devices, and improve the safety and reliability of products.

Embodiment 7, including Embodiment 7a, Embodiment 7b and Embodiment 7c, is detailed as follows:

### Embodiment 7a

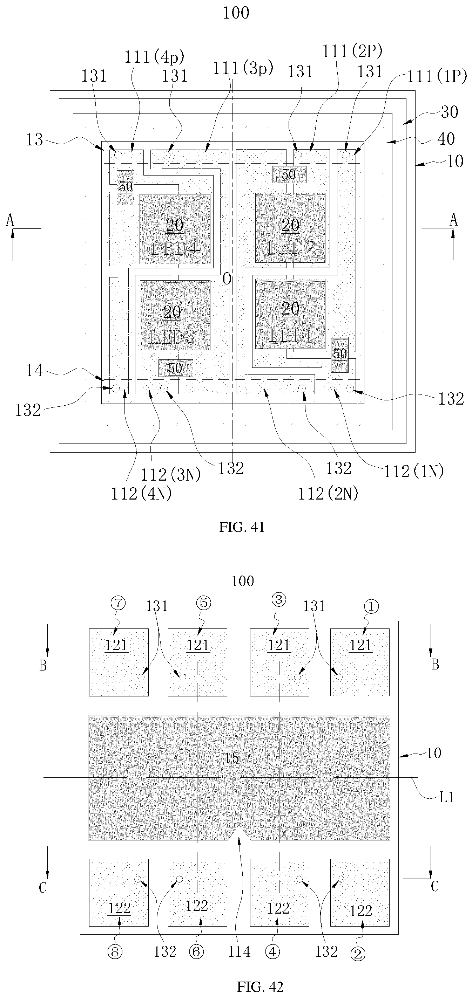

The present disclosure provides an LED device, please refer to FIGS. 40 to 45. The LED device 100 includes a substrate 10 and a plurality of LED chips 20. The substrate 10 has opposite front and back surfaces. The front surface of the substrate 10 is provided with a first circuit layer 11, which includes multiple groups of positive and negative electrode pads (including positive and negative electrode pads 111 and 112), and the back surface of the substrate 10 is provided with a second circuit layer 12, which includes multiple groups of positive terminals and negative terminals (including positive terminals 121 and negative terminals 122). Referring to FIG. 42, the positive terminals 121 and the negative terminals 122 are symmetrically arranged (the symmetry axis is shown as L1 in the figure) on two opposite sides of the back surface of the substrate 10. The positive terminals 121 on the back surface of the substrate 10 are arranged at linear intervals and equidistantly arranged on the same side of the back surface of the substrate 10, and the negative terminals 122 are arranged at linear intervals and equidistantly arranged on the other side of the back surface of the substrate 10 and correspond to the positive terminals 121 one by one. A positive electrode pad 111 is connected with a positive terminal 121 through a positive electrode conductive hole 131 penetrating through the substrate 10; and a negative electrode pad 112 is connected with a negative terminal 122 through a negative electrode conductive hole 132 penetrating through the substrate 10. That is, each positive electrode pad 111 is connected to each positive electrode conductive hole 131 and each positive terminal 121 in one-to-one correspondence. Each negative electrode pad 112 is connected to each negative electrode conductive hole 132 and each negative terminal 122 in one-to-one correspondence. Each LED chip 20 is electrically connected with a group of positive electrode pad 111 and negative electrode pad 121 on the front surface of the substrate 10, and one LED chip 20 is connected with a group of positive electrode pad 111 and negative electrode pad 112. Each LED chip 20 can be independently controlled by the corresponding positive terminal 121 and negative terminal 122, that is, when the positive terminal 121 and negative terminal 122 on the back surface of the substrate 10 are connected with power supply, the operator can independently control the LED chips 20 electrically connected with the group of positive terminal 121 and negative terminal 122, for example, they can be turned on or off independently. According to the present disclosure, a group of positive electrode pad 111 and negative electrode pad 112 on the front surface of the substrate 10 is connected with one LED chip 20, and because the control of each LED chip 20 is independent, not only can the LED device 100 package LED chips 20 with different voltages and different wavelengths, but also the user can realize the independent control of a single LED chip 20 or a plurality of LED chips 20, so that the user can control any LED chip 20 to emit light effectively according to the use situation.

Moreover, in the prior art, the series-parallel connection mode between a plurality of LED chips has been fixed and cannot be changed, while in the present disclosure, each LED chip 20 can be controlled independently, without a fixed series-parallel connection mode, and the series-parallel connection mode can be changed through a circuit connected with the positive terminal 121 and the negative terminal 122 (refer to the following description), so that the compatibility of the LED device 100 is improved, the management of the LED device 100 is facilitated, the difficulty, time and cost of manufacturing are reduced, and the product has wider application range and stronger applicability.

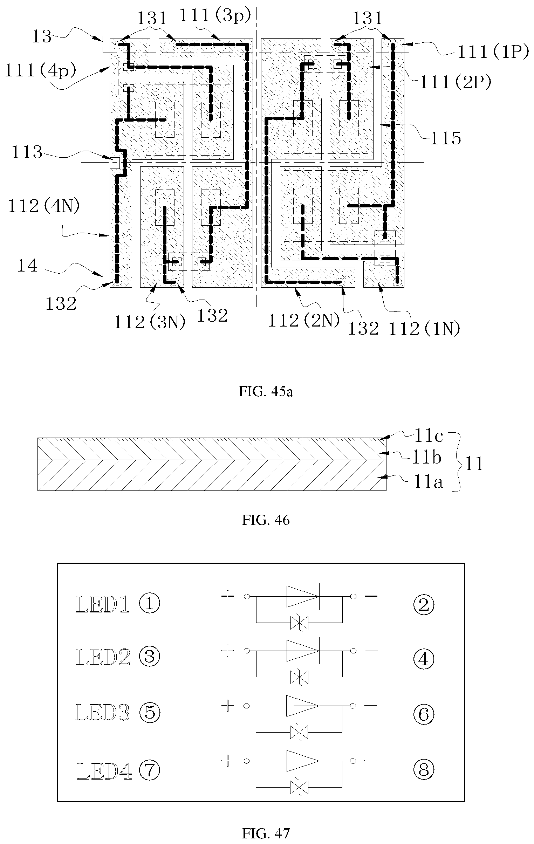

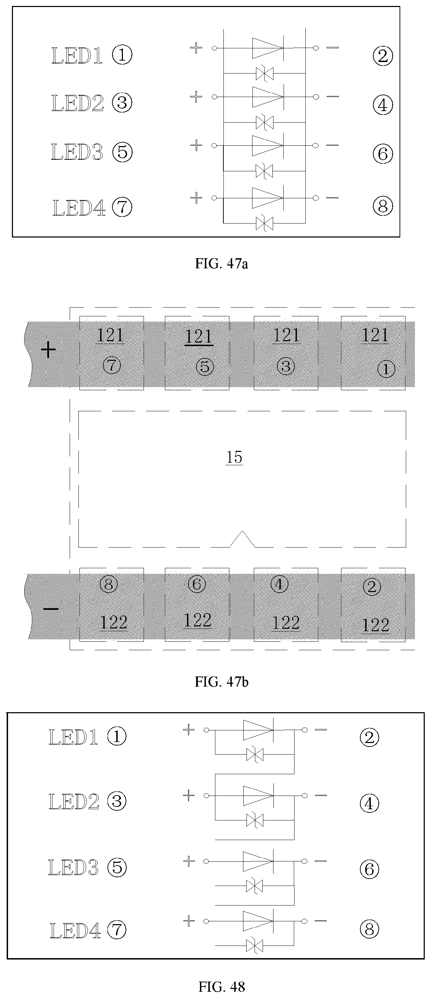

Please refer to FIGS. 47 to 50 in conjunction with FIGS. 40 to 45. FIGS. 40 to 45 show an LED device with four LED chips 20, and FIG. 47 shows the independent electrical connection of the four LED chips 20. The four LED chips 20 are LED1, LED2, LED3 and LED4 respectively, and each LED chip 20 is connected in parallel with a zener chip 50 with a flip-chip structure (described in detail below). Because the positive electrode pad 111 on the front side of each substrate 10 is connected with the positive terminal 121 on the back side of the substrate 10 through the positive electrode conductive hole 131, the negative electrode pad 112 on the front of each substrate 10 is connected to the negative terminal 122 on the back surface of the substrate 10 through the negative electrode conductive hole 132, and each LED chip 20 has a corresponding group of positive terminal 121 and negative terminal 122 connected to it on the back surface of the substrate 10, there are four positive terminals 121 and four negative terminals 122. For the convenience of explanation, the positive terminal 121 can be numbered ①③⑤⑦, the negative terminal 122 can be numbered ②④⑥⑧, the two poles of LED1 are respectively electrically connected to ①②, the two poles of LED2 are respectively electrically connected to ③④, two poles of LED3 are respectively electrically connected to ⑤ ⑥, and two poles of LED4 are respectively electrically connected to ⑦⑧. Each LED can be independently controlled by a corresponding group of positive terminal 121 and negative terminal 122, for example, LED1 can be controlled by positive electrode pad ① and negative electrode pad ②; the LED2 can be controlled by the positive electrode pad ③ and the negative electrode pad ④, and so on.

Among them, the series connection of the LED chips 20 can be realized by the printed circuit of the PCB, and there is no series-parallel relationship between the LED chips 20 of the LED device 100 in this embodiment. When the LED device 100 is used in cooperation with the PCB, a matching circuit (called external circuit for convenience of explanation) is designed on the PCB according to the needs of circuit design to form the required series-parallel relationship between the LED chips.

Referring to FIG. 47a, FIG. 47b and FIG. 40 to FIG. 45, FIG. 47a shows a schematic diagram in which each LED chip 20 is connected in parallel with each other, and a peripheral circuit (shown by gray blocks in FIGS. 47a and 47b) electrically connects the positive electrode pad ①③⑤⑦ and the negative electrode pad ②④⑥⑧, thereby realizing the parallel connection of each LED chip 20.

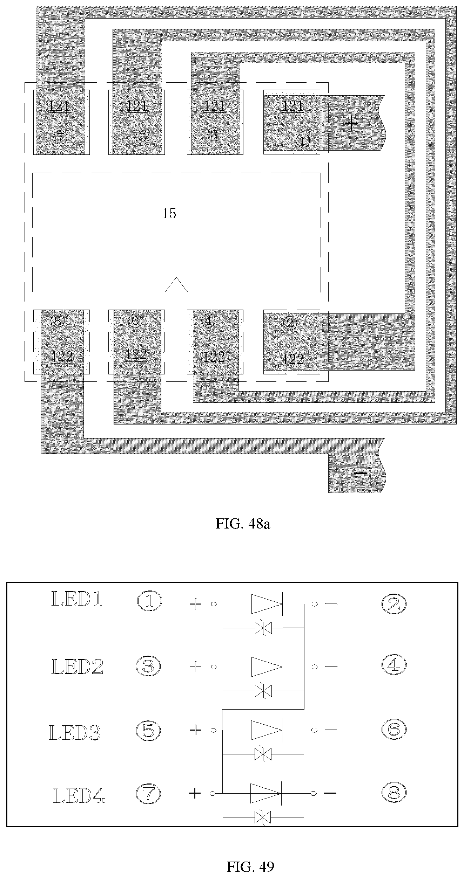

Referring to FIG. 48, FIG. 48a and FIG. 40 to FIG. 45, FIG. 48 shows a schematic diagram in which each LED chip 20 is connected in series in turn, and a peripheral circuit (shown by a gray block in FIGS. 48 and 48a) electrically connects the positive electrode pad ③ and the negative electrode pad ②; electrically connects the positive electrode pad ④ and the negative electrode pad ⑤; electrically connects the positive electrode pad ⑥ and the negative electrode pad ⑦ to realize the series connection of each LED chip 20.

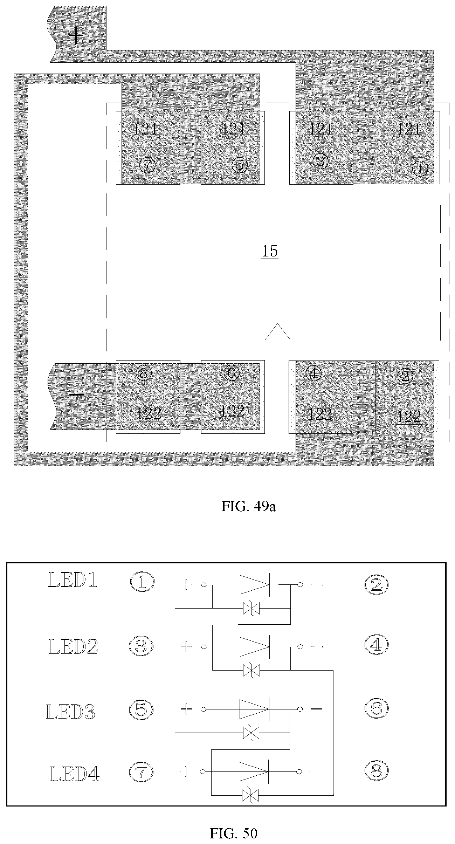

Referring to FIGS. 49 and 49a again, a peripheral circuit (the peripheral circuit is indicated by a gray block in FIGS. 49 and 49a) electrically connects the positive electrode pads ① and ③; electrically connects the positive electrode pads ⑤ and ⑦; electrically connects the negative electrode pads ② and ④; electrically connects the negative electrode pads ⑥ and ⑧; then, electrically connects the negative electrode pad ④ and the positive electrode pad ⑤ to realize a series-parallel relationship of each LED chip 20.

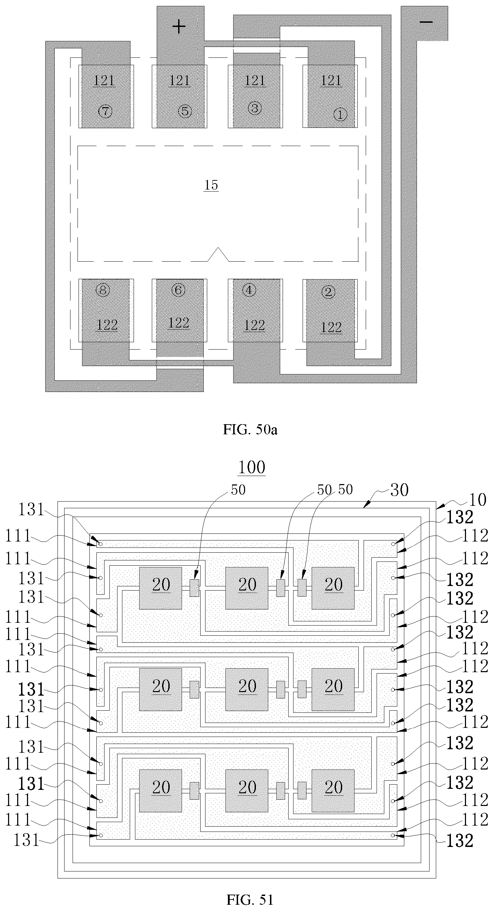

Referring to FIGS. 50 and 50a again, a peripheral circuit (the peripheral circuit is indicated by a gray block in FIGS. 50 and 50a) electrically connects the positive electrode pads ① and ⑤; Connect the negative electrode pads ④ and ⑧ electrically; electrically connects the negative electrode pad ② and the positive electrode pad ③; electrically connects the negative electrode pad ⑥ and the positive electrode pad ⑥ to realize another series-parallel relationship of each LED chip 20.

Similar to the above example, other series-parallel connection relationships can be realized through peripheral circuits on PCB. The LED device 100 provided in this embodiment does not limit the series-parallel relationship between the LED chips 20, but leaves an independent group of positive terminal and negative terminal for each LED chip 20, thus leaving sufficient design space for the design of peripheral circuits, which is adaptable to different peripheral circuits, and has wide compatibility and applicability. Of course, the method for realizing the series-parallel relationship between the LED chips 20 in the present disclosure is not limited to this. For example, a plurality of groups of positive terminals and negative terminals can be connected through a circuit provided with switching diodes, and the user can switch the series-parallel relationship between the LED chips 20 under the condition that the circuit lines are fixed by controlling the switching diodes to control the on-off of the lines.

In this embodiment, there are four LED chips 20 arranged in a rectangular array, which has the advantage of good light uniformity. Each LED chip 20 is a flip-chip LED light emitting chip, which can be a visible light emitting chip (such as a blue LED chip) or an invisible light emitting chip, such as an infrared LED light emitting chip or an ultraviolet LED light emitting chip. In other embodiments, the number of LED chips 20 can also be other numbers of chips, for example, the number of LED chips 20 is n*n, where n is a natural number greater than 2, for example, the number of LED chips 20 can be 3*3, totaling 9, or the number of LED chips 20 can be 4*4, totaling 16, and so on. Each LED chip 20 is arranged in a rectangular array, which has the advantages of compact structure, high integration and good light uniformity.

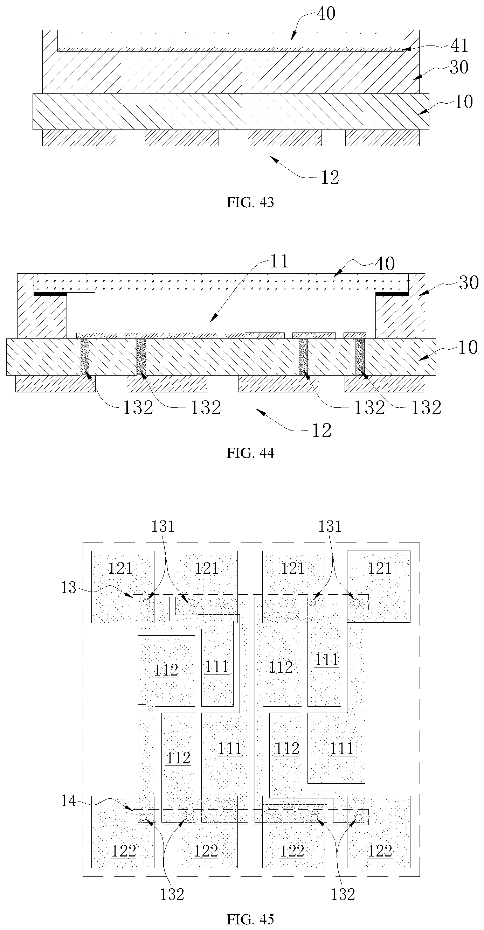

Specifically, the substrate 10 is provided with a positive electrode conductive hole 131 and a negative electrode conductive hole 132 penetrating through the substrate 10. Both the positive electrode conductive hole 131 and the negative electrode conductive hole 132 are filled with conductive materials, so that the positive electrode pad 111 is electrically connected with the positive terminal 121 through the positive electrode conductive hole 131, and the negative electrode pad 112 is electrically connected with the negative terminal 122 through the negative electrode conductive hole 132. This arrangement not only has a good conduction effect, but also is simple to manufacture and low in cost. The positive conductive hole 131 and the negative conductive hole 132 can vertically penetrate the substrate 10 and are symmetrically arranged, which is convenient for processing
Specifically, referring to FIG. 41, FIG. 42, FIG. 45 and FIG. 45a, the positive electrode pads 111 and the negative electrode pads 112 on the front surface of the substrate 10 form a rectangular circuit pattern on the front surface of the substrate 10 (as shown in FIG. 45a), and the LED chips 20 are uniformly distributed on the circuit pattern, so that the rectangular circuit pattern is more suitable for the rectangular LED chips 20 and makes it easier for the LED chips 20 to be uniformly arranged on the circuit pattern. In one embodiment, the geometric center of the rectangle defined by the LED chip array formed by each LED chip 20 (as shown by the center point O in FIG. 41) coincides with the geometric center of the circuit pattern, so that the light-emitting symmetry of the LED device 100 is good. The circuit pattern includes a first marginal area 13 and a second marginal area 14 located on opposite sides of the circuit pattern, and each positive electrode conductive hole 131 is located in the first marginal area 13 on one side of the circuit pattern. Each negative electrode conductive hole 132 is located in the second marginal area 14 on the other side of the circuit pattern. The first marginal area 13 and the second marginal area 14 are located at the edges of the circuit pattern to avoid interference with the mounting position of the LED.

The circuit pattern is provided with gaps 115 separating the positive electrode pads 111 and the negative electrode pads 112 on the front surface of each substrate 10, and each of the gaps 115 is at least greater than 0.2mm to ensure the insulation between the pads; The positive electrode conductive holes 131 are linearly arranged; the negative electrode conductive holes 132 are linearly arranged, and the positive electrode conductive holes 131 and the negative electrode conductive holes 132 are symmetrically arranged in one-to-one correspondence, which is convenient for processing.

Referring to FIG. 41 and FIG. 45a, in order to explain the corresponding relationship between the positive electrode pads 111, the negative electrode pads 112 and the LED chip 20 on the front side of the substrate 10, the plurality of positive electrode pads 111 on the front side of a substrate 10 can be numbered as a first positive electrode pad 1P, a second positive electrode pad 2P, a third positive electrode pad 3P and a fourth positive electrode pad 4P, and so on. If there are n positive electrode pads 111, the n^{th} positive electrode pad 111 is nP; similarly, a plurality of negative electrode pads 112 on the front surfaces of a substrate 10 can be numbered as a first negative electrode pad 1N, a second negative electrode pad 2N, a third negative electrode pad 3N and a fourth negative electrode pad 4N, and so on. If there are n negative electrode pads 112, the n^{th} negative electrode pad is nN; the LED chips 20 can be numbered as LED1, LED2, LED3, LED4 and so on. If there are n LED chips, the n^{th} LED chip is LEDn. Referring to the thick dotted line in FIG. 45a, one end of the n^{th} positive electrode pad 111 on the front surface of the substrate 10 is connected with the positive electrode of the corresponding n^{th} LED chip LEDn, and another end extends to the first marginal area 13 to be connected with a corresponding n^{th} positive electrode conductive hole 131. One end of the n^{th} negative electrode pad 112 on the front surface of the substrate 10 is connected to the negative electrode of the corresponding n^{th} h LED chip 20, and another end extends to the second marginal area 14 and is connected to a corresponding n^{th} negative electrode conductive hole 132. In FIG. 6a, each thick dotted line indicates the hidden (which means virtual here) electrical connection lines of each pad (positive electrode pad 111 and negative electrode pad 112), and then expands outward with each hidden electrical connection line as the main line to form the shape of each pad. The pattern of each pad is very simple without crossing, and each pad is expanded as far as possible to fully contact the electrodes of the LED chip 20 while maintaining the insulation gap, so as to facilitate the heat dissipation of the LED chip 20. In this embodiment, the hidden electrical connection lines of each pad pattern include horizontal and/or vertical connection lines, and there is no diagonal line or curve, so that when each pad expands outward with the electrical connection lines, it also expands in the direction perpendicular to each hidden electrical connection line, so that the shape of each pad is block-shaped and presents a pattern formed by splicing a plurality of rectangles. The outer sides of various pads are aligned, so that the circuit pattern composed of each pad is rectangular. The design of each pad in this embodiment is beneficial to simplify the design and facilitate the production and manufacturing. It should be noted that, in this embodiment, each LED chip 20 is also connected in parallel with a Zener chip 50, so the electrical connection lines implied in each pad are also connected to the electrodes of the Zener chip 50.

Specifically, refer to the circuit pattern shown in FIG. 45a, in this embodiment, the circuit pattern is rotationally symmetric with its geometric center as the symmetry point (that is, the circuit pattern rotates 180° with its pivot point and then coincides with it); the design of the positive electrode pad 111 and the negative electrode pad 112 can be simplified, which is convenient for design and manufacture. Further, in order to easily identify the placement position of the LED device 100 in the production process or in the process of using the LED device 100, a first positioning mark 113 is also provided on the circuit pattern. The first positioning mark 113 may be a rectangular notch formed at the edge of the circuit pattern, and in other examples, the first positioning mark 113 may also be a triangular notch or protrusion formed at the edge of the circuit pattern or other shapes. The first positioning mark 113 can define the negative pole of the LED device 100, or the placement direction. For example, the first positioning mark 113 can be defined as the left side (or the lower side) of the LED device 100. When the LED chips 20 are fixed to the LED device 100, the first positioning marks 113 of the LED device 100 can all be oriented to the left side (or the lower side), so that each LED chip 20 has good consistency in the die bonding operation, thereby ensuring that each LED device 100 is identical. In other examples, the first positioning mark 113 can also identify the negative direction of the LED chips 20, for example, the negative direction of each LED chip 20 can be identified by the first positioning mark 113. It should be noted that the existence of the first positioning mark 113 will make the circuit pattern not a strictly symmetrical pattern with its geometric center as the symmetry point, but the first positioning mark 113 may not be on the circuit pattern. For example, the first positioning mark 113 may also be arranged on the packaging body 30 of the LED device 100. Therefore, the circuit pattern described in this embodiment being rotationally symmetrical with its geometric center as the symmetry point means that the circuit pattern is equivalent to or substantially rotationally symmetric with its geometric center as the symmetry point. without considering or ignoring the first positioning mark 113. Referring to FIG. 42, the back of the LED device 100 may also be provided with a second positioning mark 114. In this embodiment, the second positioning mark 114 is provided on the heat dissipation layer 15. The second positioning mark 114 is mainly used to identify the negative terminal 122, that is, the electrode terminal near the second positioning mark 114 is the negative terminal 122. Since the heat dissipation layer 15 is mainly used for heat dissipation, the circuit function of the LED device 100 will not be affected if the second positioning mark 114 is arranged on the heat dissipation layer 15.

Referring to FIG. 45, the positive terminal 121 on the back surface of each substrate 10 is at least partially located on the back surface corresponding to the first marginal area 13, and the negative terminal 122 on the back surface of each substrate 10 is at least partially located on the back surface corresponding to the second marginal area 14. The projection of the positive electrode pad 111 on the front of each substrate 140 on the back surface of the substrate 10 at least partially overlaps with the corresponding positive terminal 121 on the back surface of the substrate 10. The projection of the negative electrode pads 112 on the front surface of each substrate 10 on the back surface of the substrate 10 at least partially overlaps with the corresponding negative terminals 122 on the back surface of the substrate 10, and each positive electrode conductive hole 131 and negative electrode conductive hole 132 are located in each overlapping area. Therefore, it is convenient for the positive electrode pad 111 to be electrically connected with the positive terminal 121 through the corresponding positive electrode conductive hole 131, and the negative electrode pad 112 to be electrically connected with the negative terminal 122 through the corresponding negative electrode conductive hole 132.

Furthermore, a heat dissipation layer 15 is arranged in the middle area of the back surface of the substrate 10, a plurality of positive terminals 121 are arranged at one side of the heat dissipation layer 15 at linear intervals, and a plurality of negative terminals 122 are arranged at another side of the heat dissipation layer 15 at linear intervals. This arrangement can improve the heat dissipation performance of the LED device 100 and make the positive terminal 121 and the negative terminal 122 located in the edge area of the back surface of the substrate 10, so as to avoid affecting the connection of the positive terminal 121 and the negative terminal 122 with peripheral circuits.

In practical application, the LED chip 20 can be a UV-LED chip, the LED device 100 can be a product with the size of 6060/6565/6868/7070, and the length of the LED chip 20 can be less than or equal to 52mil. It can be appreciated that the above embodiments are only used for illustration, and the present disclosure does not limit the specific types of LED chips 20 and the size of the LED device 100. Of course, in this embodiment, each LED chip 20 can be independently controlled, therefore the number of LED chips 20 is not limited in the present disclosure, for example, the number of LED chips 20 can be one, two, three or four, as long as it can be adapted to the size of the LED device 100 and the actual application solution.

As for the substrate 10, the substrate 10 can be made of ceramic materials, such as aluminum nitride ceramics (AlN), gallium nitride ceramics (GaN), alumina ceramics (Al₂O₃), silicon carbide ceramics (SiC), etc. Ceramic materials have good insulation and heat dissipation, and the first circuit layer 11 and the second circuit layer 12 can be made on the surface of the substrate 10 by a DPC (Direct Plating copper) process. The DPC process only needs a temperature of about 250-350°C to complete the fabrication of the substrate 10, which avoids the adverse effects of high temperature on materials or circuit structures and reduces the manufacturing process cost. Of course, the present disclosure does not limit the specific material of the substrate 10 as long as it does not affect the use of the LED device 100.

Preferably, as shown in FIG. 46, the first circuit layer 11 includes a first copper metal layer 11a, a first nickel metal layer 11b and a first gold metal layer 11c which are stacked. The thickness of the first nickel metal layer 11b is greater than 3 microns, and the thickness of the first gold metal layer 11c is greater than 0.05 microns. The first nickel metal layer 11b and the first gold metal layer 11c can improve the corrosion resistance, wear resistance and oxidation resistance of the first circuit layer 11, reduce the damage of external environment such as acid, alkali and humidity to the first circuit layer 11, and prolong the service life of the first circuit layer 11.

Preferably, the second circuit layer 12 includes a first copper metal layer, a first nickel metal layer and a first gold metal layer which are stacked. The thickness of the first nickel metal layer is greater than 3 microns, and the thickness of the first gold metal layer is greater than 0.05 microns. The first nickel metal layer and the first gold metal layer can improve the corrosion resistance, wear resistance and oxidation resistance of the second circuit layer 12, reduce the damage of external environment such as acid, alkali and humidity to the second circuit layer 12, and prolong the service life of the second circuit layer 12.

In this embodiment, it is preferred that the LED chip 20 is a flip chip (but in other embodiments, either a wire bonding chip or a vertical chip can be used). Solder can be arranged on the first circuit layer 11 on the front surface of the substrate 10, and then the LED chip 20 can be arranged on the solder to realize the connection between the LED chip 20 and the substrate 10. The electrode of the LED chip 20 is made of gold-tin alloy. The content of gold and tin in the gold-tin alloy is 80wt% and 20wt%, and the melting point of the gold-tin alloy is 280°C, so that the LED chip 20 can be conveniently fixed to the first circuit layer 11.

In some embodiments, please refer to FIG. 40 and FIG. 41 with FIG. 43 and FIG. 44, the LED device 100 includes a packaging body 30 and a light-transmitting member 40. The packaging body 30 is annular and arranged on the front surface of the substrate 10, and surrounds the positive electrode pads 111 and negative electrode pads 112 of each LED chip 20 and the front surfaces of each group of substrates 10. There is a space between the packaging body 30 and the circuit pattern formed by the positive electrode pad 111 and the negative electrode pad 112 to avoid possible short circuit. The light-transmitting member 40 is connected to the packaging body 30; the light-transmitting member 40, the packaging body 30 and the front surface of the substrate 10 form a packaging cavity for accommodating the first circuit layer 11.

Specifically, the packaging body 30 is provided with an assembly groove 31 which is formed in the inner side wall of the packaging body 30 and penetrates through the top of the packaging body 30, and the bottom surface of the light-transmitting member 40 is bonded in the assembly groove 31 by a flux material.

In an embodiment, the packaging body 30 is made of metal, and the light-transmitting member 40 is made of glass. The contact part of the light-transmitting member 40 with the packaging body 30 is formed into a gold-tin alloy through a glass gold plating process and then bonded with the packaging body 30. In the prior art, semi-inorganic packaging is usually used for the light-transmitting member and the packaging body, which means that silicone material is used in combination with inorganic materials such as glass, and the combination of the light-transmitting member 40 and the packaging body 30 is realized by bonding. However, due to the destructive effect of UV light and other light rays on organic materials, the glue is likely to fail after long-term use, which will lead to problems such as air holes between the light-transmitting member 40 and the packaging body 30 or the light-transmitting member 40 falling off, thus affecting the air tightness and service life of the product. In the present disclosure, the light-transmitting member 40 and the packaging body 30 are packaged in a fully-inorganic packaging mode. Because no organic matter which is easily influenced by light such as UV light is used, so that the risk of air holes or the light-transmitting member 40 falling off is reduced, the air tightness of the product is improved, the service life is longer, and the bonding mode is adopted, and the firmness is higher than that of the glue bonding mode.

Preferably, the content of gold and tin in the gold-tin alloy is 80wt% and 20wt%, and the melting point of the gold-tin alloy is 280°C. Metal bonding can further improve the connection firmness.

Preferably, the assembly groove 31 can be a step groove to facilitate the assembly of the light-transmitting member 40, and the light-transmitting member 40 does not easily shake and fall off. The assembly groove 31 may be single-layer stepped or multilayer stepped. For example, when the packaging body 30 is single-layer stepped (as shown in FIGS. 40 and 43), the bottom surface of the light-transmitting member 40 is provided on the groove bottom surface of the assembly groove 31 through the bonding material 41. For another example, when the packaging body 30 has a double-layered step (not shown), the light-transmitting member 40 can be directly arranged on the lower step, and the side and/or bottom surface of the light-transmitting member 40 are bonded with the wall surface of the higher step to fix the light-transmitting member 40 on the packaging body 30. Of course, although the assembly groove 31 on the packaging body 30 in this embodiment is stepped, the specific shape of the assembly groove 31 on the packaging body 30 is not limited by the present disclosure. In other embodiments, the assembly groove 31 may not be needed, the top of the packaging body 30 may be flat, and the bottom surface of the light-transmitting member 40 may be directly bonded to the top surface of the packaging body 30. The present disclosure does not restrict the cross-sectional shape of the packaging body 30, for example, the cross-sectional shape of the packaging body 30 may be hollow, round, square, diamond, etc., as long as the light-transmitting member 40 can be arranged in the packaging body 30 and does not affect the use of the LED device 100.

Preferably, a third copper metal layer, a third nickel metal layer and a third gold metal layer are stacked on the surface of the packaging body 30, with the thickness of the third nickel metal layer being greater than 3 microns and the thickness of the third gold metal layer being greater than 0.05 microns. The third nickel metal layer and the third gold metal layer can improve the corrosion resistance, wear resistance and oxidation resistance of the packaging body 30, reduce the damage of external environment such as acid, alkali and humidity to the packaging body 30, and prolong the service life of the packaging body 30.

For the light-transmitting member 40, the material of the light-transmitting member 40 can be quartz, sapphire or other materials. In specific applications, the light-transmitting member 40 can be in the shape of a plate, an arch or a hemisphere, as long as the use of the LED device 100 is not affected, and the specific shape of the light-transmitting member 40 is not limited by the present disclosure.

In this embodiment, the LED device 100 includes a plurality of zener chips 50, and each zener chip 50 is connected with a group of positive electrode pad 111 and negative electrode pad 112, that is, one LED chip 20 is connected in parallel with one zener chip 50. The zener chip 50 is used to reduce the probability of electrostatic breakdown of the LED chip 20 to protect the LED chip 20. Preferably, the Zener chip 50 is a flip chip, and the electrode of the Zener chip 50 is a gold-tin alloy, wherein the content of gold in the gold-tin alloy is 80wt%, the content of tin is 20wt%, and the melting point of the gold-tin alloy is 280°C, so as to facilitate the fixing of the Zener chip 50 to the first circuit layer 11.

In the actual production process, the first circuit layer 11 of the substrate 10 can be provided with flux or AuSn solder (in which the content of gold can be 80wt%, the content of tin can be 20wt%, and the melting point is 280°C), and then the LED chip 20 and the Zener chip 50 can be placed at the flux or AuSn solder, so that the LED chip 20 and the Zener chip 50 can be bonded and fixed to the first circuit layer 11. Secondly, flux or AuSn solder (in which the content of gold can be 80wt%, the content of tin can be 20wt%, and the melting point is 280°C) is arranged in the assembly groove 31, so that the light-transmitting member 40 is bonded and fixed to the packaging body 30. Finally, the semi-finished products which have been subjected to the above steps are fixed by a eutectic process, in which the semi-finished products pass through a eutectic furnace, wherein at least one temperature zone of the eutectic furnace is between 280°C and 320°C, and nitrogen protection is needed in the eutectic process to further improve the firmness.

### Embodiment 7b

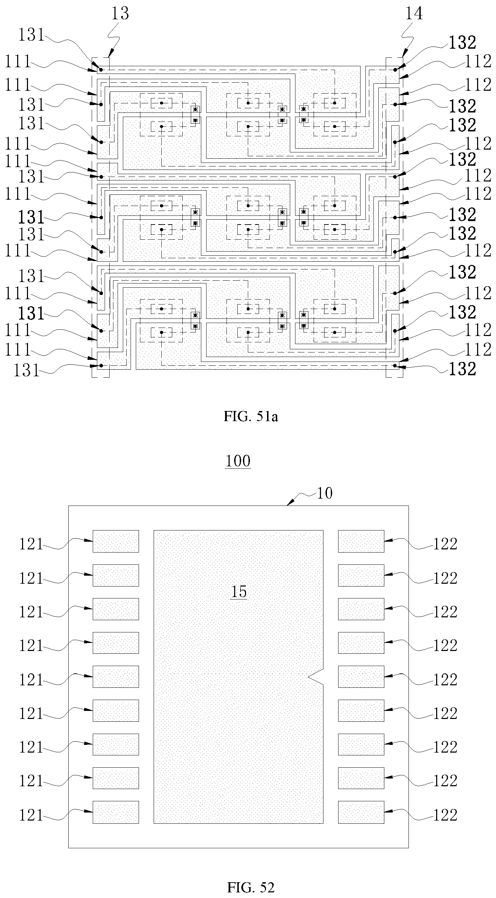

Please refer to FIG. 51 and FIG. 51a, the difference between this embodiment and embodiment 7a is that the number of LED chips 20 in this embodiment is 9, which is distributed in a 3*3 matrix. The angle at which the LED device 100 shown in FIGS. 51 and 51a is placed corresponds to that rotating by 90° counterclockwise shown in FIGS. 41 and 42 in the first embodiment. Therefore, the positive electrode conductive hole 131 and the negative electrode conductive hole 132 in FIGS. 51 and 51a are located on the left and right sides. In FIG. 52, the positive terminal 121 and the negative terminal 122 on the back surface of the substrate 10 are located on the left and right sides. Since the number of LED chips 20 is nine, there are also nine corresponding positive electrode pads 111 and negative electrode pads 112 on the front surface of the substrate 10. There are also nine positive terminals 121 and nine negative terminals 122 on the back surface of the substrate 10. There are also nine positive electrode conductive holes 131 and nine negative electrode conductive holes 132.

The circuit pattern composed of the positive electrode pad 111 and the negative electrode pad 112 is rotationally symmetric with its geometric center as the symmetry point. One end of the n^{th} positive electrode pad 111 is connected with the positive electrode of the corresponding n^{th} LED chip 20, and another end extends to the first marginal area 13 and is connected with a corresponding n^{th} positive electrode conductive hole 131. One end of the n^{th} negative electrode pad 112 is connected with the negative electrode of the corresponding n^{th} LED chip 20, and another end extends to the second marginal area 14 and is connected with a corresponding n^{th} negative electrode conductive hole 132, where n is a natural number greater than 1 and less than 9.

Other structures are the same as those of the embodiment, and the details of this embodiment are not repeated here.

### Embodiment 7c

Please refer to FIG. 14 and FIG. 15, the difference between the LED device 100 provided in this embodiment and the second embodiment is that the number of LED chips 20 in this embodiment is 16, which are distributed in a 4*4 matrix. Since the number of LED chips 20 is 16, there are also 16 corresponding positive electrode pads 111 and negative electrode pads on the front surface of the substrate 10. There are also 16 positive terminals 121 and negative terminals 122 on the back surface of the substrate 10 respectively. There are 16 positive electrode conductive holes 131 and 16 negative electrode conductive holes 132, respectively.

The circuit pattern composed of the positive electrode pad 111 and the negative electrode pad 112 is rotationally symmetric with its geometric center as the symmetry point. One end of the n^{th} h positive electrode pad 111 is connected with the positive electrode of the corresponding n^{th} h LED chip 20, and another end extends to the first marginal area 13 and is connected with a corresponding n^{th} positive electrode conductive hole 131. One end of the n^{th} negative electrode pad 122 is connected with the negative electrode of the corresponding n^{th} LED chip 20, and another end extends to the second marginal area 14 and is connected with a corresponding n^{th} negative electrode conductive hole 132, where n is a natural number greater than 1 and less than 16.

Other structures are the same as those in Embodiment 7a, and the details of this embodiment are not repeated here.

The present disclosure provides an LED device, which includes a substrate 10 and a plurality of LED chips 20. The substrate 10 has opposite front and back surfaces. The front surface of the substrate 10 is provided with a first circuit layer 11, which includes a plurality of groups of positive and negative electrode pads (positive electrode pad 111 and negative electrode pad group 112), and the back surface of the substrate 10 is provided with a second circuit layer 12, which includes a plurality of groups of positive and negative electrode pads (second positive terminals 121 and second negative terminals 122). A positive terminal 121 is arranged corresponding to a positive terminal 121, and a positive terminal 121 is electrically connected with a positive electrode pad 111. A negative terminal 122 is arranged corresponding to a negative electrode pad 112, and a negative terminal 122 is electrically connected with a negative electrode pad 112. At least one LED chip 20 is connected with a group of positive electrode pad 111 and negative electrode pad 112. The LED chip (s) 20 connected to a group of first positive electrode pad 111 and negative electrode pad 112 can be individually controlled to be turned on or off. According to the present disclosure, at least one LED chip 20 is connected with a group of positive electrode pads 111 and negative electrode pad 112, which not only enable the LED device 100 to package LED chips with different voltages and different wavelengths, but also enable a user to independently control a single LED chip or a plurality of LED chip groups by matching different external circuits, so that the user can control individual LED chips to emit light effectively according to usage conditions. In addition, in the prior art, a plurality of LED chips are usually connected by fixed lines, and the lines on the substrate are different when the LED chips are connected in series and parallel. However, in the present disclosure, the lines on the front surface of the substrate 10 are still the same when the LED chips 20 are connected in series and parallel, and different series and parallel relationships among the LED chips 20 can be realized by adapting different peripheral circuits, thereby improving the compatibility of LED devices, facilitating the management of the substrate structure model of LED devices, and reducing the difficulty, time and cost of manufacturing, so as to make the application scope of products.

Embodiment 8 includes Embodiment 8a and Embodiment 8b.

### Embodiment 8a

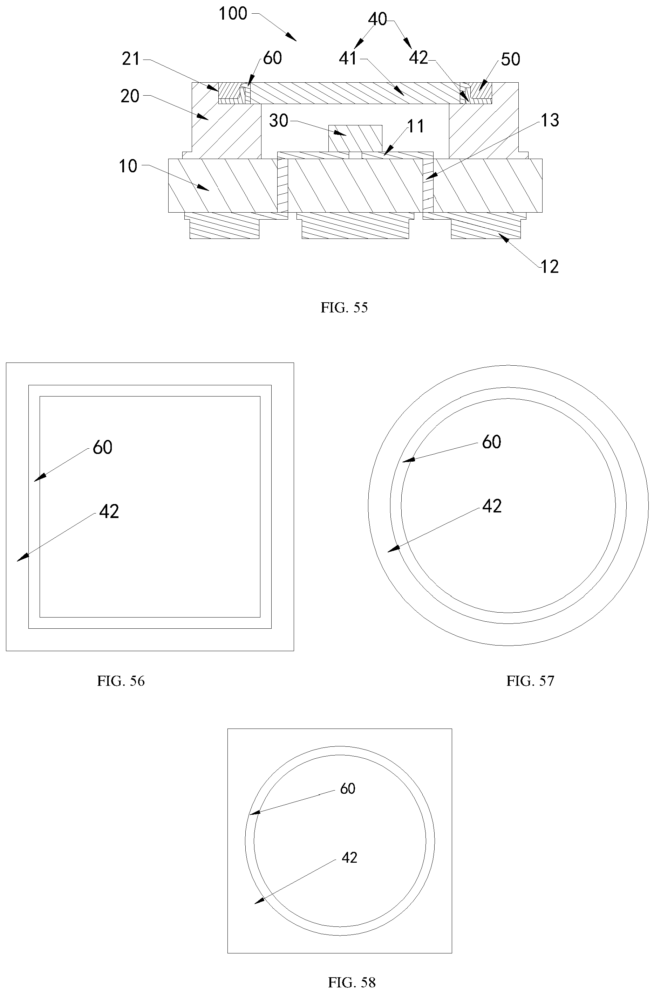

The present disclosure provides an LED device (in this embodiment, the LED devices are all in a packaging structure, specifically an LED packaging structure). Please refer to FIG. 55, the LED device 100 includes a substrate 10, a dam 20, an LED chip 30, a light window assembly 40 and a sealant 50. The dam 20 is annular and has an inner side wall, a top and a bottom, and the bottom of the dam 20 is seated on the front of the substrate 10. The LED chip 30 is fixed on the front surface of the substrate 10. The dam 20 surrounds the periphery of the LED chip 30, and at least a part of the inner side wall of the dam 20 above the LED chip 30 is provided with an assembly groove 21 penetrating the top of the dam 20. The light window assembly 40 includes a light-transmitting member 41 (in this embodiment, the light-transmitting members 41 are all transparent covers) and a metal cap 42, which is bonded to the periphery of the light-transmitting member 41. The light-transmitting member 41 and the metal cap 42 are fixed in the assembly groove 21, and the bottoms of the light-transmitting member 41 and the metal cap 42 are both abutted against the groove bottom surface of the assembly groove 21. The light-transmitting member 41, the metal cap 42, the front surface of the substrate 10 and the dam 20 define an accommodating cavity for accommodating the LED chip 30, and the surfaces of the light-transmitting member 41, the metal cap 42 and the wall surface of the assembly groove 21 define a sealant groove. The sealant 50 is disposed in the sealant groove and does not cover the light-transmitting member 41. The present disclosure not only reduces the possibility that the light window assembly 40 falls off by bonding the light window assembly 40 to the dam 20, and improves the reliability of the product, but also realizes the protection of the bonding place by supplementing the sealant 50, and reduces the possibility of oxidation and rust at the bonding place. Moreover, as the sealant 50 fills the air hole cracks at the bonding place, this arrangement can further improve the reliability and air tightness of the product. Compared with the single semi-inorganic packaging and fully-inorganic packaging in the prior art, the present disclosure fully integrates the advantages of the two packaging modes by combining organic packaging and inorganic packaging,
and by flushing the bottom of the light window assembly 40 in the dam 20, the operator can match the dam 20 to LED chips 30 with different thicknesses by changing the height of the dam 20 in the production process. Compared with the method in the prior art that the metal cap is provided with an inwardly extending edge to block light, the present disclosure does not need to provide an inwardly extending edge, so that the common cost and difficulty of product parts can be effectively reduced while ensuring the light output rate of the product, thereby improving the universality of the metal cap 42 and reducing the production cost.

For the substrate 10, please refer to FIG. 55. In some embodiments, the front surface of the substrate 10 is provided with a first circuit 11 configured to be connected to the LED chip 30. Preferably, the back surface of the substrate 10 can be provided with a second circuit 12, and the substrate 10 is provided with a conductive hole 13 penetrating through the front surface and the back surface, and the first circuit 11 and the second circuit 12 can be connected through the conductive hole 13, thereby realizing the connection between the LED chip 30, the first circuit 11 and the second circuit 12. In practical application, the first circuit 11 and the second circuit 12 can be arranged on the substrate 10 by a DPC (Direct Plating copper) process.

Preferably, the first circuit 11 and the second circuit 12 can be provided with a first metal layer and a second metal layer, the first metal layer can be a nickel layer and the second metal layer can be a gold layer, so that the oxidation resistance, corrosion resistance and conductivity of the lines can be improved, wherein the thickness of the first metal layer can be greater than 3µm, and the thickness of the second metal layer can be greater than 0.05µm, so as to ensure the conductivity and oxidation resistance effects.

For the dam 20, it is preferable that the dam 20 can be bonded to the substrate 10 or integrally formed with the substrate 10, which is very convenient to manufacture. It can be appreciated that the assembly groove 21 not only enables the light window assembly 40 to be embedded in the dam 20, so as to improve the positioning effect of the light window assembly 40, but also facilitates the light window assembly 40 and the dam 20 to define a sealant groove with sealant 50 to improve the air tightness effect of the LED device 100. The assembly groove 21 can be stepped, and its contact surface with sealant 50 is relatively large, which is a preferred embodiment for packaging the LED device 100. In other embodiments, the top of the dam 20 can also be in the shape of a plane, a single-layer step or a multilayer step (when the assembly groove 21 has a multilayer step structure, the sealant 50 can be replenished several times to further improve the air tightness), and the present disclosure is not limited to this, as long as the light window assembly 40 can be installed on the dam 20.

As for the LED chip 30, the LED chip 30 may be any one of a flip chip, a wire bonding chip or a vertical chip, which is not limited in the present disclosure. When the LED chip 30 is flip-chip, the LED chip 30 can be mounted by first arranging a soldering flux on the front surface of the substrate 10, then arranging the LED chip 30 on the soldering flux, and finally making the LED chip 30 eutectic with the substrate 10. When the LED chip 30 is a wire bonding chip or a vertical chip, a die bonding adhesive can be arranged on the front surface of the substrate 10, then the LED chip 30 is arranged on the die bonding adhesive, and the die bonding adhesive is cured by high-temperature baking. Finally, the electrodes of the LED chip 30 are connected with the circuit of the substrate 10 by wire bonding equipment, so that the LED chip 30 can be mounted.

For the metal cap 42, please refer to FIGS. 55 to 60. Preferably, the metal cap 42 can be bonded to the dam 20 to improve the connection firmness and enhance the reliability of the LED device 100.

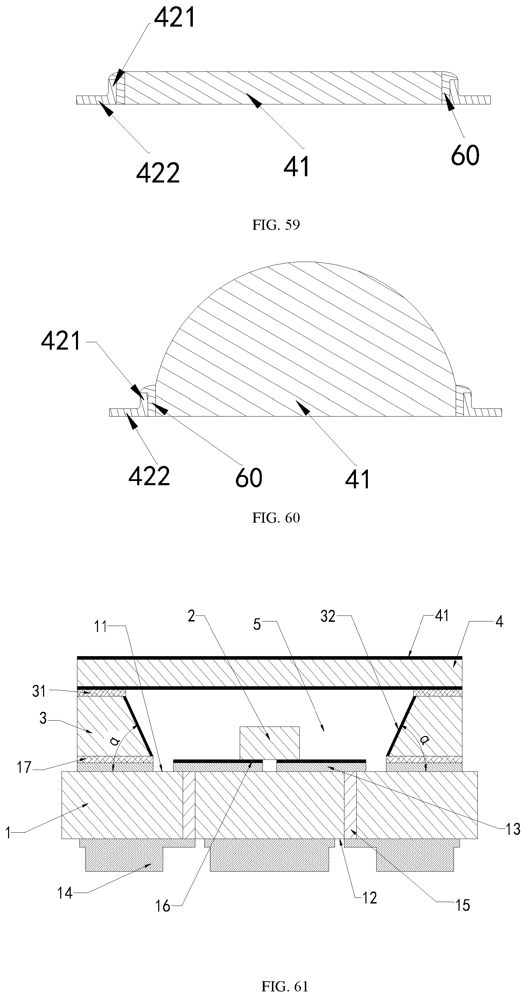

In some embodiments, please refer to FIG. 55 and FIG. 59. The metal cap 42 includes a housing part 421, which is in the shape of a tube and is used for bonding on the periphery of the light-transmitting member 41 (transparent cover). Compared with the way that the metal cap 42 extends inward to connect with the light-transmitting member 41 in the prior art, the embodiment of the present disclosure can reduce the shielding and reflection of LED light, so that the LED device 100 has better light emission rate, and the bonding area between the metal cap 42 and the light-transmitting member 41 is increased, thereby making the bonding between the metal cap 42 and the light-transmitting member 41 firmer
Preferably, the inner side wall of the housing part 421 can be square (see FIG. 2), circular (see FIGS. 3 and 4), etc. The present disclosure is not limited to this, as long as it can be adapted to the light-transmitting member 41 in practical application. Similarly, the outer side wall of the housing part 421 can also be circular (refer to FIG. 3), square (refer to FIGS. 2 and 4), and the present disclosure does not limit this, as long as it does not affect the use of the LED device 100.

In some embodiments, please refer to FIG. 55 and FIG. 59. The bottom of the metal cap 42 (that is, the bottom of the housing part 421) extends away from the light-transmitting member 41 to form a bonding part 422. The metal cap 42 is bonded to the groove bottom of the assembly groove 21 through the bonding part 422, so that the connection between the light window assembly 40 and the dam 20 is firmer. Compared with the way that the metal cap 42 extends inward to connect with the dam 20 in the prior art, the embodiment of the present disclosure can not only reduce the shielding and reflection of the LED light, so that the LED device 100 has a better light output rate, but also shield the sealant 50 in the sealant groove, reduce the influence of the LED light on the sealant 50, prolong the time for realizing the air tightness effect and prolong the service life of the LED device 100.

In some embodiments, please refer to FIG. 55 to FIG. 60. The light-transmitting member 41 (transparent cover) and the metal cap 42 can be bonded by glass solder 60, so that the connection firmness between the light-transmitting member 41 and the metal cap 42 can be increased. Of course, the present disclosure does not limit the bonding material, as long as the bonding between the light-transmitting member 41 and the metal cap 42 can be realized. Further, the height of the glass solder 60 is greater than that of the metal cap 42, and covers the surface of the metal cap 42 away from the substrate 10, so that the bonding area can be increased to further increase the connection firmness between the light-transmitting member 41 and the metal cap 42, and the smoothness of transition between the metal cap 42 and the light-transmitting member 41 can be improved, which is convenient for users to use.

Preferably, the bonding part 422 abuts against the groove side wall of the assembly groove 21, and the glass solder 60, the metal cap 42 and the groove side wall of the assembly groove 21 form the sealant groove, so that the sealant 50 can completely cover the bonding part 422 and improve the air tightness effect of the LED device 100. Furthermore, the sealant 50 can also cover the glass solder 60 and the metal cap 42, so as to better cover the bonding point between the metal cap 42 and the light-transmitting member 41, and the bonding point between the metal cap 42 and the dam 20, so as to protect the bonding point and reduce the possibility of oxidation and rust at the bonding point. Moreover, the sealant 50 can fill the air hole cracks at the bonding point, so that the reliability and air tightness of the product can be further improved.

Preferably, the metal cap 42 can be made of kovar alloy, and kovar alloy can complete the close mechanical connection between the two materials within a certain temperature range, so that the light-transmitting member 41 can be well connected with the dam 20.

For the light-transmitting member 41 (transparent cover), please refer to FIG. 55, FIG. 59 and FIG. 60. In some embodiments, the height of the light-transmitting member 41 is greater than the height of the metal cap 42, so that the glass solder 60 can better cover the surface of the metal cap 42, improve the surface smoothness of the bonding point between the light-transmitting member 41 and the metal cap 42, and enhance the user's experience. Moreover, the sealant 50 does not cover the front surface of the light-transmitting member 41, so as to avoid affecting the light efficiency.

In some embodiments, the light-transmitting member 41 (transparent cover) can be made of quartz or sapphire, but the specific material of the light-transmitting member 41 is not limited in the present disclosure, as long as it can achieve light transmission. For example, the light-transmitting member 41 can be made of PMMA (polymethylmethacrylate). In the present disclosure, the light-transmitting member 41 can be square (please refer to FIG. 59) or hemispherical (please refer to FIG. 60). Of course, the shape of the light-transmitting member 41 is not limited to this, as long as the light transmission is not affected, for example, it can also be rectangular or bulb-shaped.

As for the sealant 50, it can be appreciated that the sealant 50 refers to a curable coating with an adhesive function. When the LED chip 30 is a UV-LED chip, the sealant 50 can be UV-resistant glue, and the UV-resistant glue can usually be glue made of materials such as silica gel, epoxy resin and fluororesin. Of course, the present disclosure does not limit the specific material of the sealant 50, as long as the service life of the sealant 50 can meet the service life of the device.

### Embodiment 8b:

Please refer to FIG. 55 to FIG. 57 together, the present disclosure provides an LED packaging method for packaging the above LED devices 100 (in this embodiment, the LED devices 100 are all in a packaging structure, specifically an LED packaging structure). The LED packaging method includes the following steps:
S101: a substrate 10 is prepared;
S102: a dam 20 with an assembly groove 21 is arranged on the substrate 10, the dam 20 is seated on the front surface of the substrate 10, the dam 20 is annular, and a space for installing the LED chip 30 is formed in the middle part thereof;
S103: the LED chip 30 is arranged on the front surface of the substrate 10 and located in the space in the middle of the dam 20;
S104: the metal cap 42 is bonded to the periphery of the light-transmitting member 41 (transparent cover);
S105: the metal cap 42 and the light-transmitting member 41 are fixed in the assembly groove 21, and the bottoms of the metal cap 42 and the light-transmitting member 41 abut against the groove bottom surface of the assembly groove 21, so that the surfaces of the metal cap 42 and the light-transmitting member 41 and the wall surface of the assembly groove 21 define a sealant groove;
S106: the sealant 50 is placed in the sealant groove.

When preparing the substrate 10, a first circuit 11 and a second circuit 12 configured to be connected to the LED chip 30 may be respectively arranged on the front and back surface of the substrate 10. The arrangement of the first circuit 11 and the second circuit 12 can be made by a DPC (Direct Plating copper) process. In addition, the back surface of the substrate 10 can be provided with a second circuit 12, the substrate 10 is provided with a conductive hole 13 penetrating through the substrate 10, and the first circuit 11 and the second circuit 12 are connected through the conductive hole 13, so that the LED chip 30, the first circuit 11 and the second circuit 12 can be connected, thereby facilitating the electrical connection of the LED chip 30.

In specific applications, the first circuit 11 and the second circuit 12 can be plated with a nickel metal layer and a gold metal layer, so as to prevent the migration and oxidation of metals on the lines and improve the conductivity and oxidation resistance. The thickness of nickel metal layer is required to be > 3µm, and the thickness of gold metal layer is required to be > 0.05µm, so as to ensure the conductivity and oxidation resistance.

Preferably, the metal cap 42 and the light-transmitting member 41 can be fixed in the assembly groove 21 by bonding the light-transmitting member 41 to the metal cap 42 first, and then bonding the metal cap 42 in the assembly groove 21 of the dam 20 by laser bonding, so that the connection firmness can be improved, the possibility of the light-transmitting member 41 falling off can be reduced, and the reliability of the LED device 100 can be enhanced.

The LED packaging method provided by the present disclosure fully integrates the advantages of the two packaging methods by combining organic packaging and inorganic packaging. The present disclosure not only reduces the possibility of the light window assembly 40 falling off and improves the reliability of the product by bonding the light window assembly 40 to the dam 20, but also realizes the protection of the bonding place by supplementing the sealant 50, reducing the possibility of oxidation and rust at the bonding place. Moreover, because the sealant 50 fills the air hole cracks on the bonded joint, the reliability and air tightness of the product can be further improved. In addition, by arranging the bottom of the light window assembly 40 flush in the dam 20, the operator can match the LED chips 30 with different thicknesses by changing the height of the dam 20 in the production process, thus effectively reducing the cost and difficulty of realizing universality of the product while ensuring the light output rate of the product, thereby improving the universality of the product and facilitating the popularization and application of the product in large quantities.

As an alternative embodiment of this embodiment, the step of arranging the LED chip 30 on the front surface of the substrate 10 may further include the following steps:
S1031: a flux material is provided on the front surface of the substrate 10;
S1032: the LED chip 30 is provided on the flux material;
S1033: the LED chip 30 is made to be eutectic with the substrate 10.

Preferably, the flux material can be gold-tin alloy to have good bonding flux. Of course, in the actual production process, the LED chip 30 can also be directly placed on the front surface of the substrate 10 without using flux materials, and then the LED chip 30 and the substrate 10 are made to be eutectic, thus reducing the manufacturing difficulty and cost.

The method for eutectic the LED chip 30 and the substrate 10 may be that the substrate 10 with the LED chip 30 passes through a eutectic furnace together. Further, since the melting point of Au-Sn alloy is 280°C, the eutectic furnace temperature can be at least in one temperature range of 280°C-340°C, and vacuum or nitrogen gas protection can be set in the eutectic process, so that the bonding void rate of the LED chip 30 can be reduced and the electrode of the LED chip 30 can be prevented from being oxidized at high temperature.

Preferably, the flux material can be provided on the front surface of the substrate 10 by spot coating. It can be appreciated that the spot coating of the flux material on the front surface of the substrate 10 can be realized by manual or mechanical means, for example, an intelligent manipulator is arranged, and a certain amount of flux material is uniformly arranged by the intelligent manipulator, so that the bonding effect can be further improved.

In this embodiment, the flip-chip is mounted on the substrate 10 through a soldering aid, and the connection between the LED chip 30 and the substrate 10 is firmer through eutectic, thus improving the reliability of the LED device 100.

As an alternative embodiment of this embodiment, the step of arranging the LED chip 30 on the front surface of the substrate 10 further includes the following steps:
S1034: a die bonding adhesive is provided on the front surface of the substrate 10;
S1035: the LED chip 30 is provided on the die bonding adhesive, and baked at high temperature to cure the die bonding adhesive;
S1036: the electrodes of the LED chip 30 and the circuit of the substrate 10 are connected by wire bonding equipment.

Die bonding can make the LED chip 30 more firmly bonded with the substrate 10. When the LED chip 30 is a wire bonding chip, the die bonding adhesive can be insulating adhesive or silver adhesive. When the LED chip 30 is a vertical chip, the die bonding adhesive can be silver glue.

Preferably, in order to facilitate wire bonding, a nickel metal layer, a palladium metal layer and a gold metal layer can be arranged on the first circuit 11, wherein the thickness of the nickel metal layer can be greater than 3 µm, the thickness of the nickel metal layer can be greater than 0.05µm, and the thickness of the gold metal layer can be greater than 0.05µm, so as to ensure bonding, conductivity and oxidation resistance effects.

In this embodiment, a wire bonding chip or a vertical chip is mounted on the substrate 10 by a die bonding adhesive, and the die bonding adhesive is cured by high-temperature baking, so that the connection between the LED chip 30 and the substrate 10 is firmer, and the reliability of the LED device 100 is improved.

As an alternative embodiment of this embodiment, the step of bonding the metal cap 42 to the periphery of the light-transmitting member 41 may further include the following steps:
S1041: the metal cap 42 is punch-formed;
S1042: the metal cap 42 and the light-transmitting member 41 are placed in a positioning mold;
S1043: the molten glass solder 60 is extruded into the gap between the metal cap 42 and the light-transmitting member 41 by an extrusion device;
S1044: the metal cap 42 and the light-transmitting member 41 are put into a high-temperature furnace for sintering and molding.

In specific applications, the positioning die can include a positioning block, which is used for abutting against the metal cap 42 and the light-transmitting member 41 to realize positioning. Of course, the present disclosure is not limited to this, as long as positioning can be realized. For example, the positioning die can include a positioning groove with the metal cap 42 and the light-transmitting member 41, and the metal cap 42 and the light-transmitting member 41 are arranged in the positioning groove and abut against the groove surface of the positioning groove, so that the metal cap 42 and the light-transmitting member 41 can be realized.

In this embodiment, the metal cap 42 and the light-transmitting member 41 are bonded by glass solder 60 first, and then the metal cap 42 and the light-transmitting member 41 are sintered and molded, so that the connection between the metal cap 42 and the light-transmitting member 41 can be firmer, the possibility of the light-transmitting member 41 falling off can be reduced, and the reliability of the LED device 100 can be improved.

As an alternative embodiment of this embodiment, the step of setting the sealant 50 in the sealant groove further includes the following steps:
S1061: the sealant 50 to be cured is placed in the sealant groove without covering the light-transmitting member 41;
S1062: the sealant 50 is cured.

It can be appreciated that the sealant 50 refers to a curable coating with adhesive function, and the sealant 50 can be made of materials such as silica gel, epoxy resin, fluororesin, etc. The present disclosure does not limit the specific material of the sealant 50. Further, the way to cure the sealant 50 may include waiting for the sealant 50 to cure naturally, curing by baking or curing by UV light. Of course, the curing mode of the sealant 50 is not limited to this, as long as the sealant 50 can be cured. For example, if the sealant 50 needs to be cured by baking, it will be cured by UV light; if it can be cured by direct irradiation with UV light, then the UV light curing method is adopted, and for other types of sealant 50, the corresponding curing methods are adopted.

In the specific application, the sealant 50 to be cured can be placed in the sealant groove by manual or mechanical means, such as setting an intelligent manipulator, which can set the sealant 50 quantitatively at a fixed point, thus effectively reducing the possibility that the sealant 50 covers the light-transmitting member 41.

In this embodiment, the sealant 50 is arranged in the sealant groove to avoid covering the light-transmitting member 41 to reduce the light loss and increase the light output rate of the LED device 100, and the sealant 50 is enabled to cover the bonding position between the metal cap 42 and the dam 20, so that the bonding position can be protected and the possibility of oxidation and rust at the bonding position can be reduced. In addition, since the sealant 50 can fill the air hole cracks at the bonding position, this arrangement can further improve the reliability and air tightness of the product.

The present disclosure provides an LED device and an LED packaging method, wherein the LED device 100 includes a substrate 10, a dam 20, an LED chip 30, a light window assembly 40 and a sealant 50. The LED chip 30 is fixed on the front surface of the substrate 10. The dam 20 is annular and has an inner side wall, a top and a bottom, the bottom of the dam 20 is seated on the front surface of the substrate 10, the dam 20 surrounds the LED chip 30, and at least a part of the inner side wall of the dam 20 above the LED chip 30 is provided with an assembly groove 21 penetrating the top of the dam 20. The light window assembly 40 includes a light-transmitting member 41 and a metal cap 42, which are bonded to the periphery of the light-transmitting member 41. The light-transmitting member 41 and the metal cap 42 are fixed in the assembly groove 21, and the bottoms of the light-transmitting member 41 and the metal cap 42 are both abutted against with the groove bottom surface of the assembly groove 21. The light-transmitting member 41, the metal cap 42, the front surface of the substrate 10 and the dam 20 define an accommodating cavity for accommodating the LED chip 30, and the surfaces of the light-transmitting member 41 and the metal tube cap 42 and the wall surface of the assembly groove 21 define a sealant groove. The sealant 50 is arranged in the sealant groove and does not cover the light-transmitting member 41 (transparent cover).

Compared with the single semi-inorganic packaging and fully-inorganic packaging modes in the prior art, the present disclosure fully integrates the advantages of the two packaging modes through the packaging mode of combining organic packaging and inorganic packaging. The present disclosure not only reduces the possibility of the light window assembly 40 falling off and improves the reliability of the product by bonding the light window assembly 40 to the dam 20, but also realizes the protection of the bonding position by supplementing the sealant 50, thus reducing the possibility of oxidation and rust at the bonding position. Moreover, because the sealant 50 fills the air hole cracks on the bonded joint, the reliability and air tightness of the product can be further improved; and by arranging the bottom of the light window assembly 40 flush in the dam 20, the operator can match the LED chips 30 with different thicknesses by changing the height of the dam 20 in the production process, so as to effectively reduce the cost and difficulty of realizing the universality of the product while ensuring the light output rate of the product, thereby improving the universality of the product and facilitating the mass popularization and application of the product.

### Embodiment 9

As shown in FIG. 61 to FIG. 64, an LED device provided by an embodiment of the present disclosure includes a device body, which includes a substrate 1, a light-emitting element 2, a dam part 3 (all of which are dams in this embodiment) and a light-transmitting element 4 (all of which are transparent covers in this embodiment). The dam part 3 is connected to the substrate 1 and the light-transmitting element 4, and the substrate 1, the dam part 3 and the light-transmitting element 4 define a packaging cavity 5. The substrate 1 has a first end face 11 and a second end face 12 which are opposite to each other. The light-emitting element 2 is arranged on the first end face 11 of the substrate 1 and located in the packaging cavity 5. The light-emitting element 2 faces the light-transmitting element 4, and the dam part 3 has an inner side wall. The inner side wall of the dam part 3 is plated with a reflecting layer 32 for reflecting the light emitted by the light-emitting element 2. The inner side wall of the dam part 3 is inclined away from the light-emitting element 2 from the first end face 11, and forms an included angle α with the first end face 11 that is greater than zero and less than 90°. In an LED device provided by the present disclosure, the light-emitting element 2 is arranged in the packaging cavity 5 defined by the light-transmitting element 4, the dam part 3 and the substrate 1, and the inner side wall of the dam part 3 is arranged non-vertically relative to the first end face 11, An included angle α is formed between the inner side wall of the dam part 3 and the first end face 11, and the reflecting layer 32 is arranged on the inner side wall surface of the dam part 3 facing the packaging cavity 5. By reflecting the light emitted by the light-emitting element 2 through the reflecting layer 32 with an included angle α with the first end face, most of the light in the transverse direction of the light-emitting element 2 will be reflected to and emitted from the light-transmitting element 4 under the action of the reflecting layer 32, thus effectively reflecting the emitted light, reducing the light loss and improving the light output rate of the LED device.

Specifically, as shown in FIG. 61 to FIG. 63, the dam part 3 is cylindrical, the outline dimension of the upper end of the dam part is greater than the outline dimension of the lower end of the dam part 3. The inner side wall of the dam part 3 is arranged obliquely relative to the first end face 11, the outer side wall of the dam part 3 is perpendicular to the first end face 11, the longitudinal section of the side wall of the dam part 3 is in the shape of a right-angled ladder, and the included angle α is equal to the included angle between the hypotenuse and the bottom of the right-angled trapezoid. Compared with the traditional vertical dam part 3, the dam part 3 with the included angle α relative to the first end face 11 can reflect the light emitted by the light-emitting element 2 more effectively and reduce the light loss.

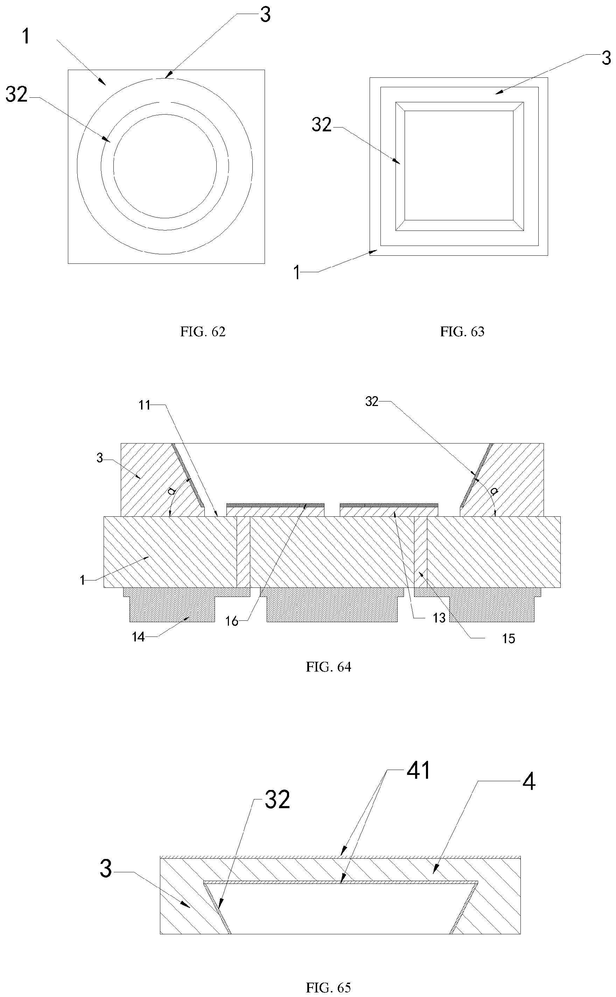

Specifically, the dam part 3 can be made of silicon or quartz, which is low in cost. As shown in FIG. 62, the dam part 3 has a frustum shape, or as shown in FIG. 63, the dam part 3 has a frustum shape, which can be set according to specific conditions, and the inner side wall of the dam part 3 is inclined, which is flexible.

Specifically, the reflecting layer 32 is a metal layer uniformly covering the inner side wall of the dam part 3; Alternatively, the reflecting layer 32 is a metal layer partially covering the inner side wall of the dam part 3, and the reflecting layer 32 is made of the metal layer, which has high light reflectivity, simple preparation process and excellent heat resistance and light resistance.

Specifically, the metal layer is a silver layer or an aluminum layer plated on the inner side wall of the dam member 3 by vacuum sputtering or evaporation. The aluminum layer will form dense aluminum oxide when contacting with air, and its performance is stable, therefore the aluminum layer is preferred as the reflecting layer 32 here.

Specifically, the included angle α is 30° to 60°. According to the characteristics of Fresnel effect (that is, a certain material presents different reflection and refraction effects at different distances and angles), when the light emitted by the light-emitting element 2 passes through the light-transmitting element 4 vertically, the Fresnel reflection of the light-transmitting element 4 is weak, and the light reflection of the light-transmitting element 4 is also weak. However, when light passes through the light-transmitting element 4 non-vertically, and the included angle α between the reflecting layer 32 and the first end face 11 is too small or too large, the Fresnel reflection of the light-transmitting element 4 will be enhanced, that is, the Fresnel reflection on the light-transmitting element 4 will become stronger. Therefore, the weaker the Fresnel reflection on the light-transmitting element 4, the higher the transmittance of light passing through the light-transmitting element 4. When the included angle α between the reflecting layer 32 and the first end face 11 is 30° to 60°, the light transmittance at the light-transmitting element 4 is relatively high, and within this angle range, the dam part 3 has a good reflection effect on light.

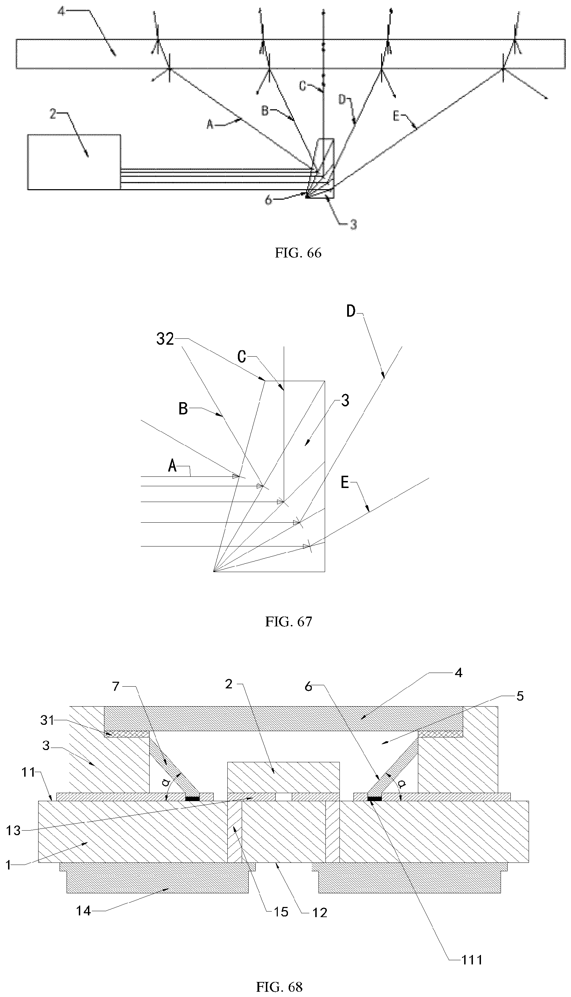

Specifically, the included angle α is 45°, and as shown in FIG. 66, ray A is a schematic diagram of the reflection path of the light emitted by the light-emitting element 2 at the light-transmitting element 4 when the included angle α is 75°, Ray B is a schematic diagram of the reflection path of the light emitted by the light-emitting element 2 at the light-transmitting element 4 when the included angle α is 60°. Ray C is a schematic diagram of the reflection path of the light emitted by the light-emitting element 2 at the light-transmitting element 4 when the included angle α is 45°. Ray D is a schematic diagram of the reflection path of the light emitted by the light-emitting element 2 at the light-transmitting element 4 when the included angle α is 30°. Ray E is a schematic diagram of the reflection path of the light emitted by the light-emitting element 2 at the light-transmitting element 4 when the included angle α is 15°. As shown in FIG. 67, when the included angle α is 75°, the ray A is a schematic diagram of the reflection path of the light ray emitted by the light-emitting element 2 at the reflecting layer 32 of the dam part 3. The ray B is a schematic diagram of the reflection path of the light emitted by the light-emitting element 2 at the reflecting layer 32 of the dam part 3 when the included angle α is 60°. The ray C is a schematic diagram of the reflection path of the light emitted by the light-emitting element 2 at the reflecting layer 32 of the dam part 3 when the included angle α is 45°. The ray d is a schematic diagram of the reflection path of the light emitted by the light-emitting element 2 at the reflecting layer 32 of the dam part 3 when the included angle α is 30°. The ray E is a schematic diagram of the reflection path of the light emitted by the light-emitting element 2 at the reflecting layer 32 of the dam part 3 when the included angle α is 15°. It can be seen that when the included angle α between the reflecting layer 32 and the first end face 11 is 45°, the ray C passes through the light-transmitting element 4 almost vertically, at this time, the Fresnel reflection of the light-transmitting element 4 is the smallest, and the light transmittance is the highest. If the included angle α is increased or decreased on the basis of 45°, the Fresnel reflection of the light-transmitting element 4 will be increased. Therefore, in this embodiment, the included angle α between the reflecting layer 32 and the first end surface 11 is preferably 45°.

Specifically, as shown in FIG. 61, a substrate surface circuit 13 is arranged between the light-emitting element 2 and the first end face 11, and a substrate back circuit 14 is arranged on the second end face 12. The substrate 1 has a conductive hole 15 that runs through the first end face 11 and the second end face 12, and the substrate surface circuit 13 and the substrate back circuit 14 are connected through the conductive hole 15, so that the structure is compact.

Specifically, the substrate on the substrate surface circuit 13 and the substrate on the substrate back circuit 14 are plated with a nickel-gold coating or a nickel-palladium coating, and the substrate on the substrate surface circuit 13 and the substrate on the substrate back circuit 14 are made by a copper plating process, wherein the thickness of nickel in the nickel-gold coating is > 3µm, the thickness of gold is > 0.05µm; the thickness of nickel in the nickel-palladium-gold coating is > 3µm, the thickness of palladium is > 0.05µm, and the thickness of gold is > 0.05µm. The substrate surface circuit 13 also has a dam bonding layer 17 and a chip bonding layer 16 for bonding the light-emitting element 2. At the same time, the substrate surface circuit 13 is plated with a metal reflecting layer in some areas except the chip bonding layer 16 and the dam bonding layer 17 by vacuum sputtering or evaporation. The metal reflecting layer 32 can be an aluminum or silver reflecting layer. When the aluminum reflecting layer contacts with air, it will form dense aluminum trioxide with stable performance, and the reflectivity of aluminum to ultraviolet light is over 90%. Aluminum plating is preferred here.

Specifically, the light-emitting element 2 is a UV chip with a flip-chip structure, and the electrode of the UV chip is a gold-tin alloy, which has excellent physical properties such as moderate bonding temperature and firm bonding, and is suitable for eutectic between the chip and the substrate.

Specifically, the light-transmitting element 4 can be a glass lens, which can be made of quartz or sapphire and is not easy to wear. The glass lens can be a plane lens or a spherical or hemispherical lens. As shown in FIG. 61, both the front and back surfaces of the glass lens can be coated with antireflection films 41 for improving the ultraviolet transmittance. The antireflection films 41 can be made of magnesium fluoride or silicon dioxide, which can improve the ultraviolet light transmission.

Specifically, as shown in FIG. 64, the dam part 3 can be integrally formed with the substrate 1, and the integrated substrate 1 with dam avoids the risk that the separated substrate may be bonded or poorly bonded in the process of dam bonding or bonding, resulting in product failure due to air tightness, and has strong practicability.

Specifically, as shown in FIG. 61, the upper end of the dam part 3 is provided with a lens bonding layer 31 for bonding the light-transmitting element 4, and glue or solder is applied to the contact surface between the upper end of the dam part 3 and the light-transmitting element 4 (forming a lens bonding layer 31). The light-transmitting element 4 can be fixedly connected to the dam part 3 by an adhesive or solder, or, as shown in FIG. 65, the dam part 3 and the light-transmitting element 4 can be integrally formed to simplify the process.

In an LED device provided by the present disclosure, the light-emitting element 2 is arranged in the packaging cavity 5 defined by the light-transmitting element 4, the dam part 3 and the substrate 1, and the inner side wall of the dam part 3 is obliquely arranged relative to the first end face 11. An included angle α is formed between the inner side wall of the dam part 3 and the first end face 11, and the dam part 3 is provided with the reflecting layer 32 facing the inner side wall surface of the packaging cavity 5. The reflecting layer 32 can effectively reflect the light emitted by the light-emitting element 2, reduce the light loss, and improve the light output rate of the LED device.

### Embodiment 10

As shown in FIG. 61 to FIG. 70, a manufacturing method (packaging method) of an LED device (LED packaging structure) provided by the present disclosure includes the following steps:
a substrate 1 having a first end face 11 and a second end face 12 opposite to each other is prepared;
the light-emitting element 2 is fixed on the first end face 11 of the substrate 1;
the first end face 11 of the substrate 1 is provided with dam parts 3 (which are all dams in this embodiment) surrounding the light-emitting element 2.
a reflecting surface 6 for reflecting part of the light emitted by the light-emitting element 2 is arranged in the space surrounded by the dam parts 3, and the reflecting surface 6 is inclined from the first end face 11 to the outside of the space, and the included angle α between the reflecting surface 6 and the first end face 11 is set to be greater than zero and less than 90°;
the light-transmitting elements 4 (all transparent covers in this embodiment) are fixedly connected to the dam parts 3, and the light-transmitting elements 4 face toward the light-emitting element 2, and the light-transmitting elements 4, the dam parts 3 and the substrate 1 define a packaging cavity 5.

The present disclosure provides a manufacturing method of an LED device and the LED device. A reflecting surface 6 for reflecting part of the light emitted by the light-emitting element 2 is arranged in a space surrounded by the dam part 3, and the light-transmitting element 4, the dam parts 3 and the substrate 1 define a packaging cavity 5, and the light-emitting element 2 is located in the packaging cavity 5. By reflecting the light emitted by the light-emitting element 2 through the reflecting surface 6 with an angle α with the first end face 11, the light output rate of the LED device can be improved.

The manufacturing method of an LED device provided by the present disclosure and the LED device will be described in further detail by taking specific Embodiment 10a and Embodiment 10b as examples and combining with the attached drawings.

### Embodiment 10a:

A manufacturing method (packaging method) of an LED device (packaging structure) provided by an embodiment of the present disclosure includes the following steps:
a substrate 1 having a first end face 11 and a second end face 12 opposite to each other is prepared;
the light-emitting element 2 is fixed on the first end face 11 of the substrate 1;
the first end face 11 of the substrate 1 is provided with dam parts 3 (which are all dams in this embodiment) surrounding the light-emitting element 2.
a reflecting surface 6 for reflecting part of the light emitted by the light-emitting element 2 is arranged in the space surrounded by the dam parts 3. In this Embodiment 10a, the included angle α between the inner side wall of the dam part 3 and the first end face 11 is set to be greater than zero and less than 90°. After the dam part 3 is arranged, a reflecting layer 32 is plated on the inner side wall of the dam part 3, and the surface of the reflecting layer 32 is the reflecting surface 6.

The light-transmitting element 4 is fixedly connected to the dam part 3, and the light-transmitting element 4 (transparent cover in this embodiment) faces toward the light-emitting element 2, and the light-transmitting element 4, the dam part 3 and the substrate 1 define a packaging cavity 5.

According to an LED device provided in Embodiment 10a of the present disclosure, the light-emitting element 2 is arranged in the packaging cavity 5 defined by the light-transmitting element 4, the dam part 3 and the substrate 1, the inner side wall of the dam part 3 is arranged non-vertically relative to the first end face 11. The reflection angle α is formed between the inner side wall of the dam part 3 and the first end face 11, and the reflecting layer 32 is arranged on the inner side wall surface of the dam part 3 facing the packaging cavity 5. By reflecting the light emitted by the light-emitting element 2 through the reflecting layer 32 with an included angle α with the first end face, most of the light emitted laterally by the light-emitting element 2 will be reflected to and emitted from the light-transmitting element 4 under the action of the reflecting layer 32, thus effectively reflecting the light emitted by the light-emitting element 2, reducing the light loss and upgrading the LED device. In this embodiment, the LED device includes the substrate 1, the light-emitting element 2, the dam part 3, the light-transmitting element 4 and the packaging cavity 5. The light-emitting element 2 is located in the packaging cavity 5 enclosed by the light-transmitting element 4, the dam part 3 and the substrate 1. In this embodiment, the packaging cavity 5 is empty except for the light-emitting element 2. The inner side wall of the dam part 3 is arranged obliquely relative to the first end face 11, the outer side wall of the dam part 3 is perpendicular to the first end face 11, the longitudinal section of the side wall of the dam part 3 is in the shape of a right-angled ladder, and the included angle α between the inner side wall of the dam part 3 and the first end face 11 is equal to the included angle between the hypotenuse and the bottom of the right-angled trapezoid, as shown in FIG. 61. The reflecting layer 32 is arranged on the inner side wall surface of the dam part 3 facing the packaging cavity 5, and can be completely covered or partially covered on the inner side wall surface of the dam part 3. The reflecting layer 32 is a metal layer plated on the inner side wall of the dam part 3, and the metal layer is an aluminum layer, and the thickness of the reflecting layer 32 can be set to be greater than 50nm. By reflecting the light emitted by the light-emitting element 2 through the reflecting layer 32 with an included angle α with the first end face 11, most of the light emitted by the light-emitting element 2 in the transverse direction will be reflected to and emitted from the light-transmitting element 4 under the action of the reflecting layer 32, thus effectively improving the light output rate of the LED device and reducing the light loss.

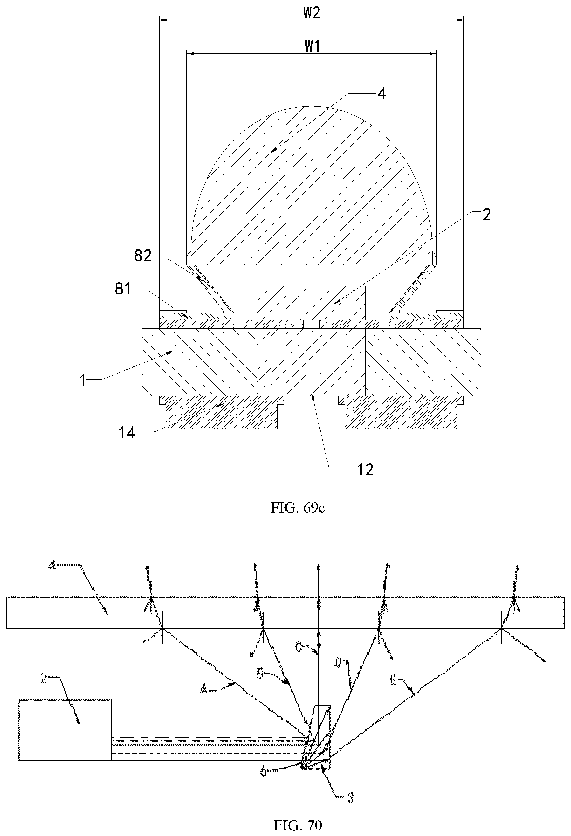

Specifically, in Embodiment 10a, the included angle α between the reflecting layer 32 and the first end face 11 is set to be between 30° and 60°. According to the characteristics of Fresnel effect (that is, a certain material exhibits different reflection and refraction effects at different distances and angles), when the light emitted by the light-emitting element 2 passes through the light-transmitting element 4 vertically, the Fresnel reflection of the light-transmitting element 4 is weak, and the light reflection of the light-transmitting element 4 is also weak. However, if the included angle α between the reflecting layer 32 and the first end face 11 is too small or too large, the Fresnel reflection of the light-transmitting element 4 will be enhanced, that is, the reflection of the light-transmitting element 4 will become stronger, therefore the weaker the Fresnel reflection on the light-transmitting element 4, the higher the transmittance of the light passing through the light-transmitting element 4. When the included angle α between the reflecting layer 32 and the first end face 11 is between 30° and 60°, the light transmittance at the light-transmitting element 4 is relatively high. As shown in FIG. 67, Ray A is a schematic diagram of the reflection path of the light emitted by the light-emitting element 2 at the reflecting layer 32 of the dam part 3 when the included angle α is 75°. Ray B is a schematic diagram of the reflection path of the light emitted by the light-emitting element 2 at the reflecting layer 32 of the dam part 3 when the included angle α is 60°. Ray C is a schematic diagram of the reflection path of the light emitted by the light-emitting element 2 at the reflecting layer 32 of the dam part 3 when the included angle α is 45°. Ray D is a schematic diagram of the reflection path of the light emitted by the light-emitting element 2 at the reflecting layer 32 of the dam part 3 when the included angle α is 30°. Ray E is a schematic diagram of the reflection path of the light emitted by the light-emitting element 2 at the reflecting layer 32 of the dam part 3 when the included angle α is 15°. As shown in FIG. 70, the ray A is a schematic diagram of the reflection path of the light emitted by the light-emitting element 2 at the light-transmitting element 4 when the included angle α is 75°; the ray B is a schematic diagram of the reflection path of the light emitted by the light-emitting element 2 at the light-transmitting element 4 when the included angle α is 60°; the ray C is a schematic diagram of the reflection path of the light emitted by the light-emitting element 2 at the light-transmitting element 4 when the included angle α is 45°; the ray D is a schematic diagram of the reflection path of the light emitted by the light-emitting element 2 at the light-transmitting element 4 when the included angle α is 30°; the ray E is a schematic diagram of the reflection path of the light emitted by the light-emitting element 2 at the light-transmitting element 4 when the included angle α is 15°. It can be seen that when the included angle α between the reflecting layer 32 and the first end face 11 is 45°, the ray C passes through the light-transmitting element 4 almost vertically, at this time, the Fresnel reflection of the light-transmitting element 4 is the smallest, and the light transmittance is the highest. If the included angle α is increased or decreased on the basis of 45°, the Fresnel reflection of the light-transmitting element 4 will be increased. Therefore, in this Embodiment 10a, THE included angle α between the reflecting layer 32 and the first end surface 11 is preferably 45°.

Specifically, in Embodiment 10a, the substrate 1 is a ceramic substrate. When preparing the substrate 1, as shown in FIG. 61, a substrate surface circuit 13 is arranged on the first end face 11 of the substrate 1, a substrate back circuit 14 is arranged on the second end face 12 of the substrate 1, and a conductive hole 15 for conducting the substrate surface circuit 13 and the substrate back circuit 14 is formed in the substrate 1. The conductive hole 15 penetrates through the first end face 11 and the second end face 12, and the substrate on the substrate surface circuit 13 and the substrate back circuit 14 is made by copper plating. The substrate surface is plated with a nickel-gold coating or a nickel-palladium-gold coating, so that the light-emitting element 2 can be better combined with the substrate 1. The thickness of nickel in the nickel-gold coating is > 3µm, and the thickness of gold is >0.05µm; the thickness of nickel in the nickel-palladium-gold coating is > 3µm, the thickness of palladium is > 0.05µm, and the thickness of gold is > 0.05µm. The substrate surface circuit 13 also has a dam bonding layer 17 and a chip bonding layer 16 for bonding the light-emitting element 2. At the same time, the substrate surface circuit 13 is plated with a metal reflecting layer by vacuum sputtering or evaporation in some areas except for the chip bonding layer 16 and the dam bonding layer 17. The metal reflecting layer can be aluminum or silver reflecting layer, and the aluminum reflecting layer will form dense aluminum trioxide when it comes into contact with air with a stable performance. The reflectivity of aluminum to ultraviolet light is over 90%.

Specifically, in Embodiment 10a, when fixing the light-emitting element 2 to the first end face 11 of the substrate 1, it includes the following steps: (1) applying a flux as a eutectic medium on the chip bonding layer 16, and placing the light-emitting element 2 where the flux exists; (2) sending the substrate 1 with the light-emitting elements 2 into a eutectic furnace for eutectic, so that the light-emitting elements 2 are firmly combined with the substrate 1, wherein the temperature of at least one temperature zone of the eutectic furnace is between 300 and 340 °C, and nitrogen can be input for protection during the eutectic process, or the eutectic environment vacuum can be ensured to prevent the LED device from being oxidized at high temperature.

Specifically, in Embodiment 10a, the light-emitting element 2 is a UV chip with a flip-chip structure, and the electrode of the UV chip is a gold-tin alloy, which has excellent physical properties such as moderate bonding temperature and firm bonding, and is suitable for eutectic between the chip and the substrate.

Specifically, in embodiment 10a, as shown in FIG. 61, when the dam part 3 surrounding the light-emitting element 2 is arranged on the first end face 11 of the substrate 1, the dam part 3 can be prefabricated first, then glue or solder is arranged at the contact surface between the dam part 3 and the substrate 1. Then the dam part 3 is arranged on the first end face 11 of the substrate 1, so as to ensure the stable engagement of the substrate 1 and the dam part 3. It should be noted that in some other specific embodiments, when the dam part 3 is made of nonmetal material and bonded with solder, it is necessary to metallize the contact surface at the lower end of the dam part 3 in advance, and the metallizing treatment can be gold-tin alloy electroplating.

Specifically, in embodiment 10a, as shown in FIGS. 61 and 62, the shape of the dam part 3 is a truncated cone, or as shown in FIGS. 61 and 63, the shape of the dam part 3 is a truncated pyramid. The shape of the dam part 3 can be made according to the actual use requirements, the shape of the dam part 3 can be set according to the specific situation, and the inner side wall of the dam part 3 is inclined to facilitate the reflection of light.

Specifically, in embodiment 10a, as shown in FIG. 64, the dam part 3 can be integrally formed with the substrate 1, and the integrated substrate 1 with a dam avoids the risk that the separated substrate may be bonded or bonded badly during the dam enclosing bonding or bonding process, which leads to the product failure due to air tightness, and has strong practicability.

Specifically, in embodiment 10a, as shown in FIG. 61, the upper end of the dam part 3 has a lens bonding layer 31 for bonding the light-transmitting element 4, and the contact surface between the upper end of the dam part 3 and the light-transmitting element 4 is coated with glue or solder (forming a bonding layer 31), so that the dam part 3 is fixedly connected with the light-transmitting element 4 through glue or solder. Alternatively, as shown in FIG. 65, the dam part 3 and the light-transmitting element 4 can also be integrally molded, simplifying process steps. Specifically, in Embodiment 9a, as shown in FIG. 61, both the front and back surfaces of the light-transmitting element 4 can be coated with antireflection films 41 for improving the light transmittance, and the antireflection films 41 can be made of magnesium fluoride or silicon dioxide, thus effectively improving the light transmittance of ultraviolet rays.

Specifically, in Embodiment 10a, the dam part 3 can be made of silicon or quartz, and the light-transmitting element 4 can be a glass lens, which can be made of quartz or sapphire and is not easy to wear.

Specifically, in Embodiment 10a, the glass lens can be a plane lens, a spherical lens or a hemispherical lens to meet different light requirements.

Specifically, in Embodiment 10a, the substrate 1 provided with the dam part 3 and the light-transmitting element 4 can be closely combined by high-temperature baking or light curing, which has good reliability.

### Embodiment 10b:

A manufacturing method (packaging method) of an LED device (packaging structure) provided by Embodiment 10b of the present disclosure includes the following steps:
a substrate 1 having a first end face 11 and a second end face 12 opposite to each other is prepared;
the light-emitting element 2 is fixed on the first end face 11 of the substrate 1;
the first end face 11 of the substrate 1 is provided with dam parts 3 (which are all dams in this embodiment) surrounding the light-emitting element 2;
a reflecting surface 6 for reflecting part of the light emitted by the light-emitting element 2 is arranged in the space surrounded by the dam part 3; specifically, in this embodiment, a reflecting ring 7 is arranged in the space surrounded by the dam parts 3, and the reflecting ring 7 surrounds the light-emitting element 2. The lower end of the reflecting ring 7 is close to the substrate 1, and the lower end of the reflecting ring 7 is smaller than the upper end of the reflecting ring 7, and the inner side wall of the reflecting ring 7 facing toward the light-emitting element 2 is the reflecting surface 6;

The light-transmitting element 4 (all transparent covers in this embodiment) is fixedly connected to the dam part 3, and the light-transmitting element 4 faces toward the light-emitting element 2, and the light-transmitting element 4, the dam parts 3 and the substrate 1 define a packaging cavity 5.

An LED device provided by Embodiment 10b of the present disclosure has the reflecting ring 7 for reflecting light, and the reflecting ring 7 is located in the packaging cavity 5 enclosed by the light-transmitting element 4, the dam part 3 and the substrate 1, and the inner side wall of the reflecting ring 7 is obliquely arranged relative to the first end face 11, with an included angle α between the inner side wall of the reflecting ring 7 and the first end face 11. The light emitted by the light-emitting element 2 is reflected by the inclined inner side wall of the reflecting ring 7, and under the action of the inner side wall of the reflecting ring 7, most of the light emitted laterally by the light-emitting element 2 will be reflected to and emitted from the light-transmitting element 4, which can effectively reduce the light loss and improve the light output rate of the LED device.

Specifically, in this embodiment, the reflecting ring 7 is annular with penetrating upper and lower ends, and the opening shape of the upper end of the reflecting ring 7 is the same as that of the lower end, but the size is different. The opening of the upper end of the reflecting ring 7 is larger than the opening of the lower end, and the opening of the upper end of the reflecting ring 7 is coaxially arranged with the opening of the lower end. The part connected between the upper end opening and the lower end opening of the reflecting ring 7 is the side wall of the reflecting ring 7. The thickness of the side wall of the reflecting ring 7 is uniform, and there is a gap between the outer side wall of the reflecting ring 7 and the inner side wall of the dam part 3. In this embodiment 9b, an inclined reflecting surface is not provided on the inner side of the dam part 3, but is formed on the inner side wall of the reflecting ring 7, thus saving the material of the dam part 3.

In this embodiment, the LED device includes the substrate 1, the light-emitting element 2, the dam part 3, the reflecting ring 7, the light-transmitting element 4 and the packaging cavity 5, wherein the reflecting ring 7 is located in the packaging cavity 5 enclosed by the light-transmitting element 4, the dam part 3 and the substrate 1. The inner side wall of the reflecting ring 7 is obliquely arranged relative to the first end face 11, and an included angle α is formed between the inner side wall of the reflecting ring 7 and the first end face 11. The light emitted by the light-emitting element 2 is reflected by the inclined inner side wall of the reflecting ring 7, and under the action of the inner side wall of the reflecting ring 7, most of the light emitted laterally by the light-emitting element 2 will be reflected to and emitted from the light-transmitting element 4, so that the light loss can be effectively reduced and the light output rate of the LED device can be improved. By the packaging mode of placing the reflecting ring 7 in the packaging cavity 5, the substrate 1 integrally formed with the dam part 3 can be directly used. The integrated substrate 1 with the dam avoids the risk that the products may fail due to air tightness caused by poor adhesion or bonding of the split substrate during the dam bonding or bonding process, and has strong practicability. The reflecting ring 7 can be prefabricated by metal punching process, which is convenient to manufacture, and then it is arranged on the dam part 3, which is convenient for assembly and replacement. Moreover, the dam part 3 can be matched with the reflecting ring 7 with a specific angle (that is, the angle α of the reflecting surface) according to different product requirements, and the applicability is wide.

Specifically, in Embodiment 10b, the included angle α between the reflecting surface 6 and the first end face 11 is set to be between 30° and 60°. According to the characteristics of Fresnel effect (that is, a certain material exhibits different reflection and refraction effects at different distances and angles), when the light emitted by the light-emitting element 2 passes through the light-transmitting element 4 vertically, the Fresnel reflection of the light-transmitting element 4 is weak, and the light reflection of the light-transmitting element 4 is also weak. However, if the included angle α between the reflecting layer 32 and the first end face 11 is too small or too large, the Fresnel reflection of the light-transmitting element 4 will be enhanced, that is, the reflection of the light-transmitting element 4 will become stronger, therefore the weaker the Fresnel reflection on the light-transmitting element 4, the higher the transmittance of the light passing through the light-transmitting element 4. When the included angle α between the reflecting layer 32 and the first end face 11 is between 30° and 60°, the light transmittance at the light-transmitting element 4 is relatively high. As shown in FIG. 70, the ray A is a schematic diagram of the reflection path of the light emitted by the light-emitting element 2 at the light-transmitting element 4 when the included angle α is 75°; the ray B is a schematic diagram of the reflection path of the light emitted by the light-emitting element 2 at the light-transmitting element 4 when the included angle α is 60°; the ray C is a schematic diagram of the reflection path of the light emitted by the light-emitting element 2 at the light-transmitting element 4 when the included angle α is 45°; the ray D is a schematic diagram of the reflection path of the light emitted by the light-emitting element 2 at the light-transmitting element 4 when the included angle α is 30°; the ray E is a schematic diagram of the reflection path of the light emitted by the light-emitting element 2 at the light-transmitting element 4 when the included angle α is 15°. It can be seen that when the included angle α between the reflecting layer 32 and the first end face 11 is 45°, the ray C passes through the light-transmitting element 4 almost vertically, at this time, the Fresnel reflection of the light-transmitting element 4 is the smallest, and the light transmittance is the highest. If the included angle α is increased or decreased on the basis of 45°, the Fresnel reflection of the light-transmitting element 4 will be increased. Therefore, in this Embodiment 10a, the included angle α between the reflecting surface 6 and the first end surface 11 is preferably 45°.

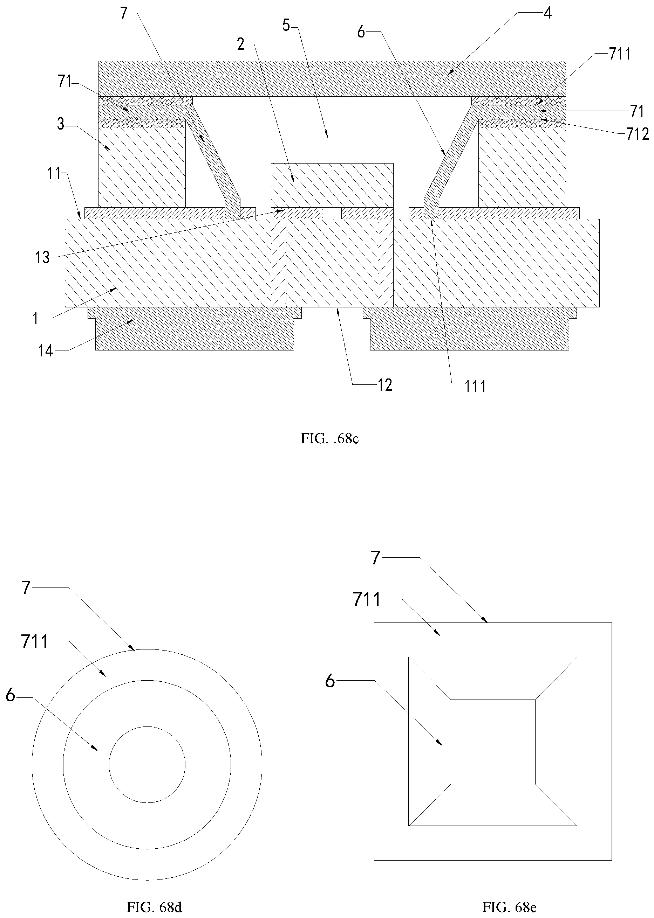

Specifically, in embodiment 10b, as shown in FIG. 68d, the shape of the reflecting ring 7 is a truncated cone, or as shown in FIG. 68e, the shape of the reflecting ring 7 is a truncated pyramid, which can be set according to actual use requirements, and the inner side wall of the reflecting ring 7 is inclined to facilitate light reflection.

Specifically, in Embodiment 10b, the reflecting ring 7 can be made of mirror-like aluminum or mirror-like silver. When the mirror-like aluminum comes into contact with air, it will form dense aluminum trioxide with stable performance. Therefore, mirror-like aluminum is preferred as the manufacturing material of the reflecting ring 7 here, and its reflectivity to ultraviolet light is higher than 90%, which greatly improves the light yield, and the process difficulty and cost are low.

Specifically, in Embodiment 10b, the substrate 1 can be a ceramic substrate. When preparing the substrate 1, as shown in FIG. 61, a substrate surface circuit 13 is arranged on the first end face 11 of the substrate 1, a substrate back circuit 14 is arranged on the second end face 12 of the substrate 1, and a conductive hole 15 for conducting the substrate surface circuit 13 and the substrate back circuit 14 is formed in the substrate 1. The conductive hole 15 penetrates through the first end face 11 and the second end face 12, and the substrate on the substrate surface circuit 13 and the substrate back circuit 14 can be made by copper plating process. The surface of the substrate is plated with a nickel-gold coating or a nickel-palladium-gold coating by gold deposition process, so that the light-emitting element 2 can be better engaged with the substrate 1. In the nickel-gold coating, the thickness of nickel is > 3µm, and the thickness of gold is > 0.05µm. In the nickel-palladium-gold coating, the thickness of palladium is > 0.05µm, and the thickness of gold is > 0.05µm. The substrate surface circuit 13 also has a dam contact position and a chip contact position for soldering the light-emitting element 2. At the same time, the substrate surface circuit 13 is plated with a metal reflecting layer by vacuum sputtering or evaporation in some areas except the dam contact position and the chip contact position. The metal reflecting layer can be aluminum or silver reflecting layer, and the aluminum reflecting layer will form dense aluminum trioxide when contacting with air, which has stable performance. The reflectivity of aluminum to ultraviolet light is above 90%.

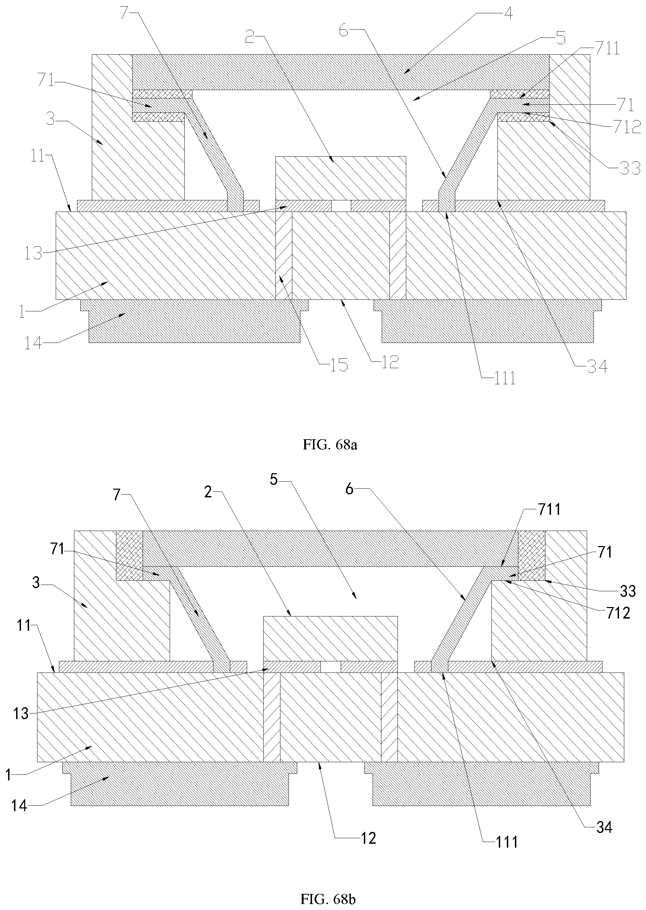

Specifically, in Embodiment 10b, the first end face 11 of the substrate 1 has a connecting groove 111 for the lower end of the reflecting ring 7 to be engaged, as shown in FIGS. 68 to 68c, the lower end of the reflecting ring 7 can be directly embedded in the connecting groove 111, or glue or solder can be coated in the connecting groove 111 to bond or weld the lower end of the reflecting ring 7 in the connecting groove 111, so that the structure is stable.

Specifically, in Embodiment 10b, when fixing the light-emitting element 2 to the first end face 11 of the substrate 1, it includes the following steps: (1) applying a flux as a eutectic medium on the contact position of the chip, and placing the light-emitting element 2 where the flux exists; (2) sending the substrate 1 with the light-emitting elements 2 into a eutectic furnace for eutectic, so that the light-emitting elements 2 are firmly combined with the substrate 1, wherein the temperature of at least one temperature zone of the eutectic furnace is between 300°C and 340°C, and nitrogen gas can be input during the eutectic process to protect or ensure the eutectic environment vacuum, so as to prevent the LED device from being oxidized at high temperature.

Specifically, in Embodiment 10b, the light-emitting element 2 is a UV chip with a flip-chip structure, and the electrode of the UV chip is a gold-tin alloy, which has excellent physical properties such as moderate bonding temperature and firm bonding, and is suitable for eutectic between the chip and the substrate.

Specifically, in Embodiment 10b, as shown in FIG. 68, when the dam part 3 surrounding the light-emitting element 2 is arranged on the first end face 11 of the substrate 1, glue or solder can be coated on the dam contact position to ensure the stable engagement. It should be noted that when the dam part 3 is made of nonmetal material and bonded with solder, the contact position of the dam part 3 needs to be metallized in advance, and the metallization treatment can be gold-tin alloy plating.

Specifically, in the Embodiment 10b, the dam part 3 can be made of silicon or quartz.

Specifically, in Embodiment 10b, the packaging method of the reflecting ring 7 can be as follows: (1) as shown in FIG. 68, the end face of the lower end of the reflecting ring 7 is directly bonded to the connecting groove 111 of the first end face 11 of the substrate 1 by an adhesive; (2) as shown in FIG. 68a, there is a stepped groove inside the dam part 3, which includes a lower groove 34 surrounding the light-emitting element 2 and an upper groove 33 with a size greater than the lower groove 34 and located above the lower groove 34; the edge of the opening of the upper end of the reflecting ring 7 extends horizontally with an abutting part 71, and the front end face of the abutting part 71 abuts against the groove wall of the upper groove 33, thus preventing the reflecting ring 7 from shaking; the abutting part 71 has an upper surface 711 and a lower surface 712 which are opposite to each other. The lower surface 712 of the abutting part 71 is connected with the bottom of the upper groove 33 by an adhesive or solder, and the light-transmitting element 4 is provided to cover the upper surface 711 of the abutting part 71 by an adhesive or solder; alternatively, as shown in FIG. 68b, both the abutting part 71 and the light-transmitting element 4 are located in the upper groove 33, and the side walls of the abutting part 71 and the light-transmitting element 4 are connected to the groove wall of the upper groove 33 by an adhesive or solder, and glue or solder only needs to be set in the upper groove 33 once, thus saving working procedures; (3) as shown in FIG. 68c, the lower surface 712 of the abutting part 71 is provided to cover and is connected to the upper end face of the dam part 3 by an adhesive or solder, and the light-transmitting element 4 is provided to cover the upper surface 711 of the abutting part 71 by an adhesive or solder, without the need of arranging a stepped groove at the top of the dam part 3, and the packaging forms are various.

Specifically, in embodiment 10b, as shown in FIG. 68, the upper end of the dam part 3 has a lens bonding layer 31 for bonding the light-transmitting element 4, glue or solder is applied at the contact surface between the upper end of the dam part 3 and the light-transmitting element 4 (forming the lens bonding layer 31), and the light-transmitting element 4 is fixedly connected to the lens bonding layer 31 by an adhesive or solder, so that the connection is stable.

Specifically, in Embodiment 10b, the light-transmitting element 4 can be a glass lens, which can be made of quartz or sapphire and is not easy to wear. The glass lens can be a plane lens, a spherical lens or a hemispherical lens to meet different light requirements.

Specifically, in Embodiment 10b, the substrate 1 provided with the dam part 3 and the light-transmitting element 4 can be closely engaged by high-temperature baking or light curing, with good reliability.

### Embodiment 10c:

A manufacturing method (packaging method) of an LED device (packaging structure) provided by embodiment 10c of the present disclosure includes the following steps:
a substrate 1 having a first end face 11 and a second end face 12 opposite to each other is prepared;
the light-emitting element 2 is fixed on the first end face 11 of the substrate 1;
the first end face 11 of the substrate 1 is provided with dam part 3 (which are all dans in this embodiment) surrounding the light-emitting element 2; in this embodiment, a cap member 8 is set as the dam part 3, which is integrally formed from metal and has a cap seat 81 and a cap side wall 82 integrally connected to the cap seat 81; the cap seat 81 is attached and connected to the substrate 1, and the inner side wall of the cap side wall 82 is the reflecting surface 6;
the light-transmitting element 4 (all transparent covers in this embodiment) is fixedly connected to the upper end of the cap side wall 82, and the light-transmitting element 4 faces toward the light-emitting element 2; the light-transmitting element 4, the cap member 8 and the substrate 1 define a packaging cavity 5. In an LED device provided in Embodiment 9c of the present disclosure, the cap member 8 is set as the dam part 3, the light-emitting element 2 is located in the packaging cavity 5 formed by the light-transmitting element 4, the cap member 8 and the substrate 1; the cap side wall 82 is obliquely arranged relative to the first end face 11, and the lower end of the cap side wall 82 is smaller than the upper end of the cap side wall 82; an included angle α exists between the inner side wall of the cap side wall 82 and the first end face 11, and the light emitted by the light-emitting element 2 can be reflected through the inner side wall of the cap side wall 82; under the action of the inner side wall of the cap side wall 82, most of the light emitted laterally by the light-emitting element 2 will be reflected to and emitted from the light-transmitting element 4, which can effectively reduce the light loss and improve the light output rate of LED devices.

Specifically, the upper end of the cap side wall 82 has an upper opening, the lower end of the cap side wall 82 has a lower opening, and the shape of the upper opening is the same as that of the lower opening. The upper opening and the lower opening are coaxially arranged. The cap base 81 extends horizontally from the edge of the lower opening of the cap side wall 82 to the periphery to form a plane base with an opening in the middle, and the cap member 8 is shaped like a cap as a whole. The light-transmitting element 4 can be fixedly connected to the upper opening of the cap side wall 82 and close the upper opening.

In this embodiment, the LED device includes the substrate 1, a light-emitting element 2, a cap member 8, a light-transmitting element 4 and the packaging cavity 5. The light-emitting element 2 is located in the packaging cavity 5 surrounded by the light-transmitting element 4, the cap member 8 and the substrate 1, the cap side wall 82 is obliquely arranged relative to the first end face 11, and the lower end of the cap side wall 82 is smaller than the upper end of the cap side wall 82. An included angle α exists between the inner side wall of the cap side wall 82 and the first end face 11, and the light emitted by the light-emitting element 2 can be reflected through the inner side wall of the cap side wall 82. Under the action of the inner side wall of the cap side wall 82, most of the light emitted laterally by the light-emitting element 2 will be reflected to and emitted from the light-transmitting element 4, which can effectively reduce the light loss and improve the light output rate of LED devices.

Specifically, in Embodiment 10c, the included angle α between the reflecting surface 6 (the inner side wall of the cap side wall 82) and the first end face 11 is set to be between 30° and 60°. According to the characteristics of Fresnel effect (that is, a certain material exhibits different reflection and refraction effects at different distances and angles), when the light emitted by the light-emitting element 2 passes through the light-transmitting element 4 vertically, the Fresnel reflection of the light-transmitting element 4 is weak, and the light reflection of the light-transmitting element 4 is also weak. However, if the included angle α between the reflecting layer 32 and the first end face 11 is too small or too large, the Fresnel reflection of the light-transmitting element 4 will be enhanced, that is, the reflection of the light-transmitting element 4 will become stronger, therefore the weaker the Fresnel reflection on the light-transmitting element 4, the higher the transmittance of the light passing through the light-transmitting element 4. When the included angle α between the reflecting layer 32 and the first end face 11 is between 30° and 60°, the light transmittance at the light-transmitting element 4 is relatively high. As shown in FIG. 70, the ray A is a schematic diagram of the reflection path of the light emitted by the light-emitting element 2 at the light-transmitting element 4 when the included angle α is 75°; the ray B is a schematic diagram of the reflection path of the light emitted by the light-emitting element 2 at the light-transmitting element 4 when the included angle α is 60°; the ray C is a schematic diagram of the reflection path of the light emitted by the light-emitting element 2 at the light-transmitting element 4 when the included angle α is 45°; the ray D is a schematic diagram of the reflection path of the light emitted by the light-emitting element 2 at the light-transmitting element 4 when the included angle α is 30°; the ray E is a schematic diagram of the reflection path of the light emitted by the light-emitting element 2 at the light-transmitting element 4 when the included angle α is 15°. It can be seen that when the included angle α between the reflecting layer 32 and the first end face 11 is 45°, the ray C passes through the light-transmitting element 4 almost vertically, at this time, the Fresnel reflection of the light-transmitting element 4 is the smallest, and the light transmittance is the highest. If the included angle α is increased or decreased on the basis of 45°, the Fresnel reflection of the light-transmitting element 4 will be increased. Therefore, in this Embodiment 10a, the included angle α between the reflecting surface 6 and the first end surface 11 is preferably 45°.

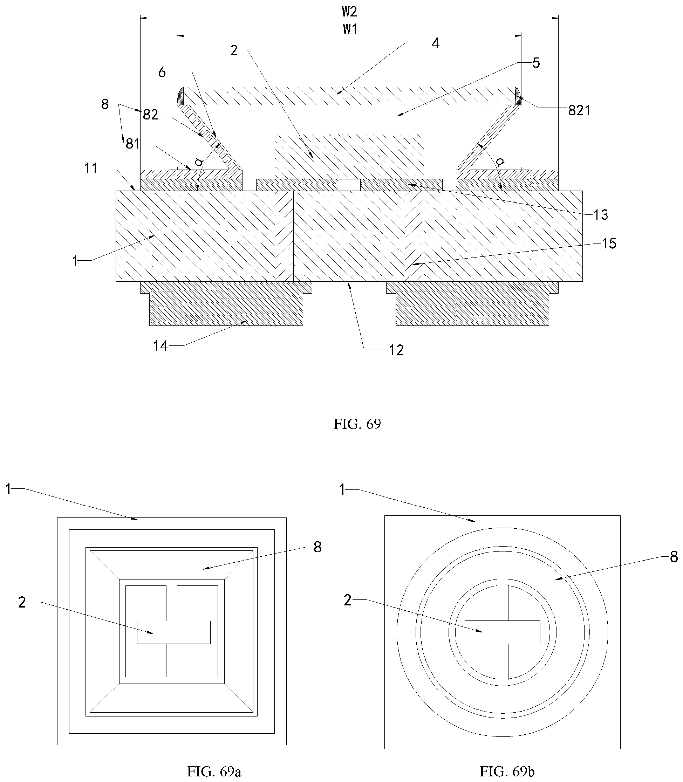

Specifically, in Embodiment 10c the substrate 1 can be a ceramic substrate. When preparing the substrate 1, as shown in FIG. 69, a substrate surface circuit 13 is arranged on the first end face 11 of the substrate 1, a substrate back circuit 14 is arranged on the second end face 12 of the substrate 1, and a conductive hole 15 for conducting the substrate surface circuit 13 and the substrate back circuit 14 is formed in the substrate 1. The conductive hole 15 penetrates through the first end face 11 and the second end face 12, and the substrate on the substrate surface circuit 13 and the substrate back circuit 14 can be made by copper plating process. The surface of the substrate is plated with a nickel-gold coating or a nickel-palladium-gold coating by gold deposition process, so that the light-emitting element 2 can be better engaged with the substrate 1. In the nickel-gold coating, the thickness of nickel is > 3µm, and the thickness of gold is > 0.05µm. In the nickel-palladium-gold coating, the thickness of palladium is > 0.05µm, and the thickness of gold is > 0.05µm. The substrate surface circuit 13 also has a dam contact position and a chip contact position for soldering the light-emitting element 2. At the same time, the substrate surface circuit 13 is plated with a metal reflecting layer by vacuum sputtering or evaporation in some areas except the dam contact position and the chip contact position. The metal reflecting layer can be aluminum or silver reflecting layer, and the aluminum reflecting layer will form dense aluminum trioxide when contacting with air, which has stable performance. The reflectivity of aluminum to ultraviolet light is above 90%.

Specifically, in Embodiment 10c when fixing the light-emitting element 2 to the first end face 11 of the substrate 1, it includes the following steps: (1) applying a flux as a eutectic medium on the contact position of the chip, and placing the light-emitting element 2 where the flux exists; (2) sending the substrate 1 with the light-emitting elements 2 into a eutectic furnace for eutectic, so that the light-emitting elements 2 are firmly combined with the substrate 1, wherein the temperature of at least one temperature zone of the eutectic furnace is between 300°C and 340°C, and nitrogen gas can be input during the eutectic process to protect or ensure the eutectic environment vacuum, so as to prevent the LED device from being oxidized at high temperature.

Specifically, in Embodiment 10c, the light-emitting element 2 is a UV chip with flip-chip structure, and the electrode of the UV chip is made of Au-Sn alloy, which has excellent physical properties such as moderate bonding temperature and firm bonding, and is suitable for eutectic between the chip and the substrate.

Specifically, in Embodiment 10c, when the cap member 8 surrounding the light-emitting element 2 is arranged on the first end face 11 of the substrate 1, glue or solder can be coated on the contact position of the cap seat to ensure stable engagement.

Specifically, in embodiment 10c, as shown in FIG. 69a, the shape of the cap side wall 82 is a truncated pyramid, or as shown in FIG. 69b, the cap side wall 82 is a truncated cone, and it is flexible and practical to make only the shape of the cap side wall 82 according to actual use requirements. As shown in FIG. 69, the lower end of the cap side wall 82 is smaller than the upper end of the cap side wall 82. The included angle α between the side wall 82 of the cap and the first end face 11 is set to be greater than zero and less than 90°, and the inner side wall of the side wall 82 of the cap is plated with aluminum, so that the reflectivity of aluminum to ultraviolet rays is over 90%, which can effectively reflect the light emitted by the light-emitting element 2.

Specifically, in Embodiment 10c, as shown in FIGS. 69 and 69c, the outline dimension W2 of the cap seat 81 is greater than the outline dimension W1 of the upper end of the cap side wall 82, and the difference between the outline dimension W2 of the cap seat 81 and the outline dimension W1 of the upper end of the cap side wall 82 is ≥0.2mm, that is, the range in which the cap seat 81 extends outward from the opening edge of the lower end of the cap side wall 82 is beyond the range of the projection of the upper end of the cap side wall 82 to the cap seat 81. This design makes the cap seat 81 have a large area for bonding (i.e., facilitating connection with the substrate 1), and because the outer contour area of the cap seat 81 is larger than that of the upper end of the cap side wall 82, the stress area at the bottom of the cap member 8 is large, which can enhance the support of the cap member 8 to the light-transmitting element 4 and avoid the deformation of the cap member 8.

Specifically, in Embodiment 10c, the cap member 8 needs to be rigid and not easily deformed, therefore Kovar alloy is preferred as the material of the cap member 8 here. The cap member 8 can be formed by punching, and its shape can be processed into a circle, a square or a diamond, etc. The shape of the cap member 8 can be set according to specific conditions, and the inner side wall of the cap side wall 82 is inclined to facilitate the reflection of light.

Specifically, in Embodiment 10c, as shown in FIG. 69, the upper end of the cap side wall 82 has a bonding point 821 for bonding the light-transmitting element 4. The light-transmitting element 4 and the cap side wall 82 can be sintered together by glass solder, or by electroplating metal at the bonding point 821 or the bonding place of the light-transmitting element 4. The transparent element 4 and the cap side wall 82 are bonded together by bonding methods such as laser bonding, eutectic bonding or reflow bonding, and the metal used for electroplating is preferably Au-Sn alloy. In the production process of manufacturing LED modules, an LED device proposed by the present disclosure usually needs to be attached to a PCB through a die attach process, and then soldered by reflow soldering equipment, and the temperature of the reflow soldering equipment reaches 265 °C, In order to avoid secondary reflow phenomenon at the bonding point 821 between the light-transmitting element 4 and the cap side wall 82, the composition content of gold and tin in the gold-tin alloy is set to 80% and 20%, and the melting temperature of the gold-tin alloy is higher than 280°C at this ratio, such that the secondary reflow phenomenon will not occur after reflow bonding. The light-transmitting element 4 and the cap side wall 82 can be locally heated and bonded by laser bonding and other bonding methods, so that the fully-inorganic packaging of the LED device can be realized, the whole product can be prevented from being affected by the expansion and contraction of air in the cavity during heating bonding, and the undesirable phenomena such as bubbles, cavities, cracks and the like can be prevented at the bonding point, thus avoiding affecting the reliability of the product.

Specifically, in Embodiment 10c, the light-transmitting element 4 can be a glass lens, which can be made of quartz or sapphire and is not easy to wear.

Specifically, in embodiment 10c, as shown in FIGS. 69 and 69c, the glass lens can be a plane lens, a spherical lens or a hemispherical lens to meet different light requirements.

The present disclosure provides a manufacturing method (packaging method) of an LED device (packaging structure) and the LED device (packaging structure. A reflecting surface 6 for reflecting part of light emitted by the light-emitting element 2 is arranged around the light-emitting element 2, and the included angle α between the reflecting surface 6 and the first end face 11 is set to be greater than zero and less than 90°. At this angle, most of the light emitted laterally by the light-emitting element 2 will be reflected to the front and emitted from the transparent element 4 (transparent cover), so that the phenomenon of reflection loss of light between dams in a vertical dam structure is avoided, the light extraction efficiency is relatively higher. Moreover, aluminum is directly plated on the reflecting surface 6, which not only realizes the ultraviolet reflectance higher than 90%, but also effectively improves the light output rate of UV-LED devices and reduces the light loss.

The order of the method steps in the embodiment provided by the present disclosure is not necessary, and the order of the steps in this embodiment can be adjusted according to the actual situation in case of no conflict. For example, dam parts 3 surrounding the light-emitting element 2 can be arranged before the first end face 11 of the substrate 1; then, the light-emitting element 2 is fixed to the first end face 11 of the substrate 1. The simple adjustment of the step sequence of the LED device manufacturing method provided by the present disclosure does not require creative labor by the those skilled in the art, and the simple adjustment of the step sequence shall be regarded as falling within the protection scope of the present disclosure.

The above is only the preferred embodiment of the present disclosure, and is not intended to limit the present disclosure. Any modification, equivalent substitution or improvement made within the spirit and principle of the present disclosure shall fall within the protection scope of the present disclosure.

## Claims

1. A packaging structure comprising a substrate, a light-emitting element, a transparent cover and a dam connected to the substrate, wherein the light-emitting element is an LED chip or a laser chip; and the substrate has a front surface and a back surface which are opposite to each other, and the light-emitting element is fixed on the front surface of the substrate; and the transparent cover is connected to the dam.

2. The packaging structure according to claim 1, wherein the dam, the transparent cover and the substrate are enclosed to form an assembly area; and the dam comprises an outer retaining wall and an inner retaining wall, and a groove is formed between the outer retaining wall and the inner retaining wall; and the packaging structure further comprises a sealing member arranged in the groove; and the transparent cover covers the inner retaining wall and the assembly area, and the transparent cover is inserted into the groove and connected with the sealing member; the packaging structure further comprises a protective member arranged at an edge of the transparent cover, wherein the protective member is provided with a blocking part for blocking a gap between the transparent cover and the outer retaining wall, and a pressing part connected to the blocking part and capable of abutting against an upper end of the transparent cover.

3. The packaging structure according to claim 2, wherein a plurality of protective members are provided, and the plurality of protective members partially cover an upper surface of the transparent cover, and a distance between end faces of the two opposite pressing parts on the upper surface of the transparent cover is not greater than a distance between two opposite side walls of the inner retaining wall facing toward the groove.

4. The packaging structure according to claim 2, wherein the sealing member has an inner sealing part for being attached to the inner retaining wall and an inner side of the transparent cover, an outer sealing part for being attached to the outer retaining wall and an outer side of the transparent cover, and a transverse sealing part for being attached to a bottom of the groove and a bottom of the transparent cover; and one end of the transverse sealing part is connected to the outer sealing part, and the other end of the transverse sealing part is connected to the inner sealing part, wherein the inner sealing part, the outer sealing part and the transverse sealing part are enclosed to form an assembly groove for installing the transparent cover.

5. The packaging structure according to claim 4, wherein the transparent cover comprises a face cover part and a longitudinal part connected to an outer peripheral side of the face cover part; and one side of the inner sealing part is attached to an inner side of the longitudinal part, the other side of the inner sealing part is attached to a side of the inner retaining wall, and a bottom of the longitudinal part is attached to the transverse sealing part.

6. The packaging structure according to claim 2, wherein the protective member further comprises a fixing part connected to the blocking part and configured for being fixedly connected with the outer retaining wall, wherein the fixing part partially overlaps with the outer retaining wall; and the fixing part partially overlaps with an upper end face of the outer retaining wall or a side thereof facing toward the groove.

7. The packaging structure according to claim 6, wherein a height of the inner retaining wall is a first height, and a height of the outer retaining wall is a second height, wherein the first height is greater than the second height; and the fixing part is connected to one end of the blocking part, and the pressing part is connected to the other end of the blocking part.

8. The packaging structure according to claim 6, wherein the height of the inner retaining wall is a first height, and the height of the outer retaining wall is a second height, wherein the first height is smaller than the second height; and the outer side of the blocking part is attached to the outer retaining wall; and the fixing part is respectively connected with the blocking part and the pressing part.

9. The packaging structure according to claim 1, wherein the bottom of the transparent cover is provided with a bonding layer, and a front surface of the substrate is provided with a first circuit layer, wherein the first circuit layer comprises a first circuit pattern configured to be connected to the bonding layer, and the first circuit layer further comprises a pad configured to be bonded with the LED chip, wherein a sealed packaging cavity is formed between the transparent cover and the substrate, and the LED chip is arranged in the packaging cavity and bonded to the pad.

10. The packaging structure of claim 9, wherein the bonding layer is a metal layer formed on the bottom of the transparent cover by electroplating; and the first circuit pattern is a metal layer formed on a front surface of the substrate by electroplating; or,
the bonding layer is glass solder formed at the bottom of the transparent cover; and the first circuit pattern is a metal layer formed on the front surface of the substrate by electroplating.

11. The packaging structure according to claim 9, wherein the first circuit pattern has a closed shape, and the bonding layer is connected with the first circuit pattern to form a closed bonding area;
or, the first circuit pattern has a semi-closed shape, and the bonding layer is connected with the first circuit pattern to form a semi-closed bonding area.

12. The packaging structure according to claim 9, wherein a second circuit layer is arranged on a back surface or/and an interior of the substrate; and
the pad is in conductive connection with the second circuit layer through a conductive hole arranged on the substrate.

13. The packaging structure according to claim 1, wherein the dam is annular and has an inner side wall, a top and a bottom, wherein the bottom of the dam is seated on the front surface of the substrate, the dam surrounds the LED chip, and at least part of the inner side wall of the dam above the LED chip is provided with an assembly groove penetrating through the top of the dam, wherein the assembly groove has a groove bottom surface and a groove side wall; and the packaging structure further comprises a positioning block arranged in the assembly groove; and the bottom surface of the transparent cover abuts against the groove bottom surface of the assembly groove and faces toward the LED chip, a side of the transparent cover abuts against a plurality of positioning blocks, and the side of the transparent cover, the groove bottom surface and the groove side wall of the assembly groove form a sealant groove; and the packaging structure further comprises a sealant that is arranged in the sealant groove and does not cover the transparent cover.

14. The packaging structure according to claim 13, wherein the plurality of the positioning blocks are arranged at equal intervals along a circumferential direction of the sealant groove.

15. The packaging structure according to claim 13, wherein the bottom of the positioning block is seated on the groove bottom surface of the assembly groove, and the positioning block has a first side and a second side that are opposite to each other, wherein the first side of the positioning block abuts against the groove side wall of the assembly groove, and the peripheral side of the transparent cover abuts against the second side of the positioning block.

16. The packaging structure according to claim 13, wherein the bottom of the transparent cover is seated on the groove bottom surface of the assembly groove, and a top of the transparent cover is higher than a height of the positioning block.

17. The packaging structure according to claim 13, wherein the height of the positioning block is lower than the top of the assembly groove, and the sealant covers the top of the positioning block.

18. The packaging structure according to claim 13, wherein
a front surface of the substrate is provided with a first circuit, and the LED chip is connected with the first circuit; and a back surface of the substrate is provided with a second circuit, and the substrate is provided with a conductive hole penetrating through the front surface and the back surface, wherein the first circuit and the second circuit are connected through the conductive hole.

19. The packaging structure according to claim 1, wherein the front surface of the substrate is provided with a first circuit layer; and the light-emitting element is arranged on the front surface of the substrate and connected with the first circuit layer; and the dam is arranged on the front surface of the substrate, and comprises a first part and a second part which are arranged on the front surface of the substrate at intervals, wherein the first part and the second part are respectively configured as a positive conductor and a negative conductor connected with an electric signal detection module, and the positive conductor and the negative conductor are arranged on the periphery of the light-emitting element and the first circuit layer; and the transparent cover comprises a light-transmitting conductive layer, a dodging layer and a light-transmitting layer which are stacked in layers, wherein the light-transmitting conductive layer is connected to the positive conductor and the negative conductor.

20. The packaging structure according to claim 19, wherein the light-transmitting conductive layer is made of an indium tin oxide material; and the dam is separated by a partition groove, and the positive conductor and the negative conductor are symmetrically arranged relative to the partition groove; and an insulating material is arranged at the partition groove; and the positive conductor is in a Π shape, the negative conductor is in an inverted Π shape, an opening of the positive conductor is arranged opposite to an opening of the negative conductor, and the light-emitting element at least partially extends into the opening of the positive conductor and/or the opening of the negative conductor; and a top of the positive conductor is provided with a first assembly groove, which is arranged on at least part of a side wall of the positive conductor above the light-emitting element and penetrates through the top of the positive conductor; and a top of the negative conductor is provided with a second assembly groove, which is arranged on at least part of a side wall of the negative conductor above the light-emitting element and penetrates through the top of the negative conductor, wherein the transparent cover is fixed on the first assembly groove and the second assembly groove; and the transparent cover has a bottom surface facing toward the light-emitting element, the dodging layer completely covers a bottom surface of the light-transmitting layer, the light-transmitting conductive layer completely covers a bottom surface of the dodging layer, and the bottom surface of the light-transmitting conductive layer is bonded to a groove bottom surface of the first assembly groove and a groove bottom surface of the second assembly groove by a conductive adhesive.

21. The packaging structure according to claim 19 or 20, wherein the back surface of the substrate is provided with a second circuit layer which is in conductive connection with the first circuit layer; and the substrate is provided with a first conductive hole and a second conductive hole penetrating through the substrate, the positive conductor is connected with the second circuit layer through the first conductive hole, and the negative conductor is connected with the second circuit layer through the second conductive hole; and the first circuit layer is provided with a driving integrated circuit, the light-emitting element is a VCSEL laser chip, and the driving integrated circuit is connected with the VCSEL laser chip and the light-transmitting conductive layer.

22. The LED packaging structure according to claim 1, wherein
the LED packaging structure comprises a support structure with the dam and the substrate, wherein the substrate is located in the dam; and the transparent cover is arranged on the front surface of the substrate and covers the LED chip; and
the packaging structure further comprises a fluorescent substance, which is arranged on the support structure or/and the transparent cover, and is configured for generating visible light by a fluorescence reaction when irradiated by the light emitted by the LED chip.

23. The packaging structure according to claim 22, wherein the transparent cover wraps the LED chip; and the dam is annular and has an inner side wall, a top and a bottom, wherein the bottom of the dam is seated on the front surface of the substrate, the dam surrounds the periphery of the LED chip, and the transparent cover, the dam and the substrate are enclosed to form an accommodating cavity.

24. The packaging structure according to claim 23, wherein the transparent cover is adhered to the dam by an adhesive glue mixed with the fluorescent substance, and/or the fluorescent substance is arranged in the accommodating cavity.

25. The packaging structure according to claim 23, wherein at least part of the inner side wall of the dam above the LED chip is provided with an assembly groove penetrating the top of the dam, and the bottom or/and side of the transparent cover is fixed to the assembly groove by an adhesive glue mixed with the fluorescent substance.

26. The packaging structure according to any one of claims 22 to 25, wherein the fluorescent substance is a fluorescent layer, and the fluorescent layer is annular, strip-shaped, circular or polygonal; and the fluorescent substance is arranged on the front surface of the substrate or on the inner side wall of the dam.

27. The packaging structure according to any one of claims 22 to 25, wherein the front surface of the substrate is provided with a first circuit with an annular groove, and the fluorescent substance is arranged in the annular groove.

28. The packaging structure according to claim 23, wherein the dam is a metal pipe cap, wherein both an upper end and a lower end of the metal pipe cap have openings, a bottom of the metal pipe cap is seated on the front surface of the substrate, the transparent cover is connected to the upper end of the metal pipe cap and closes the opening of the upper end, and the front surface of the substrate is provided with the fluorescent substance inside the metal pipe cap.

29. The packaging structure according to claim 1, wherein the substrate is a multilayer substrate, and the multilayer substrate comprises:
a first substrate with a front surface and a back surface that are opposite to each other, wherein the front surface of the first substrate is provided with a first circuit layer, and the back surface of the first substrate is provided with a second circuit layer, wherein the first circuit layer is in conductive connection with the second circuit layer, and the first circuit layer comprises a first circuit positive electrode and a first circuit negative electrode;
a packaging body that is annular and arranged on the front surface of the first substrate, and surrounds the periphery of the first circuit positive electrode and the first circuit negative electrode; and
a second substrate connected with the second circuit layer on the back surface of the first substrate by a bonding process, wherein a back surface of the second substrate is provided with a heat dissipation layer.

30. The packaging structure according to claim 29, wherein the first circuit layer further comprises a positive electrode and a negative electrode, which are arranged at a periphery of the packaging body; and the second circuit layer comprises a second circuit positive electrode and a second circuit negative electrode which are separated and insulated from each other; and the first substrate is provided with conductive holes, which comprise at least two first conductive holes and at least two second conductive holes, wherein the openings of the at least two first conductive holes on the front surface of the first substrate are located at an inner side and an outer side of the packaging body respectively; and the openings of the at least two second conductive holes on the front surface of the first substrate are located at the inner side and the outer side of the packaging body respectively, and each of the first conductive holes and the second conductive holes is provided with a conductive material; and the second circuit positive electrode is respectively connected with the positive electrode and the first circuit positive electrode through the at least two first conductive holes, and the second circuit negative electrode is respectively connected with the negative electrode and the first circuit negative electrode through the at least two second conductive holes.

31. The packaging structure according to claim 30, wherein a bonding layer connecting the first substrate and the second substrate is arranged between the first substrate and the second substrate, and the bonding layer comprises a first bonding part and a second bonding part, wherein the first bonding part and the second bonding part are respectively bonded with the second circuit positive electrode and the second circuit negative electrode, and the first bonding part is insulated from the second bonding part.

32. The packaging structure according to claim 31, wherein the first bonding part and the second circuit positive electrode are identical in shape and size, and the second bonding part and the second circuit negative electrode are identical in shape and size; and the first substrate and the second substrate are both ceramic substrates.

33. The packaging structure according to claim 31, wherein the bonding layer further comprises a third bonding part which is in a closed ring shape and surrounds the periphery of the second circuit layer; and the third bonding part and the second circuit layer are separated and insulated from each other.

34. The packaging structure according to claim 33, wherein an interval between the second circuit positive electrode and the second circuit negative electrode is filled with an insulating material; and an interval between the third bonding part and the second circuit layer is filled with an insulating material.

35. The packaging structure according to claim 33, wherein a minimum distance between the third bonding part and the second circuit layer is greater than 0.2 mm, and a minimum distance between the second circuit positive electrode and the second circuit negative electrode is greater than 0.2 mm; a minimum distance between the first bonding part and the second bonding part is greater than 0.2 mm; and each of the first conductive holes and the second conductive holes has an aperture of 0.09 mm to 0.15 mm.

36. The packaging structure according to claim 29, wherein the heat dissipation layer comprises a copper heat dissipation layer, a nickel heat dissipation layer and a gold heat dissipation layer that are stacked in layers, wherein the copper heat dissipation layer has a thickness of 50 to 300 microns, the nickel heat dissipation layer has a thickness of greater than 3 microns, and the gold heat dissipation layer has a thickness of greater than 0.05 microns.

37. An LED device, wherein the LED device comprises the multilayer substrate according to any one of claims 29 to 35, and further comprises a light-transmitting member and an LED chip, wherein the light-transmitting member is connected to the packaging body, and the LED chip is arranged on the front surface of the first substrate and electrically connected with the first circuit positive electrode and the first circuit negative electrode; and the light-transmitting member, the packaging body and the front surface of the first substrate form a packaging cavity for sealing the LED chip.

38. The packaging structure according to claim 1, wherein the front surface of the substrate is provided with a first circuit layer, which comprises a plurality of positive electrode pad and negative electrode pad groups; and the back surface of the substrate is provided with a second circuit layer, which comprises a plurality of positive terminal and negative terminal groups corresponding to the positive electrode pad and negative electrode pad groups one by one, wherein the positive terminal and negative terminal of one group are symmetrically arranged on two opposite sides of the back surface of the substrate; and the positive terminals are arranged at linear intervals and equidistantly arranged on a same side of the back surface of the substrate, and the negative terminals are arranged at linear intervals and equidistantly arranged on the other side of the back surface of the substrate and are opposite to the positive terminals one by one; and one positive electrode pad is connected with one positive terminal through a positive electrode conductive hole penetrating through the substrate, and one negative electrode pad is electrically connected with one negative terminal through a negative electrode conductive hole penetrating through the substrate; and
a plurality of the LED chips are provided, and each LED chip is electrically connected with one of the positive electrode pad and negative electrode pad groups respectively.

39. The packaging structure according to claim 38, wherein the LED chips are flip chips, and a number of the LED chips is n*n, where n is a natural number greater than 2, and the LED chips are arranged in a rectangular array.

40. The packaging structure according to claim 39, wherein the positive electrode pad and the negative electrode pad form a rectangular circuit pattern on the front surface of the substrate, and the LED chips are uniformly distributed on the circuit pattern, wherein the circuit pattern comprises a first marginal area and a second marginal area which are respectively located on two opposite sides of the circuit pattern, and each positive electrode conductive holes is located in the first marginal area; and each negative electrode conductive hole is located in the second marginal area, wherein one end of a n^{th} positive electrode pad is connected with a positive electrode of a corresponding n^{th} LED chip, and the other end extends to the first marginal area to be connected with a corresponding n^{th} positive electrode conductive hole; and one end of a n^{th} negative electrode pad is connected with a negative electrode of the corresponding n^{th} LED chip, and the other end extends to the second edge area to be connected with a corresponding n^{th} negative electrode conductive hole; and
a projection of each positive electrode pad on the back surface of the substrate has at least a partial overlap area with the corresponding positive terminal; and a projection of each negative electrode pad on the back surface of the substrate has at least a partial overlap area with the corresponding negative terminal, wherein each positive electrode conductive hole and negative electrode conductive hole are respectively located in each overlap area.

41. The packaging structure according to claim 40, wherein the circuit pattern is provided with a gap separating the positive electrode pad and the negative electrode pad on the front surface of each substrate, wherein the gap is at least greater than 0.2mm; and the positive electrode conductive holes are linearly arranged; and the negative electrode conductive holes are arranged linearly, and the positive electrode conductive holes and the negative electrode conductive holes are symmetrically arranged in one-to-one correspondence.

42. The packaging structure according to any one of claims 38 to 41, wherein the packaging structure further comprises a packaging body arranged on the front surface of the substrate and a light-transmitting member arranged on the packaging body, wherein the packaging body is annular and surrounds each LED chip and each group of positive and negative electrode pads, and the light-transmitting member covers the LED chips.

43. The packaging structure according to claim 42, wherein the packaging body is provided with an assembly groove that is provided on an inner side wall of the packaging body and penetrates through the top of the packaging body, and the bottom surface of the light-transmitting member is bonded on the assembly groove by a flux material; and the substrate is a ceramic substrate.

44. The packaging structure according to any one of claims 38 to 41, wherein a heat dissipation layer is further arranged in a middle area of the back surface of the substrate, the plurality of positive terminals are adjacently arranged on one side of the heat dissipation layer at intervals, and the plurality of negative terminals are adjacently arranged on the other side of the heat dissipation layer at intervals.

45. The packaging structure according to claim 40, wherein the circuit pattern is rotationally symmetric about a geometric center thereof; and the circuit pattern is provided with a first positioning mark.

46. The packaging structure according to any one of claims 38 to 41, wherein each LED chip is connected in parallel with a zener chip with a flip-chip structure, and each zener chip is electrically connected with one group of positive and negative electrode pads.

47. The packaging structure according to any one of claims 38 to 41, wherein the first circuit layer and/or the second circuit layer comprise a first copper metal layer, a first nickel metal layer and a first gold metal layer that are stacked in layers, wherein the first nickel metal layer has a thickness of greater than 3 microns, and the first gold metal layer has a thickness of greater than 0.05 microns.

48. The packaging structure according to claim 1, wherein the dam is annular and has an inner side wall, a top and a bottom, wherein the bottom of the dam is seated on the front surface of the substrate, and the dam surrounds the periphery of the LED chip; and at least part of the inner side wall of the dam above the LED chip is provided with an assembly groove penetrating through the top of the dam; and the packaging structure comprises a light window assembly, which comprises a transparent cover and a metal pipe cap, wherein the metal pipe cap is bonded on the periphery of the transparent cover, and the transparent cover and the metal pipe cap are fixed in the assembly groove; and the bottoms of the transparent cover and the metal pipe cap are both abutted against a groove bottom surface of the assembly groove; and the transparent cover, the metal pipe cap, the front surface of the substrate and the dam are enclosed to form an accommodating cavity for accommodating the LED chips, and the surfaces of the transparent cover and the metal pipe cap and a wall surface of the assembly groove are enclosed to form a sealant groove; and the packaging structure further comprises a sealant, and the sealant is arranged in the sealant groove.

49. The packaging structure according to claim 48, wherein a height of the transparent cover is greater than that of the metal pipe cap.

50. The packaging structure according to claim 48 or 49, wherein
the transparent cover and the metal pipe cap are bonded by glass solder; and
the glass solder has a height greater than that of the metal pipe cap and covers a surface of the metal pipe cap far away from the substrate.

51. The packaging structure according to claim 50, wherein a bonding part extends from a bottom of the metal pipe cap in a direction away from the transparent cover, and the metal pipe cap is bonded to the groove bottom surface of the assembly groove through the bonding part.

52. The packaging structure according to claim 51, wherein the bonding part abuts against the groove side wall of the assembly groove, and the glass solder, the metal pipe cap and the groove side wall of the assembly groove form the sealant groove; and the sealant covers the glass solder and the metal pipe cap.

53. The packaging structure according to claim 1, comprising a device body, wherein the device body comprises the substrate, the light-emitting element, the dam and the transparent cover, wherein the dam is connected with the substrate and the transparent cover, and the substrate, the dam and the transparent cover are enclosed to form a packaging cavity; and the substrate has a first end face and a second end face which are opposite to each other, and the light-emitting element is arranged on the first end face of the substrate and located in the packaging cavity; and the light-emitting element faces toward the transparent cover, the dam is provided with an inner side wall plated with a reflecting layer for reflecting the light emitted by the light-emitting element, wherein the inner side wall is inclined from the first end face in a direction away from the light-emitting element and forms an included angle with the first end face of more than zero and less than 90°.

54. The packaging structure according to claim 53, wherein the dam is in a shape of a cylinder, an outline dimension of an upper end of the cylinder is larger than that of a lower end of the cylinder, and an inner side wall of the dam is obliquely arranged relative to the first end face; and the reflecting layer is a metal layer evenly covering the inner side wall of the dam; or, the reflecting layer is a metal layer partially covering the inner side wall of the dam; and the metal layer is an aluminum layer; and the included angle is 30 to 60° or the included angle is 45°.

55. The packaging structure according to claim 53, wherein a substrate surface circuit is arranged between the light-emitting element and the first end face, and a substrate back circuit is arranged on the second end face; and the substrate has a conductive hole penetrating through the first end face and the second end face, and the substrate surface circuit and the substrate back circuit are electrically connected through the conductive hole; and a base material of the substrate surface circuit and the substrate back circuit is plated with a nickel-gold coating or a nickel-palladium-gold coating.

56. The packaging structure according to claim 53, wherein the transparent cover is a glass lens, and the glass lens is a plane lens, or the glass lens is a spherical lens or a hemispherical lens, and a surface of the glass lens is plated with an antireflection film for improving a ultraviolet transmittance.

57. A packaging method of a packaging structure configured for packaging the packaging structure according to claim 53, comprising the following steps:
preparing a substrate with a first end face and a second end face which are opposite to each other;
fixing a light-emitting element on the first end face of the substrate;
providing a dam around the light-emitting element on the first end face of the substrate;
providing a reflecting surface for reflecting part of the light emitted by the light-emitting element in a space surrounded by the dam, wherein the reflecting surface is inclined from the first end face to the outside of the space, and an included angle between the reflecting surface and the first end face is set to be greater than zero and less than 90°; and
fixedly connecting a transparent cove to the dam, and configuring the transparent cover to faces toward the light-emitting element, and enclosing the transparent cover, the dam and the substrate to form a packaging cavity.

58. The packaging method according to claim 57, wherein an included angle between the inner side wall of the dam and the first end face is set to be greater than zero and less than 90°, and after the dam is provided, the reflecting layer is plated on the inner side wall, and the surface of the reflecting layer is the reflecting surface.

59. The packaging method according to claim 57 or 58, wherein before the transparent cover is fixedly connected to the dam and after the dam is provided, a reflecting ring is provided in the space surrounded by the dam, and a lower end of the reflecting ring is configured to be close to the substrate, wherein the lower end of the reflecting ring is smaller than an upper end of the reflecting ring, and the reflecting ring has a shape of truncated cone or truncated pyramid, and an inner side wall of the reflecting ring facing toward the light-emitting element is the reflecting surface.

60. The packaging method according to claim 57, wherein a pipe cap member is provided as the dam, and the pipe cap member is integrally formed by a metal material and has a pipe cap seat and a pipe cap side wall integrally connected to the pipe cap seat, wherein the pipe cap seat is attached to and connected to the substrate, and an inner pipe cap side wall side wall is the reflecting surface.

61. The packaging method according to claim 60, wherein the pipe cap side wall has a shape of truncated cone or truncated pyramid, an outline dimension of a lower end of the pipe cap side wall is smaller than that of an upper end of the pipe cap side wall, and an included angle between the pipe cap side wall and the first end face is set to be greater than zero and less than 90°.

62. The packaging method according to claim 61, wherein an outline dimension of the pipe cap seat is larger than that of the upper end of the pipe cap side wall, and a difference between the outline dimension of the pipe cap seat and the outline dimension of the upper end of the pipe cap side wall is ≥ 0.2 mm.

63. The packaging method according to any one of claims 57 to 61, wherein when preparing the substrate, a substrate surface circuit is arranged on the first end face of the substrate, a substrate back circuit is arranged on the second end face of the substrate, and a conductive hole for conductively connecting the substrate surface circuit and the substrate back circuit is provided in the substrate, and the conductive hole penetrates through the first end face and the second end face.

64. The packaging method according to any one of claims 57 to 61, wherein the transparent cover is a glass lens, and a surface of the glass lens is plated with an antireflection film for improving a light transmittance.

65. The packaging method according to any one of claims 57 to 61, wherein the included angle between the reflecting surface and the first end face is set to be between 30° and 60°.
